(19) Europäisches Patentamt
European Patent Office
Office européen des brevets

(11) EP 3 489 025 A1

(12) # EUROPEAN PATENT APPLICATION
published in accordance with Art. 153(4) EPC

(43) Date of publication:
**29.05.2019 Bulletin 2019/22**

(21) Application number: **17846265.1**

(22) Date of filing: **23.08.2017**

(51) Int Cl.:
***B41N 1/00** (2006.01)* ***C08F 2/44** (2006.01)*
***C08F 4/00** (2006.01)* ***C08K 5/00** (2006.01)*

(86) International application number:
**PCT/JP2017/030201**

(87) International publication number:
**WO 2018/043260 (08.03.2018 Gazette 2018/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **31.08.2016 JP 2016169850**

(71) Applicant: **FUJIFILM Corporation**
**Tokyo 106-8620 (JP)**

(72) Inventor: **ISHIJI, Yohei**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(54) **CURABLE COMPOSITION, ORIGINAL PLATE FOR LITHOGRAPHIC PRINTING PLATES, AND METHOD FOR MANUFACTURING LITHOGRAPHIC PRINTING PLATE**

(57) A curable composition includes an infrared absorber having at least one element in Group XIII of the periodic table on a mother nucleus structure and having a chain-like polymethine structure, in which two or more hetero atoms are bonded to carbon atoms at non-meso positions. Also, a lithographic printing plate precursor in which the curable composition is used, and a method for producing a lithographic printing plate in which the lithographic printing plate precursor is used are provided.

EP 3 489 025 A1

## Description

BACKGROUND OF THE INVENTION

1. Field of the Invention

The present disclosure relates to a curable composition, a lithographic printing plate precursor, and a method for producing a lithographic printing plate.

2. Description of the Related Art

Generally, a lithographic printing plate includes a lipophilic image area that receives ink in a printing process and a hydrophilic non-image area that receives dampening water. Lithographic printing is a method in which the properties of water and oil-based ink that repel each other are used, the lipophilic image area of the lithographic printing plate is used as an ink-receiving portion, the hydrophilic non-image area is used as a dampening water-receiving portion (non-ink-receiving portion), a difference in the adhesive property of ink to the surface of the lithographic printing plate is caused, the ink is inked only in the image area, and then the ink is transferred to a body to be printed such as paper, thereby carrying out printing.

At the moment, in a plate making step of producing a lithographic printing plate from a lithographic printing plate precursor, image-wise exposure is carried out using a computer to plate (CTP) technology. That is, image-wise exposure is directly carried out on a lithographic printing plate precursor by means of scanning, exposure, or the like using a laser or a laser diode without using a lith film.

In addition, due to the intensifying interest in the global environment, regarding the plate making of lithographic printing plate precursors, an environmental issue of waste liquid generated by wet processes such as a development process has gathered attention, and accordingly, there have been attempts to simplify or remove development processes. As one of simple development processes, a method called "on-machine development" has been proposed. The on-machine development refers to a method in which, after the image-wise exposure of a lithographic printing plate precursor, a development process of the related art is not carried out, and instead, the lithographic printing plate precursor is attached to a printer, and a non-image area in an image-recording layer is removed at the initial phase of an ordinary printing step.

Generally, as a previous step of attaching the lithographic printing plate to the printer, an operation of inspecting and identifying an image on the lithographic printing plate (the inspection of the plate) in order to check whether or not the image is recorded as intended on the lithographic printing plate is carried out. Particularly, in polychromatic printing, the capability of determining whether or not a register mark, which serves as a mark for registration, is drawn is critical in printing operations.

In lithographic printing plate precursors that are subjected to an ordinary development process step, generally, an image-recording layer is colored, thereby obtaining a colored image by means of a development process, and thus it is easy to check the image before the printing plate is attached to a printer.

Meanwhile, in on-machine development-type or process-less (development-less)-type lithographic printing plate precursors on which an ordinary development process is not carried out, it is difficult to check an image on the lithographic printing plate precursor in a phase of attaching the lithographic printing plate precursor to a printer, and thus it is impossible to sufficiently inspect the plate. Therefore, for on-machine development-type or process-less (development-less)-type lithographic printing plate precursors, there is a demand for means for checking an image in a phase of being exposed, that is, the formation of a so-called print-out image in which an exposed region develops or does not develop a color. Furthermore, from the viewpoint of improving workability, it is also critical that an exposed region which develops or does not develop a color maintains the state of developing or not developing colors even after the elapsing of time.

As means for forming the print-out image, a variety of means are being studied.

For example, JP2008-544053A describes an infrared-absorbing dye (IR dye) represented by Formula 1-1.

JP2008-544322A describes a thermosensitive image-forming element including the IR dye represented by Formula 1-1.

In addition, JP2013-199089A describes an infrared color developing curable composition containing (A) a compound represented by Formula (1), (B) an IR colorant represented by Formula (3), (C) a binder polymer, (D) any of onium-based polymerization initiators represented by Formulae (4) to (6), and (E) a polymerizable compound.

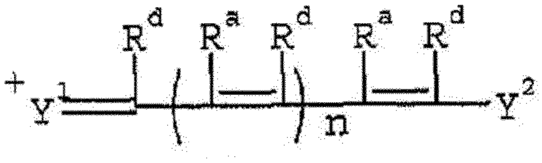

Formula 1-1

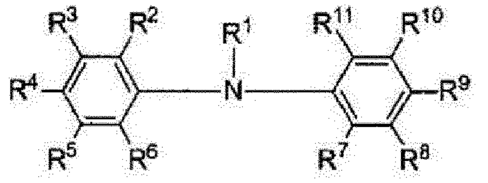

(1)

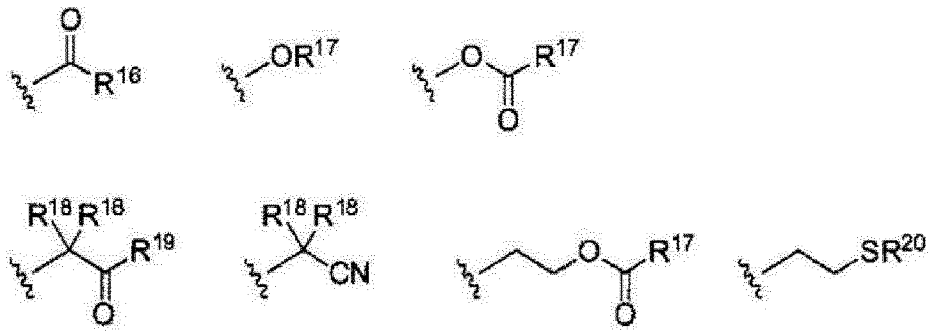

(2)

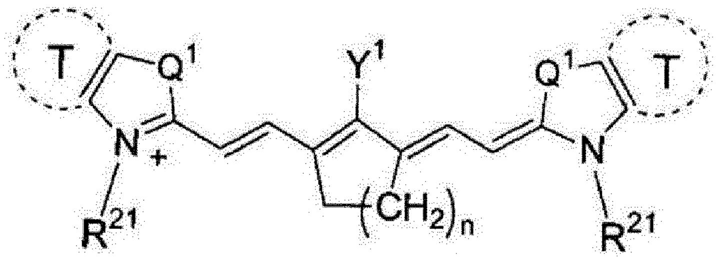

(3)

X

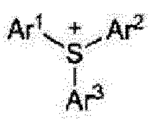

(4)

Z-

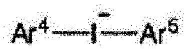

(5)

Z-

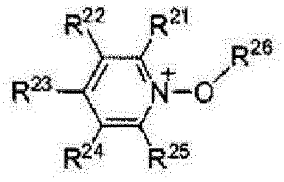

(6)

Z-

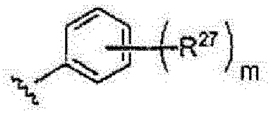

(7)

SUMMARY OF THE INVENTION

An object that an embodiment of the present invention attempts to achieve is to provide a curable composition having an excellent color developability after being cured.

In addition, an object that another embodiment of the present invention attempts to achieve is to provide a lithographic printing plate precursor having an excellent plate inspection property by color development and a method for producing a lithographic printing plate using the above-described lithographic printing plate precursor.

Means for achieving the above-described objects include the following aspects.

<1> A curable composition including: an infrared absorber having at least one element in Group XIII of the periodic table on a mother nucleus structure and having a chain-like polymethine structure.
<2> The curable composition according to <1>, in which, in the infrared absorber, an anion charge is present on the element in Group XIII in a resonant structure formula.
<3> The curable composition according to <1> or <2>, in which the element in Group XIII of the periodic table is boron or aluminum.
<4> The curable composition according to any one of <1> to <3>, in which the chain-like polymethine structure is a chain-like polymethine structure in which two or more hetero atoms are bonded to carbon atoms at non-meso positions.
<5> The curable composition according to <4>, in which the infrared absorber has two or more boron atoms, and the two or more hetero atoms are two or more oxygen atoms or two or more nitrogen atoms.
<6> The curable composition according to <4>, in which the infrared absorber has two or more boron atoms, and the two or more hetero atoms are four or more oxygen atoms.
<7> The curable composition according to any one of <1> to <6>, in which the infrared absorber has a group represented by the following Formula I.

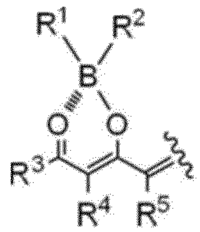

Formula I

In Formula I, $R^1$ and $R^2$ each independently represent a halogen atom or a monovalent atomic group including at least one atom selected from the group consisting of an oxygen atom, a nitrogen atom, and a carbon atom; $R^1$ and $R^2$ may be bonded to each other to form a ring structure; $R^3$, $R^4$, and $R^5$ each independently represent a monovalent atomic group including at least one atom selected from the group consisting of a hydrogen atom, an oxygen atom, a nitrogen atom, and a carbon atom; at least two groups selected from the group consisting of $R^3$, $R^4$, and $R^5$ may be bonded to each other to form a ring structure; and a wavy line moiety represents a bonding site with a different structure.
<8> The curable composition according to any one of <1> to <7>, in which the infrared absorber is a compound represented by the following Formula II.

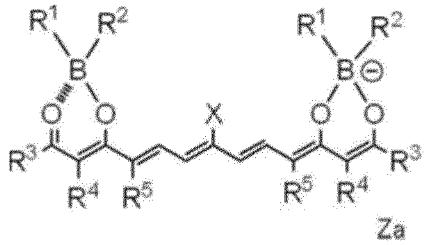

Formula II

In Formula II, $R^1$ and $R^2$ each independently represent a halogen atom or a monovalent atomic group including at least one atom selected from the group consisting of an oxygen atom, a nitrogen atom, and a carbon atom; $R^1$ and $R^2$ may be bonded to each other to form a ring structure; $R^3$, $R^4$, and $R^5$ each independently represent a monovalent atomic group including at least one atom selected from the group consisting of a hydrogen atom, an oxygen atom, a nitrogen atom, and a carbon atom; at least two groups selected from the group consisting of $R^3$, $R^4$, and $R^5$ may be bonded to each other to form a ring structure; a linear polymethine chain may have a ring structure therein; X represents a halogen atom or a monovalent atomic group including at least one atom selected from the group consisting of an oxygen atom, a sulfur atom, a nitrogen atom, and a carbon atom; and Za represents a counter ion for neutralizing a charge.
<9> The curable composition according to any one of <1> to <8>, in which the infrared absorber is a compound represented by the following Formula III.

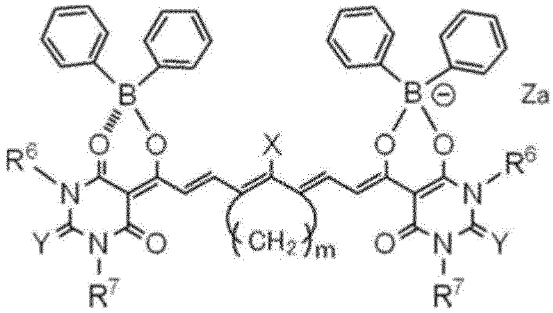

Formula III

In Formula III, $R^6$ and $R^7$ each independently represent a hydrogen atom, an alkyl group, or an aryl group; X represents a halogen atom or a monovalent atomic group including at least one atom selected from the group consisting of an oxygen atom, a sulfur atom, a nitrogen atom, and a carbon atom; each Y independently represents an oxygen atom, a sulfur atom, or a divalent atomic group including at least one atom selected from the group consisting of a nitrogen atom and a carbon atom, wherein in a case in which Y represents a divalent atomic group including at least one atom selected from the group consisting of a nitrogen atom and a carbon atom, the atomic group may be bonded to at least one group selected from the group consisting of $R^6$ and $R^7$ to form a ring structure; m represents an integer of 2 to 10; and Za represents a counter ion for neutralizing a charge.
<10> The curable composition according to any one of <1> to <9>, further comprising:

a polymerizable compound; and
a polymerization initiator.

<11> The curable composition according to <10>, in which the polymerization initiator is an onium salt compound.
<12> The curable composition according to any one of <1> to <11>, further including: a thermally adhesive particle.
<13> The curable composition according to any one of <1> to <12>, further including: a binder polymer.
<14> A lithographic printing plate precursor comprising:

a support; and
an image-recording layer containing the curable composition according to any one of <1> to <13> on the support.

<15> The lithographic printing plate precursor according to <14>, further including: a protective layer on the image-recording layer.
<16> A method for producing a lithographic printing plate, the method including:

a step of subjecting the lithographic printing plate precursor according to <14> or <15> to image-wise exposure; and
a step of removing a non-exposed portion of the image-recording layer on a printer using at least one selected from the group consisting of printing ink and dampening water.

According to an embodiment of the present invention, a curable composition having an excellent color developability after being cured is provided.
In addition, according to another embodiment of the present invention, a lithographic printing plate precursor having an excellent plate inspection property by color development and a method for producing a lithographic printing plate using the above-described lithographic printing plate precursor are provided.

DESCRIPTION OF THE PREFERRED EMBODIMENTS

Hereinafter, the present disclosure will be described in detail.
Meanwhile, in the present specification, the expression "xx to yy" indicates a numerical range including xx and yy.
In addition, in the present specification, "(meth)acryl" represents either or both of acryl and methacryl, and "(meth)acrylate" represents either or both of acrylate and methacrylate.
In addition, in the present disclosure, "% by mass" and "% by weight" have the same meaning, and "parts by mass" and "parts by weight" have the same meaning.
In addition, in the present disclosure, a combination of two or more preferred aspects is a more preferred aspect.
In addition, unless particularly otherwise described, the weight-average molecular weight (Mw) in the present disclosure refers to a molecular weight that is detected using a gel permeation chromatography (GPC) analyzer in which

columns of TSKgel GMHxL, TSKgel G4000HxL, and TSKgel G2000HxL (all are trade names manufactured by Tosoh Corporation) are used, solvent tetrahydrofuran (THF), and a differential refractometer and is converted using polystyrene as a standard substance.

In the present specification, regarding the expression of a group in a compound represented by a formula, in a case in which there is no description of whether the group is substituted or unsubstituted, unless particularly otherwise described, the group refers not only to an unsubstituted group but also to the group having a substituent as long as the group is capable of having a substituent. For example, for a formula, in a case in which there is a description "R represents an alkyl group, an aryl group, or a monovalent heterocyclic group", it means that "R represents an unsubstituted alkyl group, a substituted alkyl group, an unsubstituted aryl group, a substituted aryl group, an unsubstituted monovalent heterocyclic group, or a monovalent heterocyclic group having a substituent".

In the present specification, the term "step" refers not only to an independent step but also to a step that is not clearly differentiated from other steps as long as the intended object is achieved.

Hereinafter, the present disclosure will be described in detail.

(Curable Composition)

A curable composition according to the embodiment of the present disclosure contains an infrared absorber having at least one element in Group XIII of the periodic table (hereinafter, also simply referred to as "an element in Group XIII") on a mother nucleus structure and having a chain-like polymethine structure (hereinafter, also referred to as "the specific infrared absorber").

The mother nucleus structure of the specific infrared absorber refers to a structure excluding a counter ion in a structure included in the specific infrared absorber.

The curable composition according to the embodiment of the present disclosure is preferably used as an image-forming material. As the image-forming material, image-forming materials using the color development and curing of a lithographic printing plate precursor, a printed-wiring board, a color filter, a photo mask, or the like are exemplified.

An image-forming material for which the curable composition according to the embodiment of the present disclosure is used forms a color developing image by being heated or exposed to a light source that radiates an infrared ray. As heating means, well-known heating means can be used, and examples thereof include a heater, an oven, a hot plate, an infrared lamp, an infrared laser, and the like. As the light source that radiates an infrared ray, a solid-state laser, a semiconductor laser, and the like which radiate an infrared ray are exemplified.

The curable composition according to the embodiment of the present disclosure is particularly preferably used for an image-recording layer in a lithographic printing plate precursor.

The present inventors found that a lithographic printing plate precursor containing the infrared absorber described in JP2008-544053A, JP2008-544322A, or JP2013-199089A is insufficient in term of the visibility (plate inspection property) due to the color developability.

Therefore, the present inventors carried out intensive studies and consequently obtained a curable resin composition having an excellent color developability after being cured (hereinafter, also simply referred to as "color developability") by including the specific infrared absorber.

In addition, in the case of using the curable composition according to the embodiment of the present disclosure for the image-recording layer in the lithographic printing plate precursor, a lithographic printing plate precursor having an excellent plate inspection property was obtained.

Furthermore, the present inventors found that a lithographic printing plate precursor containing the infrared absorber described in JP2008-544053A, JP2008-544322A, or JP2013-199089A had a poor plate inspection property after aging (for example, after two hours from exposure or the like) and was insufficient in terms of the on-machine developability and the printing resistance. Additionally, the present inventors found that, in a case in which a lithographic printing plate precursor is exposed to a white light, the on-machine developability degraded (hereinafter, also referred to as "the white light stability is poor").

Therefore, the present inventors carried out intensive studies and consequently obtained a lithographic printing plate precursor which was excellent in terms of the plate inspection property after aging, the on-machine developability, and the white light stability in a case in which the curable composition according to the embodiment of the present disclosure is used for an image-recording layer in the lithographic printing plate precursor and made the printing resistance and the tone reproducibility of a lithographic printing plate to be obtained favorable.

The detailed mechanism of obtaining the above-described effect is not clear, but is assumed to be as follows.

The specific infrared absorber that is used in the curable composition according to the embodiment of the present disclosure is excellent in terms of the color developability after curing (hereinafter, also simply referred to as "color developability") since the product of a chemical reaction caused by exposure or heating is a colorant having a high absorption in the visible light range.

Therefore, the plate inspection property by color development of a lithographic printing plate precursor to be

obtained is considered to be excellent.

In addition, a product of a chemical reaction caused by exposure or heating of the specific infrared absorber that is used in the curable composition according to the embodiment of the present disclosure has a rigid structure and is thus considered to be excellent in terms of color development even after aging (for example, two hours or the like).

Therefore, the plate inspection property after aging of a lithographic printing plate precursor to be obtained is considered to be excellent.

In addition, the curable composition according to the embodiment of the present disclosure does not have a meaning absorption at the bright line spectrum wavelength of a fluorescent light and suppresses dark polymerization in a non-exposed portion more than a colorant of the related art, and thus the on-machine developability and the white light stability of a lithographic printing plate precursor to be obtained are considered to be excellent.

Furthermore, the specific infrared absorber that is included in the curable composition according to the embodiment of the present disclosure is excellent in terms of the electron migration efficiency to a polymerization initiator by exposure or the photothermal conversion efficiency and is thus excellent in terms of polymerization in the case of including a polymerization initiator or a curing reaction such as thermal fusion, and a lithographic printing plate for which the above-described lithographic printing plate precursor is used is considered to be excellent in terms of the printing resistance and the tone stability.

The curable composition according to the embodiment of the present disclosure is not particularly limited, but is preferably a curable composition according to a first embodiment or a second embodiment described below.

The first embodiment includes the specific infrared absorber, a polymerizable compound, and a polymerization initiator.

The second embodiment includes the specific infrared absorber and a thermally adhesive particle.

Hereinafter, first, the respective components that are included in the curable composition of the first embodiment will be described.

(First Embodiment)

<Specific infrared absorber>

The curable composition according to the first embodiment includes the specific infrared absorber.

The specific infrared absorber according to the present disclosure has a characteristic that the product of a chemical reaction caused by heat or infrared energy is a color-developing body having a high visibility. In the present specification, color development means that, compared with before heating or exposure to an infrared ray, stronger coloration occurs in the visible light range or absorption occurs at a shorter wavelength and thus absorption also occurs in the visible light range after heating or exposure to an infrared ray.

That is, the specific infrared absorber is a compound that does absorption to an increased extent in the visible light range or does absorption at a shorter wavelength and thus does absorption in the visible light range compared with before heating or exposure to an infrared ray due to a chemical reaction caused by heat or exposure to an infrared ray.

More specifically, color development refers to absorption occurring to an increased extent in the visible light range (400 nm or more and less than 750 nm) compared with before heating or exposure to an infrared ray.

Meanwhile, an infrared ray in the present disclosure refers to a wavelength of 750 nm or more and 1 mm or less and preferably 750 nm or more and 1,400 nm or less.

The color development mechanism of the specific infrared absorber is not particularly limited, and, for example, a compound in which it is assumed that a boron chelate portion is decomposed by heat or exposure to an infrared ray, a compound which has a substituent X at a meso position (a carbon atom in the center of a chain-like polymethine structure) as illustrated in the following drawing and in which it is assumed that the bond between the carbon atom and the substituent X is subjected to a nucleophilic decomposition reaction (a hydrolysis by water in the curable composition) and an oxonol colorant that is a highly visible color-developing body is generated, a compound in which it is assumed that a radical cation is generated by electron migration, thereby generating a color-developing body, a compound in which it is assumed that a borate portion is desorbed and the structure is substituted into a different structure, thereby generating a color-developing body, a compound in which it is assumed that a substituent at a meso position is desorbed and the structure is substituted into a different structure, thereby generating a color-developing body, and the like are used in the present disclosure.

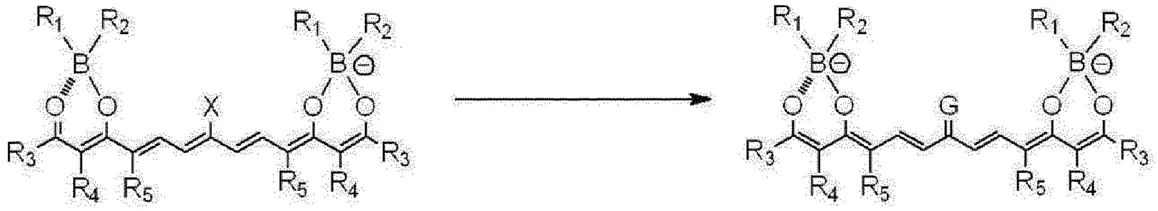

Boron chelate oxonol (long wavelength) Boron chelate oxonol (short wavelength)

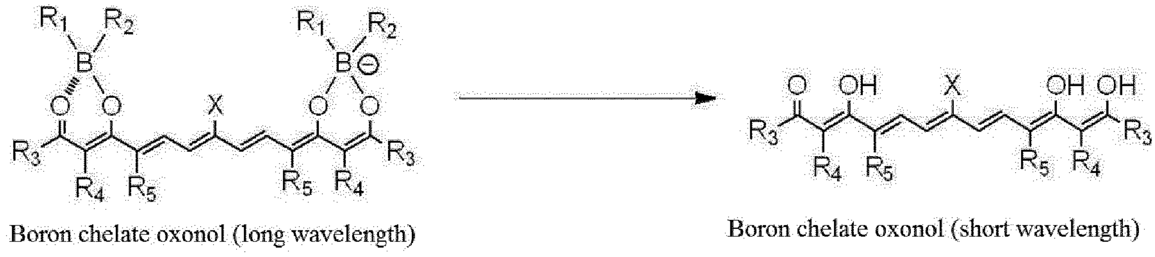

Boron chelate oxonol (long wavelength) Boron chelate oxonol (short wavelength)

In the boron chelate oxonol (short wavelength), G represents an oxygen atom, a sulfur atom, =N-R, =N-CO-$R^A$, or =N-$SO_2$-$R^B$, R is a hydrogen atom, a hydroxyl group, an alkyl group, an aryl group, or a heteroaryl group which may have a substituent, and $R^A$ and $R^B$ each independently represent an alkyl group, an aryl group, a heteroaryl group, an alkoxy group, or an amine derivative (examples thereof include dialkylamine, monoalkylarylamine, diarylamine, pyrrole, imidazole, and pyrazoles, and diphenylamine is more preferably exemplified).

[Element in Group XIII]

The specific infrared absorber has at least one element in Group XIII. The element in Group XIII is preferably boron, aluminum, gallium, indium, or thallium, more preferably boron or aluminum, and still more preferably boron.

The element in Group XIII in the specific infrared absorber is preferably chelated by two or more hetero atoms bonded to the chain-like polymethine structure.

The two or more hetero atoms are preferably two or more hetero atoms bonded to carbon atoms at non-meso positions of a polymethine structure described below.

The number of the elements in Group XIII in the specific infrared absorber is preferably 1 to 4 and more preferably 2.

In a case in which the specific infrared absorber contains a plurality of the elements in Group XIII, the elements in Group XIII may be identical to or different from each other, but are preferably identical to each other.

In addition, in the specific infrared absorber, from the viewpoint of the curing property of the curable composition and the printing resistance of a lithographic printing plate in a case in which the specific infrared absorber is used for a lithographic printing plate precursor, an anion charge is preferably present on the element in Group XIII in a resonant structure formula. In the present disclosure, the expression "an anion charge is present on the element in Group XIII in a resonant structure formula" means that an anion charge is present on the element in Group XIII in at least one resonant structure formula.

In the resonant structure formula, in a case in which an anion charge is present on the element in Group XIII or a case in which an anion charge is present at a different place in the molecule, the specific infrared absorber has a cation for neutralizing the charge in the molecule or outside the molecule. As the cation, a cation such as an alkali metal ion, an alkaline earth metal ion, an ammonium ion, a pyridinium ion, an imidazolium ion, a phosphonium ion, an iodonium ion, a diazonium ion, a sulfonium ion, or an alkylated diazabicycloundecene ion is exemplified, a sodium ion, a potassium ion, an ammonium ion, a pyridinium ion, or a sulfonium ion is preferred, and a potassium ion, a pyridinium ion, or an ammonium ion is more preferred.

[Chain-Like Polymethine Structure]

The specific infrared absorber has a chain-like polymethine structure.

The chain-like polymethine structure refers to a structure in which a plurality of methine groups is bonded to each other and may have a ring structure therein or at a terminal, but a cyclic polymethine structure such as porphyrin is not the chain-like polymethine structure.

The chain-like polymethine structure is preferably a chain-like polymethine structure in which two or more hetero atoms are bonded to carbon atoms at non-meso positions.

In the present disclosure, the meso position in the polymethine structure refers to the location of a carbon atom in a methine group in the center of the polymethine structure, and a carbon atom at a non-meso position refers to a carbon atom which is included in the methine group in the polymethine structure and is located at a non-meso position.

The chain-like polymethine structure in which two or more hetero atoms are bonded to carbon atoms at non-meso positions refers to a polymethine structure having two or more carbon atoms at non-meso positions that are directly bonded with two or more hetero atoms via no other atom therebetween.

As the hetero atom, an oxygen atom, a nitrogen atom, or a sulfur atom is exemplified, and an oxygen atom or a nitrogen atom is preferred.

To the carbon atom at the meso position of the polymethine structure, the hetero atom may or may not be bonded.

As the hetero atom that is bonded to the carbon atom at the meso position of the polymethine structure, an oxygen atom, a nitrogen atom, or a sulfur atom is exemplified.

The number of the hetero atoms is 2 or more, preferably 4 or more, and more preferably 4.

The upper limit of the number of the hetero atoms is preferably 8 or less and more preferably 6 or less.

The number of methines bonded in the chain-like polymethine structure is preferably 11, 13, 15, or 17 and more preferably 13 or 15 from the viewpoint of the color developability.

As a structure including the polymethine structure, the specific infrared absorber according to the present disclosure preferably includes a structure represented by any of Formula PM1 to Formula PM4.

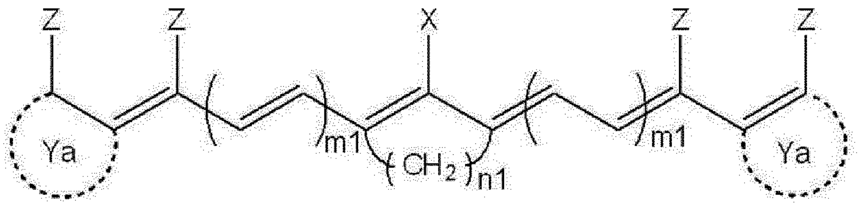

Formula PM1

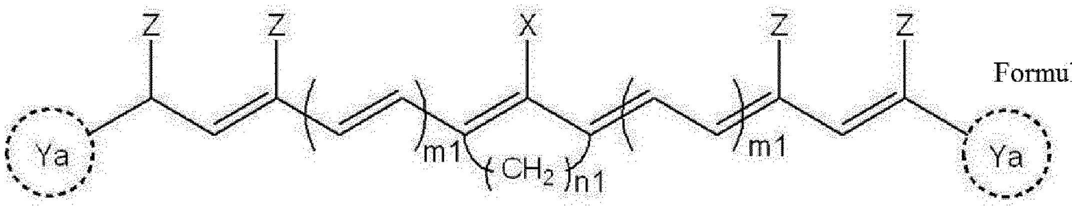

Formula PM2

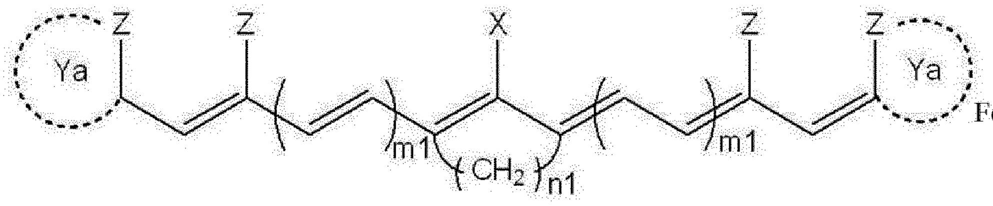

Formula PM3

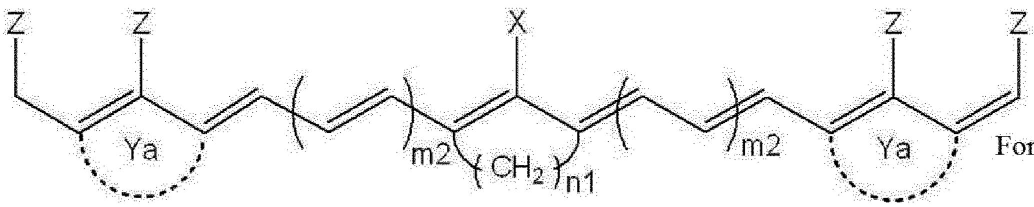

Formula PM4

In Formula PM1 to Formula PM4, n1 represents an integer of 2 to 10, two m1's represent the same integer of 1 or 2, two m2's represent the same integer of 0 or 1, each Z independently represents a hetero atom, each Ya independently represents a monocyclic or ring-fused aromatic ring or hetero ring, and X represents a halogen atom or a monovalent atomic group including at least one atom selected from the group consisting of an oxygen atom (O atom), a sulfur atom (S atom), a nitrogen atom (N atom), and a carbon atom (C atom).

n1 in Formula PM1 to Formula PM4 is preferably an integer of 2 to 6, more preferably 2 or 3, and still more preferably 2.

Two ml's in Formula PM1 to Formula PM3 are both preferably 1.

Two m2's in Formula PM4 are both preferably 0.

Each Z in Formula PM1 to Formula PM4 independently represents a hetero atom and is preferably an oxygen atom, a nitrogen atom, or a sulfur atom, more preferably an oxygen atom or a nitrogen atom, and still more preferably an oxygen atom.

Each Ya in Formula PM1 to Formula PM4 independently represents a monocyclic or ring-fused aromatic ring or hetero ring, a benzene ring, a barbituric acid ring, a thiobarbituric acid ring, an indanone ring, an indanedione ring, a pyridone ring, a benzoxazole ring, a benzothiazole ring, a coumarin ring, and the like are exemplified, and a barbituric acid ring or a thiobarbituric acid ring is preferred.

X in Formula PM1 to Formula PM4 represents a halogen atom or a monovalent atomic group including at least one atom selected from the group consisting of an oxygen atom, a sulfur atom, a nitrogen atom, and a carbon atom, and the halogen atom is preferably a fluorine atom, a chlorine atom, a bromine atom, or an iodine atom and more preferably a chlorine atom.

The monovalent atomic group including at least one atom selected from the group consisting of an oxygen atom, a sulfur atom, a nitrogen atom, and a carbon atom is preferably a group represented by Formula A.

$$*\text{-}S^A\text{-}T^A \qquad \text{Formula A}$$

In Formula A, $S^A$ represents a single bond, an alkylene group, an alkenylene group, an alkynylene group, -O-, -S-, $-NR^{L1}-$, -C(=O)-, -C(=O)O-, $-C(=O)NR^{L1}-$, $-S(=O)_2-$, $-OR^{L2}-$, or a group formed of a combination thereof, $R^{L1}$ represents a hydrogen atom, a halogen atom, an alkyl group, an aryl group, or a monovalent heterocyclic group, $R^{L2}$ represents an alkylene group, an arylene group, or a divalent heterocyclic group, $T^A$ represents a halogen atom, an alkyl group, an aryl group, a monovalent heterocyclic group, a cyano group, a hydroxy group, a formyl group, a carboxy group, an amino group, a thiol group, a sulfonium group, a sulfo group, or a phosphoryl group, and * represents a bonding site to the carbon atom at the meso position of the polymethine structure.

Meanwhile, in the present disclosure, the monovalent heterocyclic group refers to a group obtained by removing one hydrogen atom from a heterocyclic compound, and the divalent heterocyclic group refers to a group obtained by removing two hydrogen atoms from a heterocyclic compound.

In Formula A, from the viewpoint of the color developability, $S^A$ is preferably a single bond, -O-, -S-, $-OR^{L2}-$, or $-NR^{L1}-$, more preferably a single bond, -O-, or $-NR^{L1}-$, and still more preferably -O-, or $-NR^{L1}-$.

The alkylene group as $S^A$ is preferably an alkylene group having 1 to 10 carbon atoms, more preferably an alkylene group having 1 to 4 carbon atoms, and still more preferably a methylene group or an ethylene group.

The alkenylene group as $S^A$ is preferably an alkenylene group having 2 to 10 carbon atoms, more preferably an alkenylene group having 2 to 4 carbon atoms, and still more preferably an alkenylene group having 2 or 3 carbon atoms.

The alkynylene group as $S^A$ is preferably an alkynylene group having 2 to 10 carbon atoms, more preferably an alkynylene group having 2 to 4 carbon atoms, and still more preferably an alkynylene group having 2 or 3 carbon atoms.

In -C(=O)O- as $S^A$, the carbon atom is on a bonding side to the polymethine structure, and the oxygen atom may be a bonding side to $T^A$ or vice versa.

In $--C(=O)NR^{L1}-$ as $S^A$, the carbon atom is on a bonding side to the polymethine structure, and the nitrogen atom may be a bonding side to $T^A$ or vice versa.

$R^{L1}$- represents a hydrogen atom, a halogen atom, an alkyl group, an aryl group, or a monovalent heterocyclic group and is preferably a hydrogen atom or an alkyl group and more preferably a hydrogen atom.

The alkyl group as $R^{L1}$ is preferably an alkyl group having 1 to 10 carbon atoms, more preferably an alkyl group having 1 to 4 carbon atoms, and still more preferably an alkyl group having 1 or 2 carbon atoms.

The aryl group as $R^{L1}$ is preferably an aryl group having 6 to 20 carbon atoms and more preferably a phenyl group or a naphthyl group.

A hetero ring in the monovalent heterocyclic group as $R^{L1}$ is preferably a five-membered ring or a six-membered ring. In addition, the hetero ring may form a fused ring with an aliphatic ring, an aromatic ring or a different hetero ring.

As a hetero atom in the hetero ring, a N atom, an O atom, and a S atom are exemplified, and a N atom is preferred.

As the hetero ring, a pyridine ring, a piperidine ring, a furan ring, a furfuran ring, a thiophene ring, a pyrrole ring, a quinoline ring, a morpholine ring, an indole ring, an imidazole ring, a pyrazole ring, a carbazole ring, a phenothiazine ring, a phenoxazine ring, an indoline ring, a pyrrolidone ring, a thiazole ring, a pyrazine ring, a thiadiazine ring, a benzoquinoline ring, and a thiadiazole ring are exemplified.

The hetero ring may form a salt. For example, the pyridine ring may form a pyridinium salt and may be present as a pyridinium ion.

$R^{L2}$ represents an alkylene group, an arylene group, or a divalent heterocyclic group and is preferably an

alkylene group.

The alkylene group as $R^{L2}$ is preferably an alkylene group having 1 to 10 carbon atoms, more preferably an alkylene group having 1 to 4 carbon atoms, and still more preferably an alkylene group having 1 or 2 carbon atoms.

The arylene group as $R^{L2}$ is preferably an arylene group having 6 to 20 carbon atoms, more preferably a phenylene group or a naphthylene group, and still more preferably a phenylene group.

As the divalent heterocyclic group as $R^{L2}$, a structure obtained by further removing one hydrogen from the monovalent heterocyclic group as $R^{L1}$ is preferred.

In Formula A, $T^A$ is preferably a halogen atom, an amino group, or a monovalent heterocyclic group, more preferably an amino group or a pyridinium group, and still more preferably a pyridinium group.

As the hetero atom as $T^A$, a fluorine atom (F atom), a chlorine atom (Cl atom), a bromine atom (Br atom), and an iodine atom (I atom) are exemplified, a Cl atom or a Br atom is preferred, and a Cl atom is more preferred.

The alkyl group as $T^A$ is preferably an alkyl group having 1 to 10 carbon atoms, more preferably an alkyl group having 1 to 4 carbon atoms, and still more preferably an alkyl group having 1 or 2 carbon atoms.

The aryl group as $T^A$ is preferably an aryl group having 6 to 20 carbon atoms, more preferably a phenyl group or a naphthyl group, and still more preferably a phenyl group.

A hetero ring in the monovalent heterocyclic group as $T^A$ is preferably a five-membered ring or a six-membered ring. In addition, the hetero ring may form a fused ring with an aliphatic ring, an aromatic ring or a different hetero ring.

As a hetero atom in the hetero ring, a N atom, an O atom, and a S atom are exemplified, and a N atom is preferred.

As the hetero ring, a pyridine ring, a triazine ring, a piperidine ring, a furan ring, a furfuran ring, a Meldrum's acid ring, a barbituric acid ring, a succinimide ring, a thiophene ring, a pyrrole ring, a quinoline ring, a morpholine ring, a thiomorpholine ring, an indole ring, an imidazole ring, a pyrazole ring, a carbazole ring, a phenothiazine ring, a phenoxazine ring, an indoline ring, a pyrrolidone ring, a thiazole ring, a pyrazine ring, a thiadiazine ring, a benzoquinoline ring, and a thiadiazole ring are exemplified.

The monovalent heterocyclic group as $T^A$ may form a salt structure. For example, a pyridine ring may form a pyridinium salt or may be a pyridinium ion. In a case in which the pyridine ring is a pyridinium ion, the monovalent heterocyclic group is a pyridinium group.

The monovalent heterocyclic group as $T^A$ is preferably a pyridinium group.

In a case in which $T^A$ is a pyridinium group, $S^A$ is preferably -O-, -S-, $-OR^{L2}-$, or $-NR^{L1}-$ and more preferably -O- or -S-.

The pyridinium group is preferably a group represented by Formula PY.

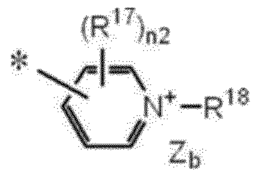

Formula PY

In Formula PY, $R^{17}$ represents a halogen atom, an alkyl group, an aryl group, a hydroxy group, or an alkoxy group; in a case in which a plurality of $R^{17}$'s is present, the plurality of $R^{17}$'s may be identical to or different from each other or the plurality of $R^{17}$'s may be linked to each other to form a ring, n2 represents an integer of 0 to 4, and $R^{18}$ represents an alkyl group or an aryl group. $Z_b$ represents a counter ion for neutralizing a charge.

The alkyl group as $R^{17}$ is preferably an alkyl group having 1 to 20 carbon atoms, more preferably an alkyl group having 1 to 10 carbon atoms, still more preferably an alkyl group having 1 to 4 carbon atoms, and particularly preferably a methyl group.

The aryl group as $R^{17}$ is preferably an aryl group having 6 to 20 carbon atoms, more preferably a phenyl group or a naphthyl group, and still more preferably a phenyl group.

The alkoxy group as $R^{17}$ is preferably an alkoxy group having 1 to 10 carbon atoms, and a methoxy group, an ethoxy group, an n-propoxy group, an isopropoxy group, an n-butoxy group, an isobutoxy group, a tert-butoxy group, and the like are exemplified.

The alkyl group as $R^{18}$ which may include an ether bond or an ester bond is preferably an alkyl group having 1 to 20 carbon atoms, more preferably an alkyl group having 1 to 10 carbon atoms, still more preferably an alkyl group having 1 to 4 carbon atoms, and particularly preferably a methyl group.

The aryl group as $R^{18}$ is preferably an aryl group having 6 to 20 carbon atoms, more preferably a phenyl group or a naphthyl group, and still more preferably a phenyl group.

n2 is preferably 0 or 1, and more preferably 0.

$Z_b$ represents a counter ion for neutralizing a charge and is preferably an anion charge present on the element in Group XIII in the resonant structure formula of the specific infrared absorber.

As the group represented by Formula PY, N-alkyl-2-pyridinium group, N-alkyl-3-pyridinium group, N-benzyl-3-pyridinium group, N-(alkoxypolyalkyleneoxyalkyl)-3-pyridinium group, N-alkoxycarbonylmethyl-3-pyridinium group, N-alkyl-4-pyridinium group, N-benzyl-4-pyridinium group, N-(alkoxypolyalkyleneoxyalkyl)-4-pyridinium group, N-alkoxycarbonylmethyl-4-pyridinium group, and N-alkyl-3,5-dimethyl-4-pyridinium group are exemplified.

Among these, N-alkyl-2-pyridinium group, N-alkyl-3-pyridinium group, or N-alkyl-4-pyridinium group is preferred, and N-alkyl-3-pyridinium group is more preferred.

An alkyl group in these N-alkylpyridinium groups is preferably an alkyl group having 1 to 20 carbon atoms, more preferably an alkyl group having 1 to 10 carbon atoms, still more preferably an alkyl group having 1 to 4 carbon atoms, and particularly preferably a methyl group.

The amino group as $T^A$ is preferably N,N-diarylamino group, N,N-dialkylamino group, or N-alkyl N-arylamino group.

The alkyl group or the aryl group is identical to the alkyl group or the aryl group as $T^A$, and a preferred aspect thereof is also identical thereto.

Hereinafter, specific examples of the group represented by Formula A will be illustrated, but the present disclosure is not limited thereto. In the following specific examples, * represents a bonding location to the carbon atom at the meso position of the polymethine structure.

Among the following specific examples, A-1, A-3, A-7, or A-8 is preferred, and A-7 or A-8 is more preferred.

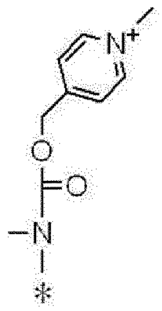
A-1

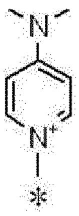
A-2

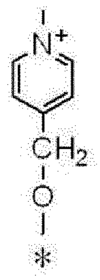
A-3

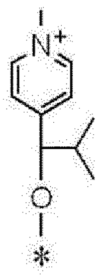
A-4

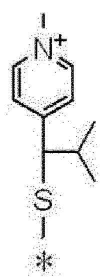
A-5

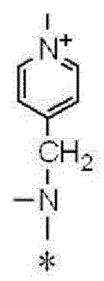
A-6

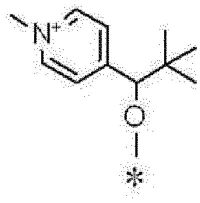
A-7

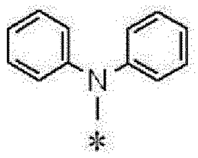
A-8

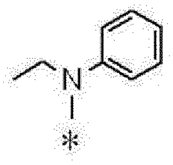
A-9

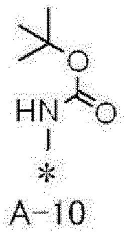
A-10

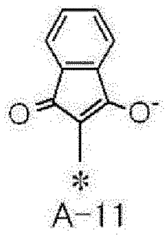
A-11

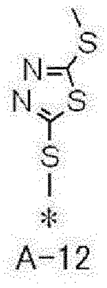
A-12

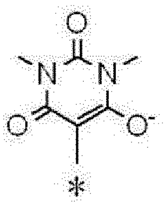
A-13

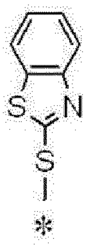
A-14

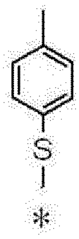
A-15

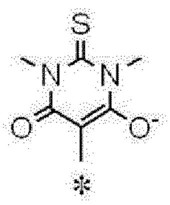
A-16

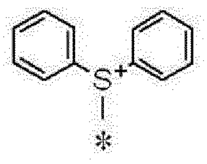
A-17

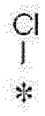
A-18

[Combination of Element in Group XIII and Two or More Hetero Atoms in Chain-Like Polymethine Structure]

It is preferable that the specific infrared absorber has two or more boron atoms and the two or more hetero atoms are two or more oxygen atoms or two or more nitrogen atoms, and it is more preferable that the infrared absorber

has two or more boron atoms and the two or more hetero atoms are four or more oxygen atoms.

[Group Represented by Formula I]

The specific infrared absorber preferably has a group represented by Formula I.

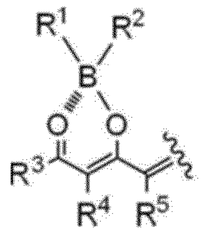

Formula I

In Formula I, $R^1$ and $R^2$ each independently represent a halogen atom or a monovalent atomic group including at least one atom selected from the group consisting of an oxygen atom, a nitrogen atom, and a carbon atom, $R^1$ and $R^2$ may be bonded to each other to form a ring structure, $R^3$, $R^4$, and $R^5$ each independently represent a monovalent atomic group including at least one atom selected from the group consisting of a hydrogen atom, an oxygen atom, a nitrogen atom, and a carbon atom, at least two groups selected from the group consisting of $R^3$, $R^4$, and $R^5$ may be bonded to each other to form a ring structure, and a wavy line moiety represents a bonding site with a different structure.

As the halogen atom as $R^1$ and $R^2$, a fluorine atom, a chlorine atom, a bromine atom, or an iodine atom are exemplified, and a fluorine atom is preferred.

As the monovalent atomic group including at least one atom selected from the group consisting of an oxygen atom, a nitrogen atom, and a carbon atom as $R^1$ and $R^2$, an alkyl group, an aryl group, and a monovalent heterocyclic group are exemplified, and the ring structure formed by the bonding of $R^1$ and $R^2$ may be a monocycle or a fused ring, and a catechol structure, an oxalic acid structure, and a bisimidazole structure are exemplified.

From the viewpoint of the storage stability of the specific infrared absorber, $R^1$ and $R^2$ are preferably an aryl group.

The ring structure formed by the bonding of $R^1$ and $R^2$ may have a substituent, and, as the substituent, an alkyl group, an aryl group, or a monovalent heterocyclic group is exemplified.

$R^3$, $R^4$, and $R^5$ each independently represent a monovalent atomic group including at least one atom selected from the group consisting of a hydrogen atom, an oxygen atom, a nitrogen atom, and a carbon atom.

$R^3$ and $R^4$ each are independently preferably an alkyl group, an aryl group, or a monovalent heterocyclic group.

$R^5$ is preferably a hydrogen atom, an alkyl group, an aryl group, or a monovalent heterocyclic group and more preferably a hydrogen atom.

The ring structure formed by at least two groups selected from the group consisting of $R^3$, $R^4$, and $R^5$ may a monocycle or a fused ring, a barbituric acid ring, a thiobarbituric acid ring, an indanone ring, an indanedione ring, a pyridone ring, a coumarin ring, and the like are exemplified, and a barbituric acid ring or a thiobarbituric acid ring is preferred.

The ring structure formed by at least two groups selected from the group consisting of $R^3$, $R^4$, and $R^5$ may have a substituent, and, as the substituent, an alkyl group, an aryl group, or a monovalent heterocyclic group is exemplified.

In addition, a methine group including a carbon atom to which $R^4$ is bonded is preferably the methine group included in the polymethine structure.

The alkyl group as $R^1$ to $R^5$ or the alkyl group as the substituent as $R^1$ to $R^5$ is preferably an alkyl group having 1 to 30 carbon atoms, more preferably an alkyl group having 1 to 15 carbon atoms, and still more preferably an alkyl group having 1 to 10 carbon atoms.

Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, and a butyl group are particularly preferred.

The aryl group as $R^1$ to $R^5$ is preferably an aryl group having 6 to 30 carbon atoms, more preferably an aryl group having 6 to 20 carbon atoms, and still more preferably an aryl group having 6 to 12 carbon atoms.

The aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, a group formed of a

combination thereof, and the like.

Specific examples thereof include a phenyl group, a naphthyl group, a p-tolyl group, a p-chlorophenyl group, a p-fluorophenyl group, a p-methoxyphenyl group, a p-dimethylaminophenyl group, a p-methyl thiophenyl group, a p-phenylthiophenyl group, and the like.

Among these aryl groups, a phenyl group, a p-methoxyphenyl group, a p-dimethylaminophenyl group, or a naphthyl group is preferred.

The wavy line moiety represents a bonding site with a different structure, is preferably bonded to the carbon atom in the methine group included in the polymethine structure, and, from the viewpoint of absorbing an infrared ray of 700 nm or more, is preferably bonded to a different colorant color developing group through the polymethine structure.

[Compound Represented by Formula II]

The specific infrared absorber is preferably a compound represented by Formula II from the viewpoint of the color developability.

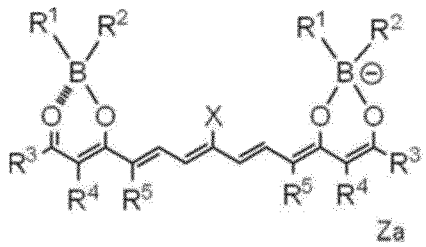

Formula II

In Formula II, $R^1$ and $R^2$ each independently represent a halogen atom or a monovalent atomic group including at least one atom selected from the group consisting of an oxygen atom, a nitrogen atom, and a carbon atom, $R^1$ and $R^2$ may be bonded to each other to form a ring structure, $R^3$, $R^4$, and $R^5$ each independently represent a monovalent atomic group including at least one atom selected from the group consisting of a hydrogen atom, an oxygen atom, a nitrogen atom, and a carbon atom, at least two groups selected from the group consisting of $R^3$, $R^4$, and $R^5$ may be bonded to each other to form a ring structure, a linear polymethine chain may have a ring structure therein, X represents a halogen atom or a monovalent atomic group including at least one atom selected from the group consisting of an oxygen atom, a sulfur atom, a nitrogen atom, and a carbon atom, and Za represents a counter ion for neutralizing a charge.

In Formula II, $R^1$ to $R^5$ are identical to $R^1$ to $R^5$ in Formula I, and preferred aspects thereof are also identical thereto.

In Formula II, the linear polymethine chain may have a ring structure therein. The ring structure is preferably a ring structure including two carbon atoms adjacent to the meso position of the linear polymethine chain. In addition, the ring structure is preferably a hydrocarbon ring, more preferably an aliphatic hydrocarbon ring, and still more preferably a cyclopentene ring or a cyclohexene ring.

In Formula II, X is identical to X in Formula PM1, and a preferred aspect thereof is also identical thereto.

In Formula II, Za represents a counter ion for neutralizing a charge, and examples thereof include a cation for neutralizing an anion charge on an element in Group XIII.

As the cation, cations such as an alkali metal ion, an alkaline earth metal ion, an ammonium ion, a pyridinium ion, an imidazolium ion, a phosphonium ion, an iodonium ion, a diazonium ion, a sulfonium ion, and an alkylated diazabicycloundecene ion are exemplified, a sodium ion, a potassium ion, an ammonium ion, a pyridinium ion, or a sulfonium ion is preferred, and a potassium ion, a pyridinium ion, or an ammonium ion is more preferred.

Meanwhile, in a case in which the mother nucleus structure of the compound represented by Formula II is electrically neutral, Za is not present.

[Compound Represented by Formula III]

The specific infrared absorber is preferably a compound represented by Formula III from the viewpoint of the color developability and the storage stability.

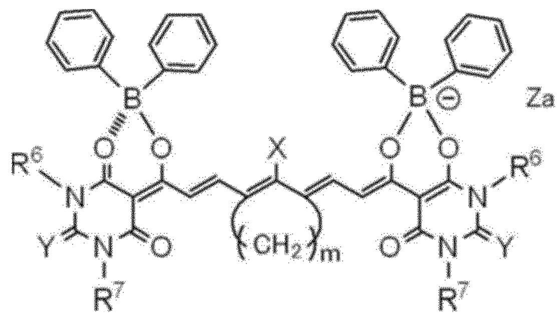

Formula III

In Formula III, $R^6$ and $R^7$ each independently represent a hydrogen atom, an alkyl group, or an aryl group, X represents a halogen atom or a monovalent atomic group including at least one atom selected from the group consisting of an oxygen atom, a sulfur atom, a nitrogen atom, and a carbon atom, each Y independently represents an oxygen atom, a sulfur atom, or a divalent atomic group including at least one atom selected from the group consisting of a nitrogen atom and a carbon atom, m represents an integer of 2 to 10, and Za represents a counter ion for neutralizing a charge.

In Formula III, $R^6$ and $R^7$ each independently represent a hydrogen atom, an alkyl group, or an aryl group, are preferably a hydrogen atom, an alkyl group having 1 to 20 carbon atoms, or an aryl group having 6 to 20 carbon atoms, more preferably a hydrogen atom, an alkyl group having 1 to 10 carbon atoms, a phenyl group, or a naphthyl group, and still more preferably an alkyl group having 1 to 10 carbon atoms.

In Formula III, X is identical to X in Formula PM1, and a preferred aspect thereof is also identical thereto.

In Formula III, each Y independently represents an oxygen atom, a sulfur atom, or a divalent atomic group including at least one atom selected from the group consisting of a nitrogen atom and a carbon atom, an oxygen atom or a sulfur atom is preferred, and an oxygen atom is more preferred.

In a case in which Y represents a divalent atomic group including at least one atom selected from the group consisting of a nitrogen atom and a carbon atom, the atomic group may be bonded to at least one group selected from the group consisting of $R^6$ and $R^7$ to form a ring structure.

In Formula III, m represents an integer of 2 to 10 and is preferably an integer of 2 to 6 and more preferably 2 or 3.

In Formula III, Za is identical to Za in Formula II, and a preferred aspect thereof is also identical thereto.

Hereinafter, specific examples of the specific infrared absorber will be illustrated, but the present disclosure is not limited thereto.

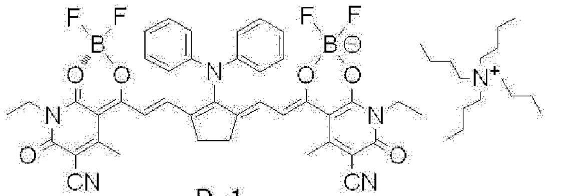

D-1

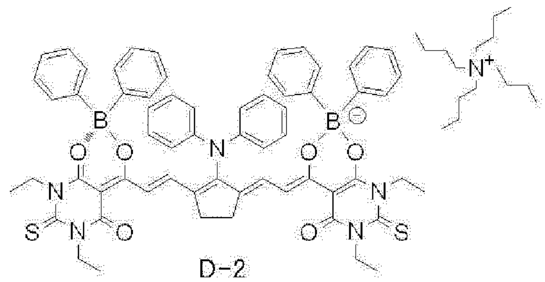

D-2

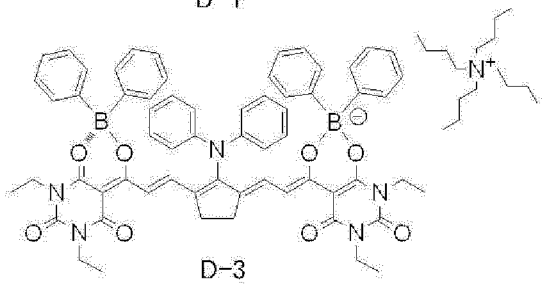

D-3

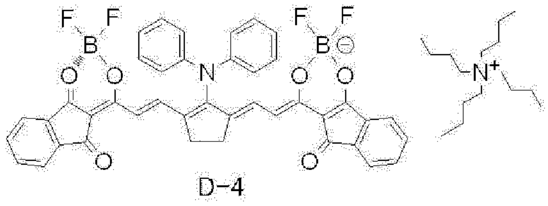

D-4

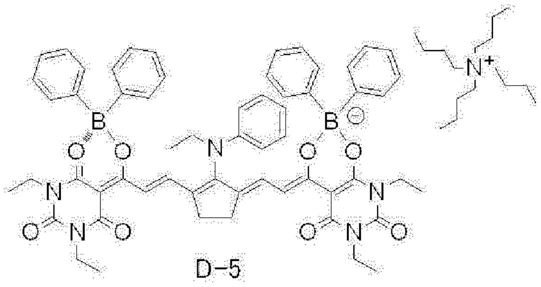

D-5

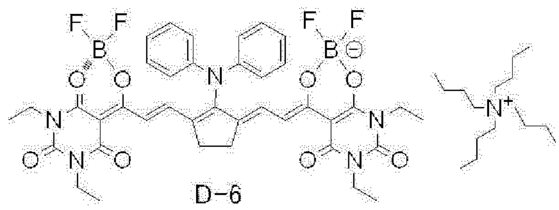

D-6

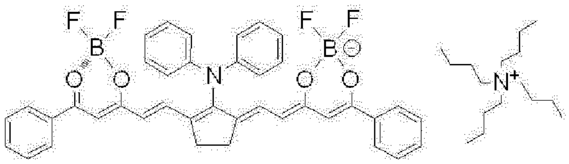

D-7

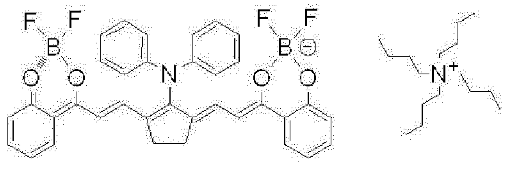

D-8

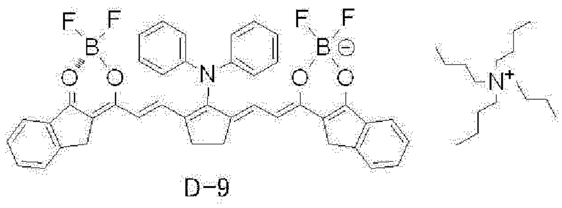

D-9

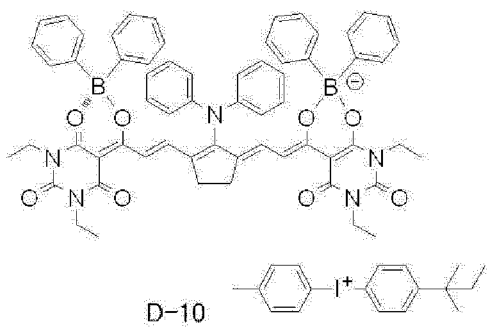

D-10

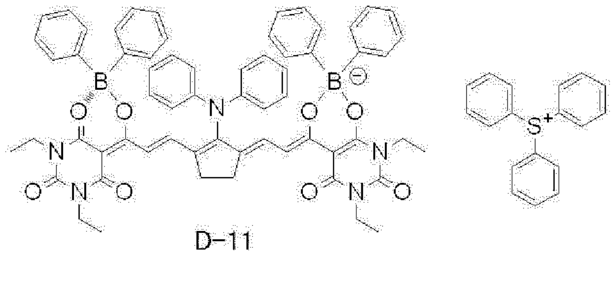

D-11

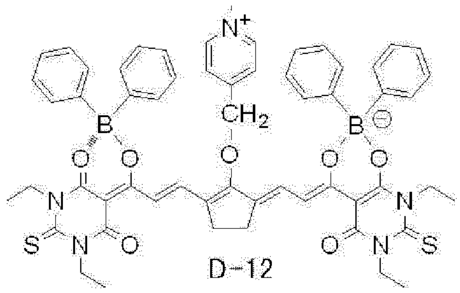
D-12

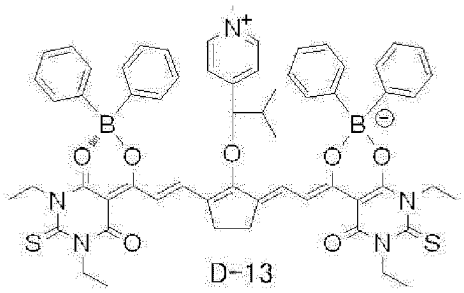
D-13

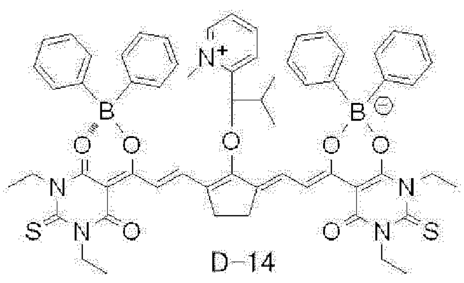
D-14

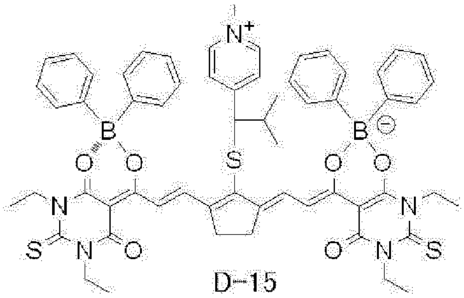
D-15

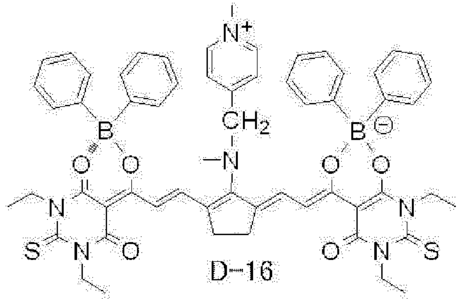
D-16

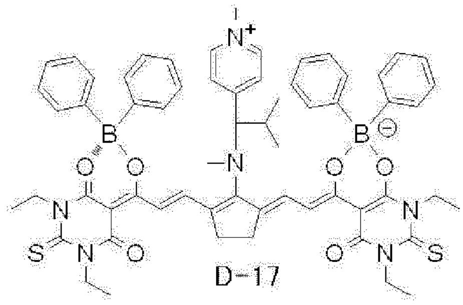
D-17

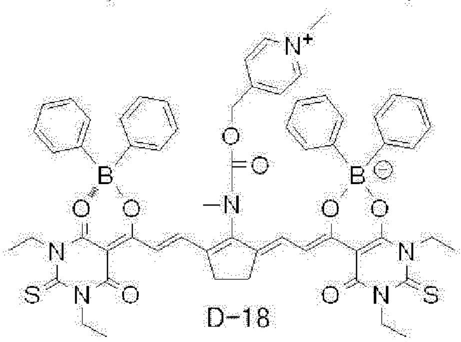
D-18

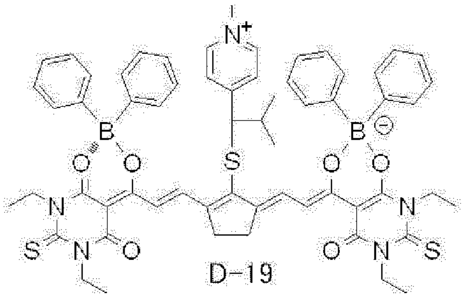
D-19

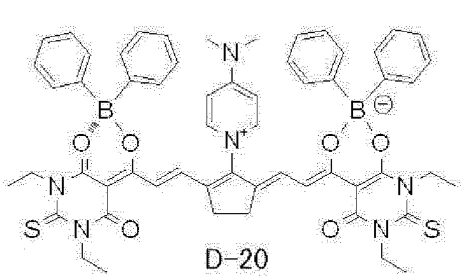
D-20

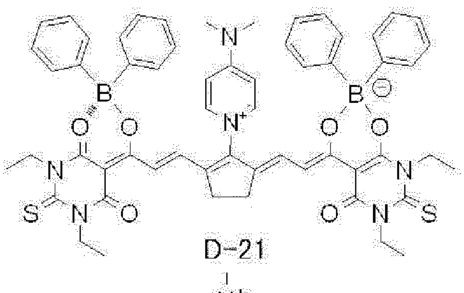
D-21

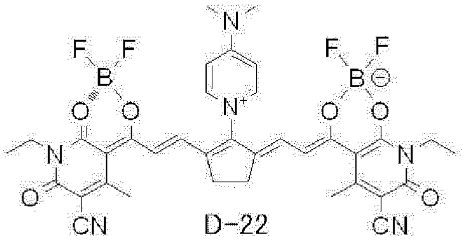
D-22

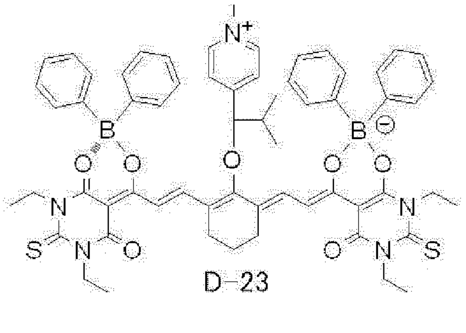
D-23

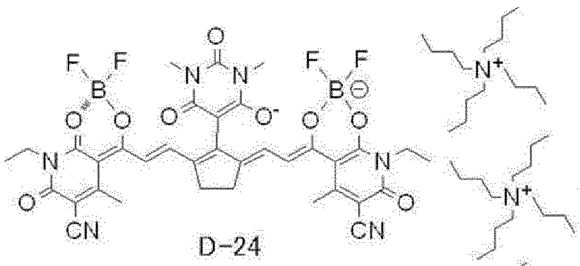

D-24

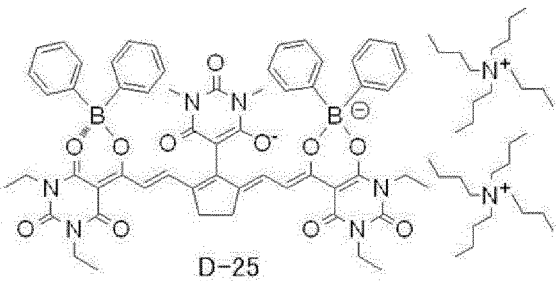

D-25

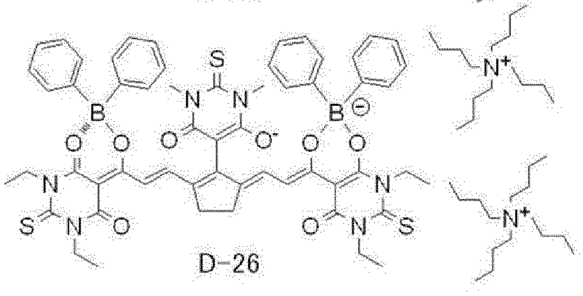

D-26

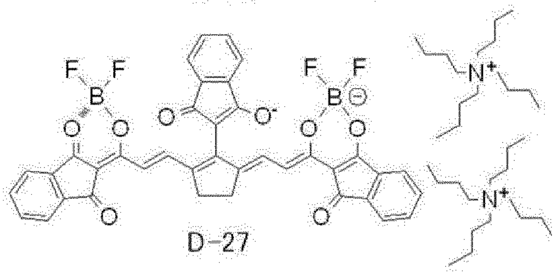

D-27

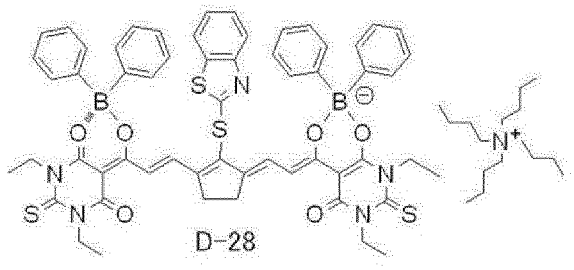

D-28

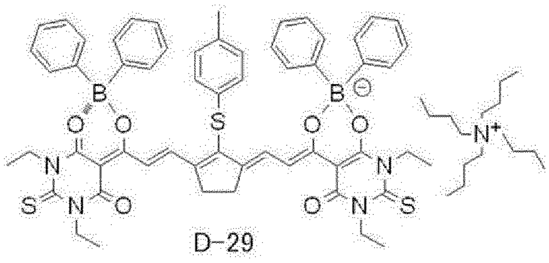

D-29

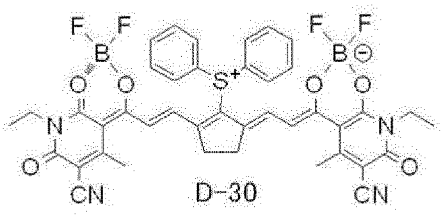

D-30

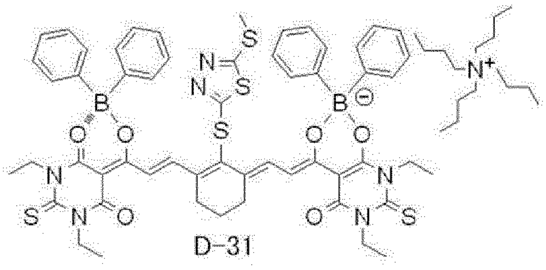

D-31

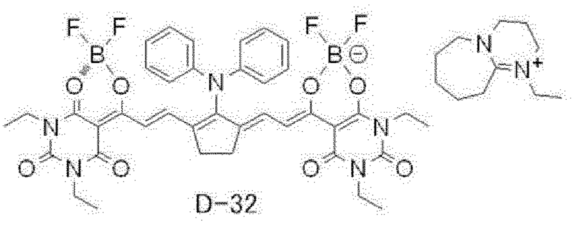

D-32

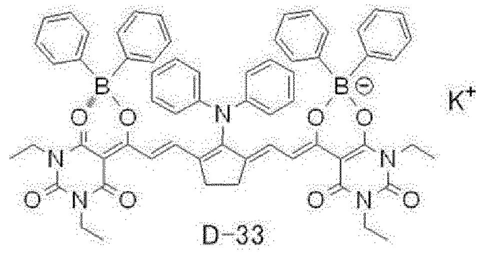

D-33

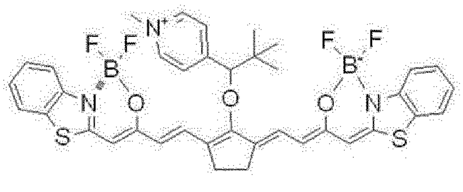

D-34

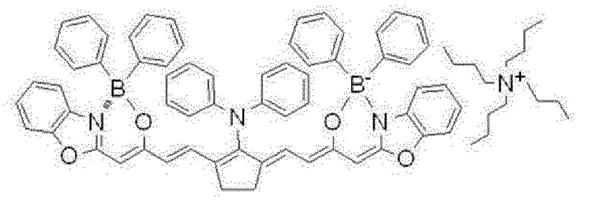

D-35

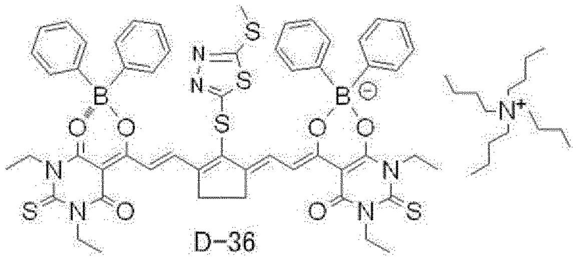

D-36

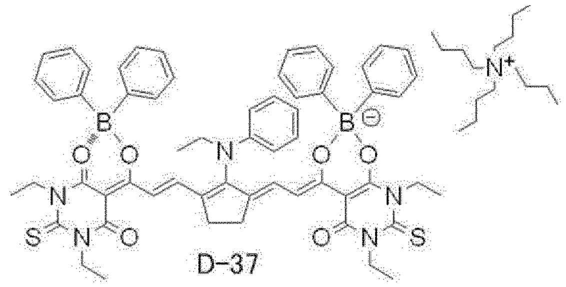

D-37

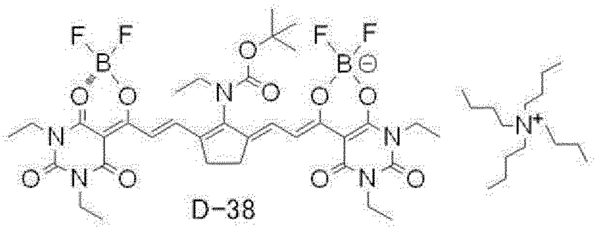

D-38

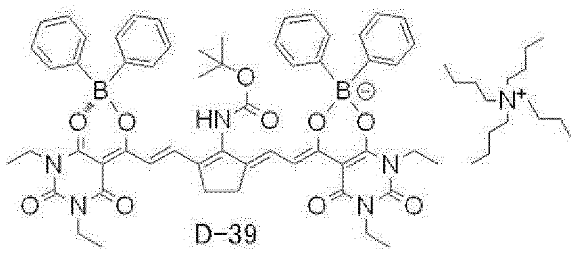

D-39

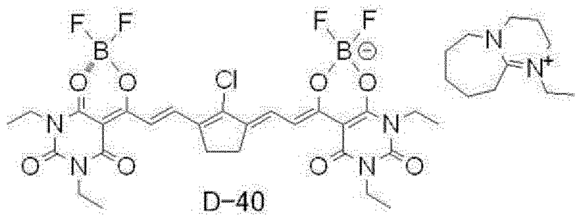

D-40

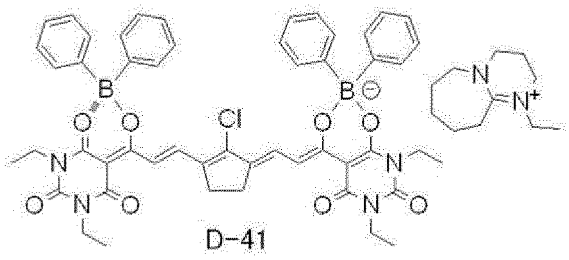

D-41

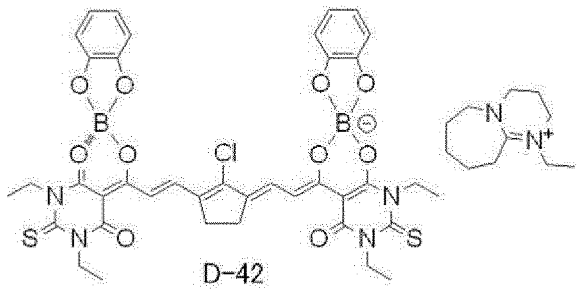

D-42

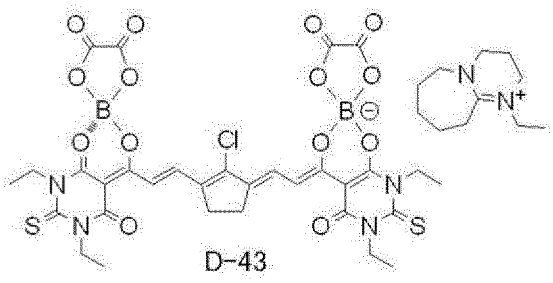

D-43

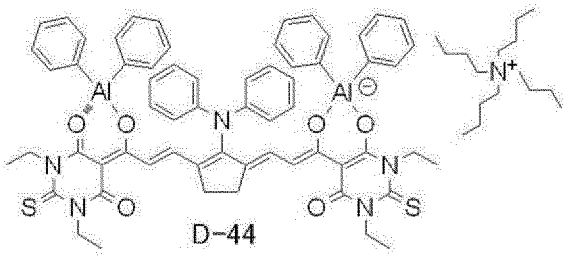

D-44

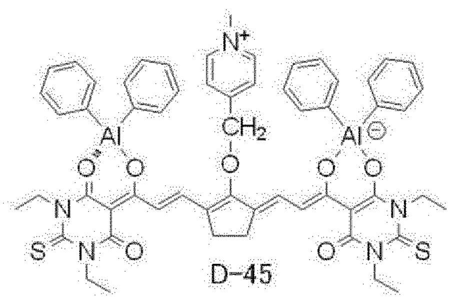

D-45

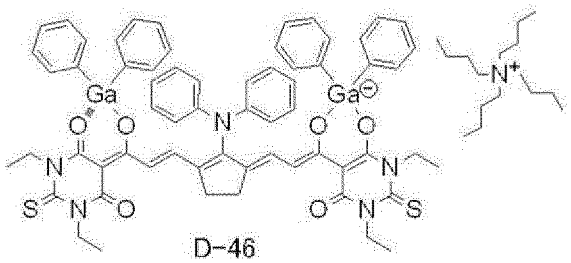

D-46

The specific infrared absorber may be used singly or two or more specific infrared absorbers may be jointly used.

In the curable composition according to the embodiment of the present disclosure, the content of the specific infrared absorber is preferably in a range of 0.1% to 95% by mass, more preferably in a range of 1% to 50% by mass, and still more preferably in a range of 1% to 40% by mass of the total solid content of the curable composition. Meanwhile, the total solid content in the present disclosure refers to the total amount of components in the composition excluding volatile components such as a solvent.

The specific infrared absorber can be synthesized according to, for example, a synthesis scheme illustrated below. In the following synthesis scheme, $Ac_2O$ represents an acetic anhydride, $Et_3N$ represents triethylamine, AR represents acetonitrile, DMF represents dimethylformamide, and MeOTs represents methyl para-toluenesulfonate respectively.

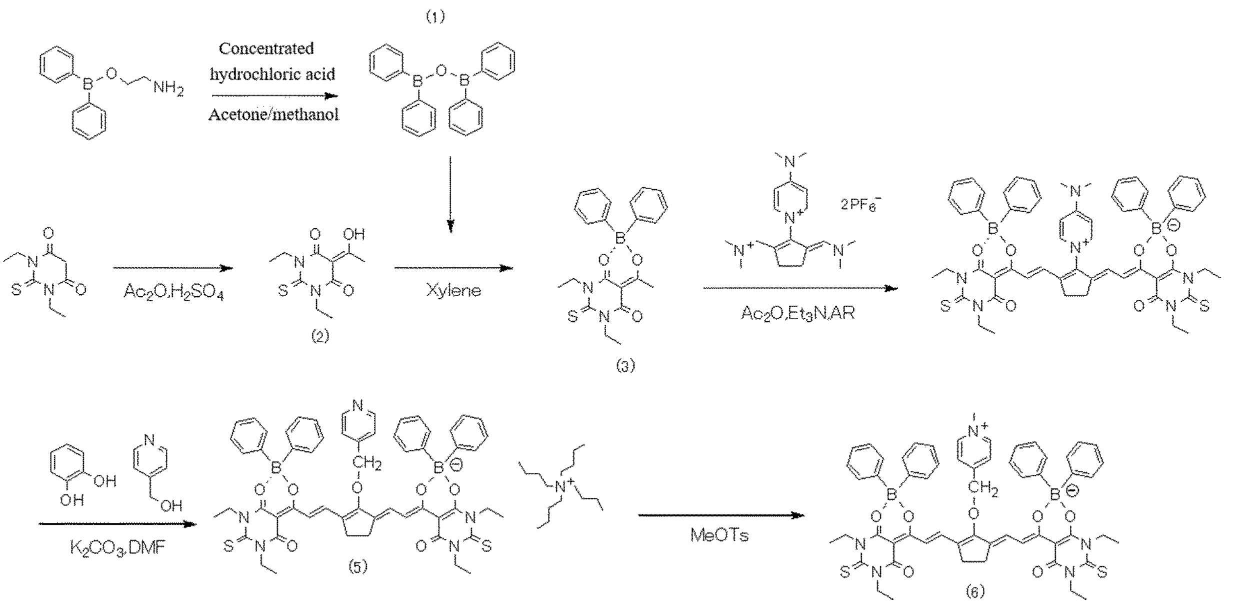


[Polymerizable Compound]

The curable composition of the first embodiment according to the present disclosure contains a polymerizable compound.

The polymerizable compound that is used in the curable composition may be, for example, a radical polymerizable compound or a cationic polymerizable compound, but is preferably an addition polymerizable compound having at least one ethylenically unsaturated bond (ethylenically unsaturated compound). The ethylenically unsaturated compound is preferably a compound having at least one terminal ethylenically unsaturated bond and more preferably a compound having two or more terminal ethylenically unsaturated bonds. The polymerizable compound may have a chemical form, for example, a monomer, a prepolymer, that is, a dimer, a trimer, or an oligomer, or a mixture thereof.

Examples of the monomer include unsaturated carboxylic acids (for example, acrylic acid, methacrylic acid, itaconic acid, crotonic acid, isocrotonic acid, and maleic acid), esters thereof, and amides thereof, and esters of unsaturated carboxylic acids and polyvalent amine compounds and amides of unsaturated carboxylic acids and polyhydric alcohol compounds are preferably used. In addition, addition reaction products between unsaturated carboxylic acid esters or amides having nucleophilic substituents such as hydroxy groups, amino groups, or mercapto groups and monofunctional or polyfunctional isocyanates or epoxies, dehydration condensation reaction products with monofunctional or polyfunctional carboxylic acids, and the like are also preferably used. In addition, addition reaction products between unsaturated carboxylic acid esters or amides having electrophilic substituents such as isocyanate groups and epoxy groups and monofunctional or polyfunctional alcohols, amines, or thiols, furthermore, substitution reaction products between unsaturated carboxylic acid esters or amides having dissociable substituents such as halogen atoms and tosyloxy groups and monofunctional or polyfunctional alcohols, amines, or thiols are also preferred. In addition, as additional examples, compound groups obtained by substituting the unsaturated carboxylic acids with unsaturated phosphonic acids, styrene, vinyl ethers, or the like can also be used. These monomers are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-064130A, JP2003-280187A, JP1998-333321A(JP-H10-333321A), and the like.

As specific examples of monomers of esters of polyhydric alcohol compounds and unsaturated carboxylic acids, examples of acrylic acid esters include ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, polyester acrylate oligomers, and the like. Examples of methacrylic acid esters include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, bis[p-(methacryloxyethoxy)phenyl] dimethyl methane, and the like. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxy group are also preferred, and specific examples thereof include vinyl urethane compounds having two or more polymerizable vinyl groups in one monomer obtained by adding vinyl monomers having a hydroxy group represented by Formula (M) to a polyisocyanate compound having two or more isocyanate groups in one molecule which is described in, for example, JP1973-041708B (JP-S48-041708B).

$$CH_2=C(R^{M4})COOCH_2CH(R^{M5})OH \qquad (M)$$

In Formula (M), each of $R^{M4}$ and $R^{M5}$ independently represents a hydrogen atom or a methyl group.

In addition, urethane acrylates described in JP1976-037193A (JP-S51-037193A), JP1990-032293B (JP-H02-032293B), JP1990-016765B (JP-H02-016765B), JP2003-344997A, and JP2006-065210A, urethane compounds having ethylene oxide-based skeletons described in JP1983-049860B (JP-S58-049860B), JP1981-017654B (JP-S56-017654B), JP1987-039417B (JP-S62-039417B), JP1987-039418B (JP-S62-039418B), JP2000-250211A, and JP2007-094138A, and urethane compounds having hydrophilic groups described in US7153632B, JP1996-505958A (JP-H08-505958A), JP2007-293221A, and JP2007-293223A are also preferred.

The details of the structures of the polymerizable compound and the method for using the polymerizable compound such as whether to use the polymerizable compound singly or jointly and the amount of the polymerizable compound added can be randomly set in consideration of the applications and the like of the final curable composition.

The content of the polymerizable compound is preferably in a range of 5% to 75% by mass, more preferably in a range of 10% to 70% by mass, and particularly preferably in a range of 15% to 60% by mass of the total solid content of the curable composition.

[Polymerization Initiator]

The curable composition of the first embodiment according to the present disclosure contains a polymerization initiator.

The polymerization initiator that is used in the curable composition is a compound that generates a polymerization-initiating species such as a radical or a cation with the energy of heat, light, or both, and it is possible to appropriately select from a well-known thermopolymerization initiator, a compound having a bond with a small bond dissociation energy, a photopolymerization initiator, and the like and use it.

The polymerization initiator is preferably an infrared-sensitive polymerization initiator. In addition, the polymerization initiator is preferably a radical polymerization initiator.

Examples of the radical polymerization initiator include (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound, and (k) an onium salt compound.

As the organic halide (a), for example, a compound described in Paragraphs 0022 and 0023 of JP2008-195018A

is preferred.

As the carbonyl compound (b), for example, a compound described in Paragraph 0024 of JP2008-195018A is preferred.

As the azo compound (c), for example, an azo compound described in JP1996-108621A(JP-H08-108621A) is exemplified.

As the organic peroxide (d), for example, a compound described in Paragraph 0025 of JP2008-195018A is preferred.

As the metallocene compound (e), for example, a compound described in Paragraph 0026 of JP2008-195018A is preferred.

As the azide compound (f), for example, a compound such as 2,6-bis(4-azidobenzylidene)-4-methylcyclohexanone is exemplified.

As the hexaarylbiimidazole compound (g), for example, a compound described in Paragraph 0027 of JP2008-195018A is preferred.

As the organic borate compound (h), for example, a compound described in Paragraph 0028 of JP2008-195018A is preferred.

As the disulfone compound (i), for example, a compound described in each of JP1986-166544A (JP-S61-166544A) and JP2002-328465A is exemplified.

As the oxime ester compound (j), for example, a compound described in Paragraphs 0028 to 0030 of JP2008-195018A is preferred.

As the polymerization initiators, from the viewpoint of the curing property, an oxime ester and an onium salt are more preferably exemplified, and onium salts such as an iodonium salt, a sulfonium salt, and an azinium salt are still more preferably exemplified. In the case of being used for a lithographic printing plate precursor, an iodonium salt and a sulfonium salt are particularly preferred. Specific examples of the iodonium salt and the sulfonium salt will be described below, but the present disclosure is not limited thereto.

An example of the iodonium salt is preferably a diphenyl iodonium salt, particularly, preferably a diphenyl iodonium salt having an electron-donating group as a substituent, for example, a diphenyl iodonium salt substituted with an alkyl group or an alkoxyl group, and preferably an asymmetric diphenyl iodonium salt. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

The sulfonium salts are preferably triarylsulfonium salts, particularly preferably triarylsulfonium salts having an electron-attracting group as a substituent, for example, triarylsulfonium salts in which at least some of groups on the aromatic ring are substituted with a halogen atom, and still more preferably triarylsulfonium salts in which the total number of substituting halogen atoms on the aromatic ring is four or greater. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

The polymerization initiator may be used singly or two or more polymerization initiators may be jointly used.

The content of the polymerization initiator is preferably 0.1% to 50% by mass, more preferably 0.5% to 30% by mass, and particularly preferably 0.8% to 20% by mass of the total solid content of the curable composition.

[Binder Polymer]

The curable composition according to the embodiment of the present disclosure preferably contains a binder polymer. The binder polymer that is used in the curable composition is preferably a polymer having a film property, and it is possible to preferably use well-known binder polymers that can be used in the curable composition. Among them, as the binder polymer, a (meth)acrylic resin, a polyvinyl acetal resin, and a polyurethane resin are preferred.

In a case in which the curable composition is applied to an image-recording layer in a lithographic printing plate precursor, as the binder polymer, it is possible to preferably use well-known binder polymers that can be used in the image-recording layer in the lithographic printing plate precursor. As an example, a binder polymer that is used for an on-machine development-type lithographic printing plate precursor (hereinafter, also referred to as the binder polymer for on-machine development) will be described in detail.

As the binder polymer for on-machine development, a binder polymer having an alkylene oxide chain is preferred. The binder polymer having an alkylene oxide chain may have a poly(alkylene oxide) portion in a main chain or in a side chain. In addition, the binder polymer may be a graft polymer having poly(alkylene oxide) in a side chain or a block

copolymer of a block constituted of a poly(alkylene oxide)-containing repeating unit and a block constituted of an (alkylene oxide)-non-containing repeating unit.

In the case of having a poly(alkylene oxide) portion in the main chain, the binder polymer is preferably a polyurethane resin. As a polymer in the main chain in a case in which the binder polymer has a poly(alkylene oxide) portion in the side chain, a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber are exemplified, and, particularly, a (meth)acrylic resin is preferred.

The alkylene oxide is preferably alkylene oxide having 2 to 6 carbon atoms and particularly preferably ethylene oxide or propylene oxide.

The number of times of repetition of the alkylene oxide in the poly(alkylene oxide) portion is preferably 2 to 120, more preferably 2 to 70, and still more preferably 2 to 50.

In a case in which the number of times of repetition of the alkylene oxide is 120 or less, neither the printing resistance against wear nor the printing resistance against the ink-receiving property degrades, which is preferable.

The poly(alkylene oxide) portion is preferably contained in a form of a structure represented by Formula (AO) as the side chain of the binder polymer and more preferably contained in a form of the structure represented by Formula (AO) as the side chain of the (meth)acrylic resin.

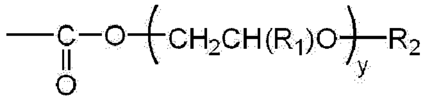

(AO)

In Formula (AO), y represents 2 to 120, $R_1$ represents a hydrogen atom or an alkyl group, and $R_2$ represents a hydrogen atom or a monovalent organic group.

The monovalent organic group is preferably an alkyl group having 1 to 6 carbon atoms. Specific examples thereof include a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group, and a cyclohexyl group.

In Formula (AO), y is preferably 2 to 70 and more preferably 2 to 50. $R_1$ is preferably a hydrogen atom or a methyl group and particularly preferably a hydrogen atom. $R_2$ is particularly preferably a hydrogen atom or a methyl group.

The binder polymer may have a crosslinking property in order to improve the membrane hardness of an image area. In order to provide a crosslinking property to the polymer, a crosslinking functional group such as an ethylenically unsaturated bond may be introduced to a main chain or a side chain of a polymer. The crosslinking functional group may be introduced by copolymerization or may be introduced by a polymer reaction.

Examples of a polymer having an ethylenically unsaturated bond in the main chain of the molecule include poly-1,4-butadiene, poly-1,4-isoprene, and the like.

Examples of a polymer having an ethylenically unsaturated bond in the side chain of the molecule include polymers that are an ester or an amide of acrylic acid or methacrylic acid and in which a residue (R in -COOR or -CONHR) of the ester or the amide is a polymer having an ethylenically unsaturated bond.

Examples of the residue (the R) having an ethylenically unsaturated bond can include $-(CH_2)_nCR^{1A}=CR^{2A}R^{3A}$, $-(CH_2O)_nCH_2CR^{1A}=CR^{2A}R^{3A}$, $-(CH_2CH_2O)_nCH_2CR^{1A}=CR^{2A}R^{3A}$, $-(CH_2)_nNH-CO-O-CH_2CR^{1A}=CR^{2A}R^{3A}$, $-(CH_2)_n-O-CO-CR^{1A}=CR^{2A}R^{3A}$, and $-(CH_2CH_2O)_2-X^A$ (in the formulae, $R^{A1}$ to $R^{A3}$ each independently represent a hydrogen atom, a halogen atom, an alkyl group having 1 to 20 carbon atoms, an aryl group, an alkoxy group, or an aryloxy group, and $R^{A1}$ and $R^{A2}$ or $R^{A3}$ may be bonded to each other to form a ring. n represents an integer of 1 to 10. $X^A$ represents a dicyclopentadienyl residue.).

Specific examples of an ester residue include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$, and $-CH_2CH_2O-X$ (in the formula, X represents a dicyclopentadienyl residue.).

Specific examples of an amide residue include $-CH_2CH=CH_2$, $-CH_2CH_2-Y$ (in the formula, Y represents a cyclohexene residue.), and $-CH_2CH_2-OCO-CH=CH_2$.

The binder polymer having a crosslinking property is cured as follows: for example, a free radical (a polymerization initiation radical or a growth radical in a polymerization process of a polymerizable compound) is added to the crosslinking functional group, addition polymerization occurs between polymer molecules directly or through the polymerization chain of the polymerizable compound, and a crosslink is formed between the polymer molecules, whereby the polymer is cured. Alternatively, an atom in the polymer (for example, a hydrogen atom on a carbon atom adjacent to the crosslinking functional group) is pulled off by a free radical, polymer radicals are generated, and the polymer radicals are bonded to each other, whereby a crosslink is formed between the polymer molecules, and the polymer is cured.

The content of the crosslinking group in the binder polymer (the content of an unsaturated double bond that is

radical polymerizable by iodimetry) is preferably 0.1 to 10.0 mmol, more preferably 1.0 to 7.0 mmol, and particularly preferably 2.0 to 5.5 mmol per gram of the binder polymer from the viewpoint of a favorable sensitivity and a favorable storage stability.

Hereinafter, specific examples 1 to 11 of the binder polymer will be illustrated, but the present disclosure is not limited thereto. In the following exemplary compounds, numerical values described together with individual repeating units (numerical values described together with main chain repeating units) represent the molar percentages of the repeating units. Numerical values described together with side chain repeating units represent the number of times of repetition of the repeating portions. In addition, Me represents a methyl group, Et represents an ethyl group, and Ph represents a phenyl group.

(1)

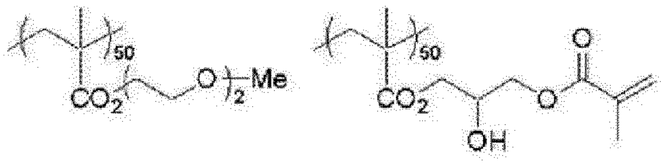

(2)

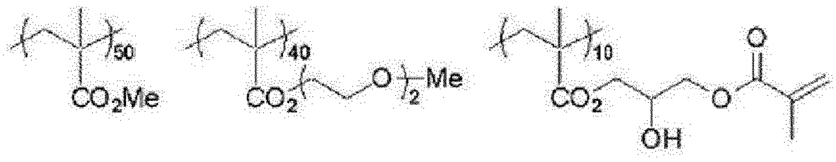

(3)

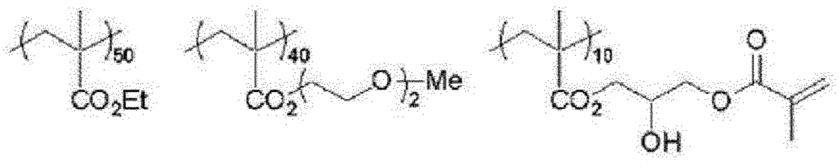

(4)

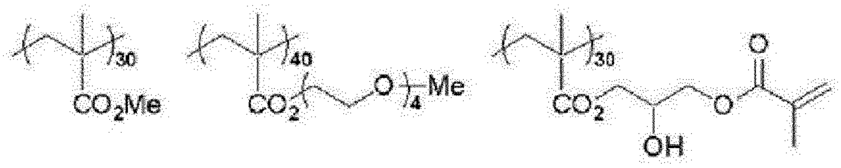

(5)

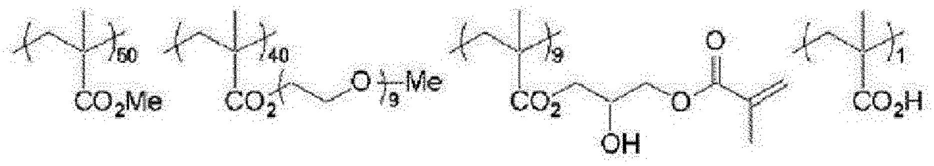

(6)

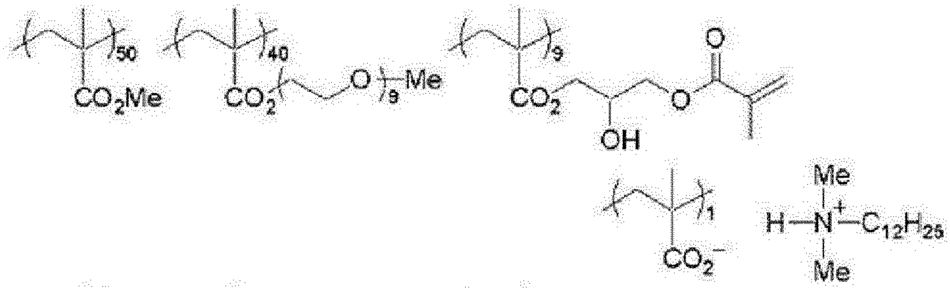

(7)

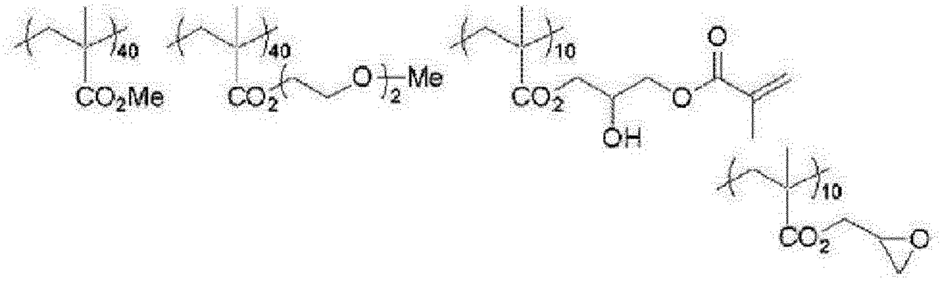

(8)

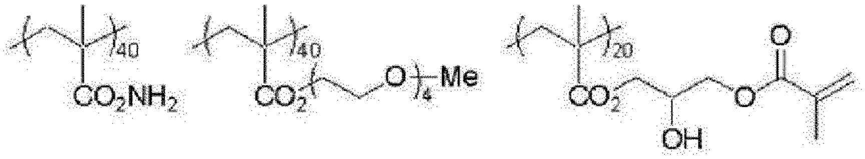

(9)

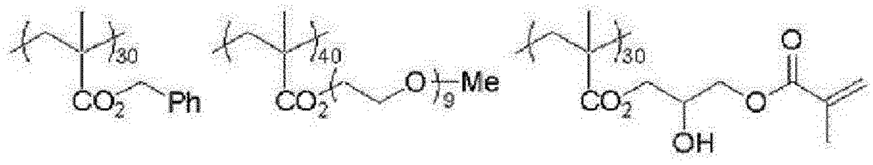

(10)

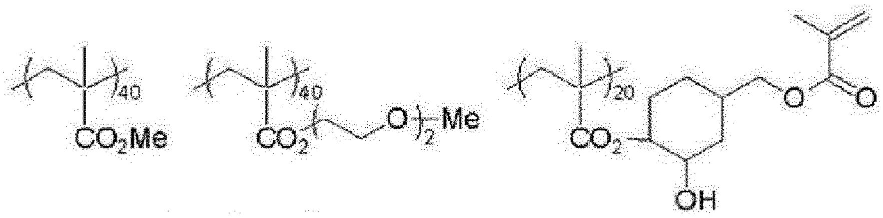

(11)

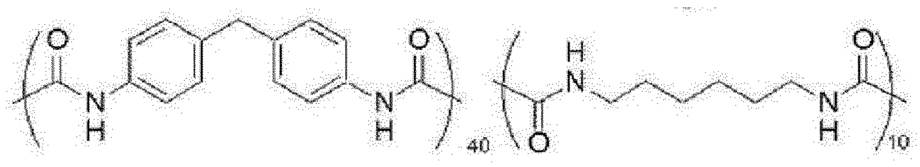

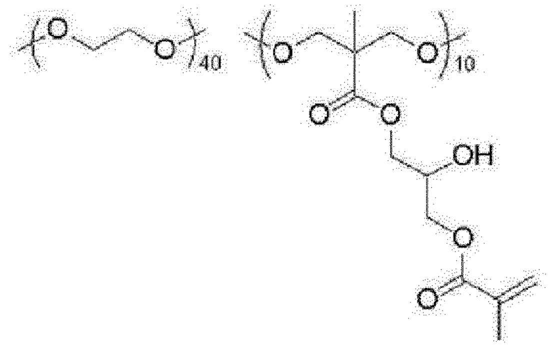

Regarding the molecular weight of the binder polymer that is used in the present disclosure, the weight-average molecular weight (Mw) as a polystyrene equivalent value by a GPC method is 2,000 or more, preferably 5,000 or more, and more preferably 10,000 to 300,000.

In addition, in the present disclosure, an oligomer refers to a substance having Mw of 800 or more and less than 2,000, and a polymer refers to a substance having Mw of 2,000 or more.

If necessary, it is possible to jointly use a hydrophilic polymer such as polyacrylic acid or polyvinyl alcohol described in JP2008-195018A. In addition, it is also possible to jointly use a lipophilic polymer and a hydrophilic polymer.

In a case in which the curable composition according to the embodiment of the present disclosure is applied to the image-recording layer in the lithographic printing plate precursor, the binder polymer may be present as a polymer that functions as a binder of the respective components or may be present in a particle shape in the curable composition. In a case in which the binder polymer is present in a particle shape, the number-average primary particle diameter is preferably 10 to 1,000 nm, more preferably 20 to 300 nm, and still more preferably 30 to 120 nm.

In the present disclosure, the volume average primary particle diameter is obtained by capturing an electron micrograph of particles, measuring the particle diameters of a total of 5,000 particles on the photograph, and computing the arithmetical average value.

Meanwhile, for a non-spherical particle, the particle diameter value of a spherical particle having the same particle area as the particle area on the photograph was considered as the particle diameter (circle-equivalent diameter).

The above-described method for measuring the volume average primary particle diameter shall apply to the particle of any substances other than the binder polymer which is present in a particle shape as long as there is no special description.

In the curable composition of the embodiment of the present disclosure, the binder polymer may be used singly or two or more binder polymers may be jointly used.

The binder polymer can be added to the curable composition in any amount. The content of the binder polymer can be appropriately selected depending on the application or the like of the curable composition, but is preferably 1% to 90% by mass and more preferably 5% to 80% by mass of the total solid content of the curable composition.

[Radical Production Aid]

The curable composition according to the embodiment of the present disclosure may contain a radical production aid. The radical production aid contributes to the improvement of the printing resistance in lithographic printing plates in a case in which the curable composition is used for image-recording layers in the lithographic printing plate precursors. Examples of the radical production aid include five kinds of radical production aids described below.

(i) Alkyl or arylate complexes: It is considered that carbon-hetero bonds are oxidatively cleaved and active radicals are generated. Specific examples thereof include borate compounds and the like.

(ii) Amino acetate compounds: It is considered that C-X bonds on carbon adjacent to nitrogen are cleaved due to oxidation and active radicals are generated. X is preferably a hydrogen atom, a carboxy group, a trimethylsilyl group, or a benzyl group. Specific examples thereof include N-phenylglycines (which may have a substituent in a phenyl group), N-phenyl iminodiacetic acids (which may have a substituent in a phenyl group), and the like.

(iii) Sulfur-containing compounds: The above-described amino acetate compounds in which a nitrogen atom is

substituted with a sulfur atom are capable of generating active radicals by means of the same action. Specific examples thereof include phenylthioacetic acids (which may have a substituent in a phenyl group) and the like.

(iv) Tin-containing compounds: The above-described amino acetate compounds in which a nitrogen atom is substituted with a tin atom are capable of generating active radicals by means of the same action.

(v) Sulfinates: Active radicals can be generated by means of oxidation. Specific examples thereof include sodium aryl sulfinate and the like.

Among these radical production aids, the curable composition preferably contains a borate compound. The borate compound is preferably a tetraaryl borate compound or a monoalkyltriaryl borate compound, more preferably a tetraaryl borate compound from the viewpoint of the stability of the compound and the potential difference described below, and particularly preferably a tetraaryl borate compound having one or more aryl groups having an electron-attracting group from the viewpoint of the potential difference described below.

The electron-attracting group is preferably a group having a positive $\sigma$ value of the Hammett equation and more preferably a group having a $\sigma$ value of the Hammett equation in a range of 0 to 1.2. The $\sigma$ value of the Hammett (the $\sigma p$ value and the $\sigma m$ value) are described in detail in Hansch, C.; Leo, A.; Taft, R. W., Chem. Rev., 1991, 91, 165 to 195.

The electron-attracting group is preferably a halogen atom, a trifluoromethyl group, or a cyano group and more preferably a fluorine atom, a chlorine atom, a trifluoromethyl group, or a cyano group.

A counter cation in the borate compound is preferably an alkali metal ion or a tetraalkyl ammonium ion and more preferably a sodium ion, a potassium ion, or a tetrabutylammonium ion.

In a case in which the curable composition includes the borate compound, the potential difference $\Delta G2$ between the highest occupied molecular orbital (HOMO) of the specific infrared absorber and the highest occupied molecular orbital of the borate compound ($\Delta G2$=the HOMO of the specific infrared absorber-the HOMO of the borate compound) is preferably 0.500 eV or more, more preferably 0.585 eV or more, and particularly preferably 0.608 to 1.000 eV.

In a case in which the potential difference between the HOMO of the specific infrared absorber and the HOMO of the borate compound is in the above-described range, it is considered that the stability of the borate compound while not exposed to heat or infrared rays is excellent, and, in a case in which the borate compound is exposed to heat or infrared rays, electrons migrate from the HOMO of the borate compound to the HOMO of the specific infrared absorber, and thus the excitation of electrons to the lowest unoccupied molecular orbital (LUMO) of the specific infrared absorber is accelerated, and the decomposition of the specific infrared absorber is accelerated. In addition, it is considered that the electron migration from the specific infrared absorber to the polymerization initiator is also accelerated, and contribution is made to the improvement of the printing resistance in lithographic printing plates in a case in which the curable composition is used for an image-recording layer in the lithographic printing plate precursor.

The HOMO and LUMO of the compound represented by Formula (1) are computed using the following method.

First, counter anions in compounds which are computation subjects are ignored.

Quantum chemical calculation software Gaussian 09 is used, and structure optimization is carried out in DFT (B3LYP/6-31G(d)).

The molecular orbital (MO) energy is calculated using the structure obtained by means of the structure optimization in DFT (B3LYP/6-31+G(d,p)/CPCM (solvent=methanol)).

The MO energy Epre (unit: hartree) obtained by the above-described MO energy calculation is converted to Eaft (unit: eV) which is used as the HOMO and LUMO values in the present disclosure using the following expression.

$$\text{Eaft}=0.823168\times 27.2114\times \text{Epre}-1.07634$$

Meanwhile, 27.2114 is simply a coefficient for converting hartree to eV, 0.823168 and -1.07634 are adjustment coefficients, and the HOMO and LUMO of compounds which are computation subjects are specified so that computation matches actually measured values.

$\Delta G2$ is obtained from the difference between the HOMO of the compound represented by Formula (1) and the HOMO of the borate compound ($\Delta G2$=the HOMO of the compound represented by Formula (1)-the HOMO of the borate compound).

Specific examples of the borate compound include compounds illustrated below. Here, $X_c^+$ represents a monovalent cation and is preferably an alkali metal ion or a tetraalkyl ammonium ion and more preferably an alkali metal ion or a tetrabutylammonium ion. In addition, Bu represents an n-butyl group.

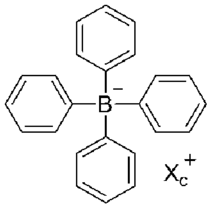
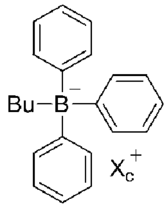
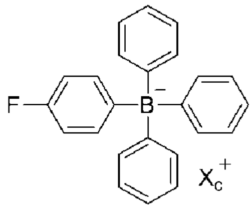
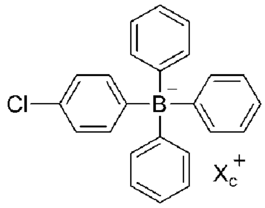

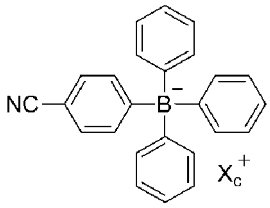
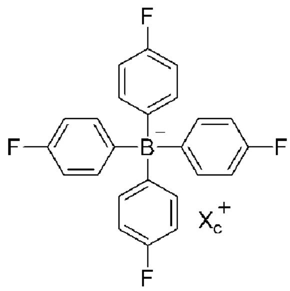
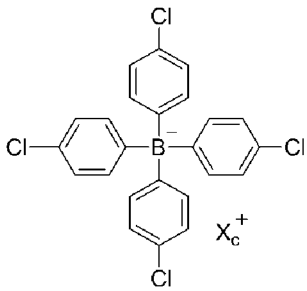

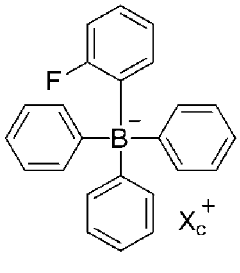
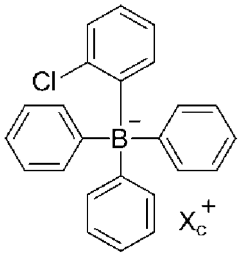
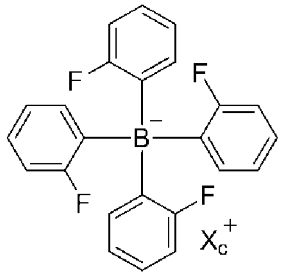

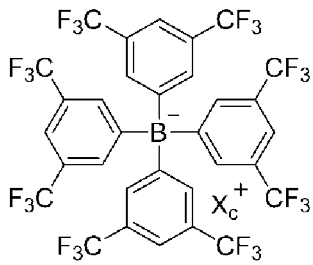

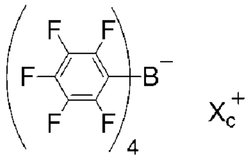
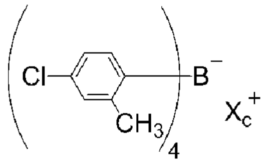
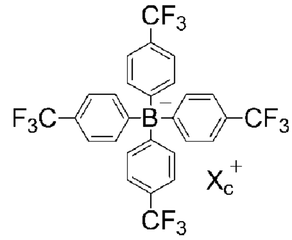
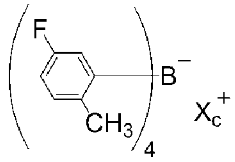
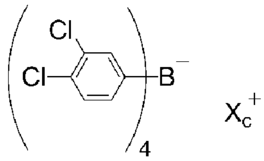
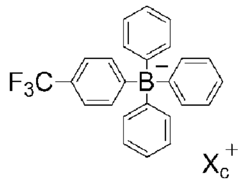
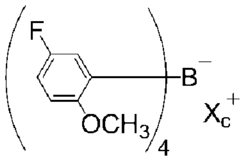
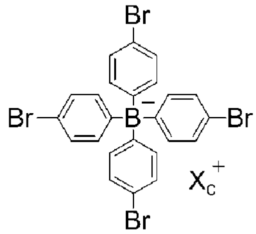
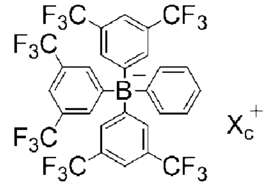
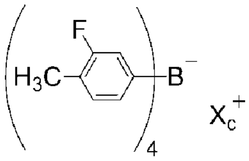
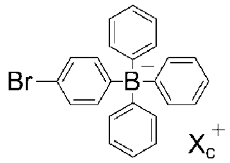
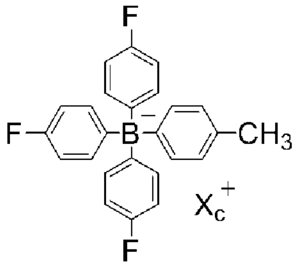
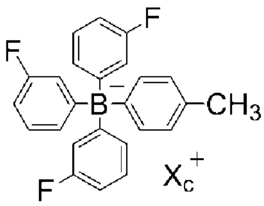
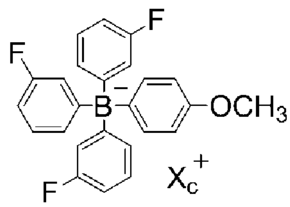
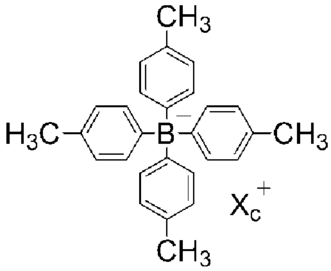
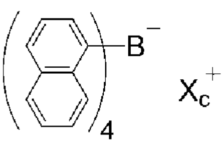
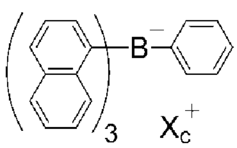

Only one radical production aid may be added thereto or two or more radical production aids may be jointly used.

The content of the radical production aid is preferably 0.01% to 30% by mass, more preferably 0.05% to 25% by mass, and still more preferably 0.1% to 20% by mass of the total solid content of the curable composition.

(Polymer Particle)

From the viewpoint of the on-machine developability of the lithographic printing plate precursor, the curable composition according to the embodiment of the present disclosure may contain a polymer particle. The polymer particle is preferably a polymer particle capable of converting the image-recording layer to be hydrophobic in the case of being irradiated with heat, preferably, heat generated by exposure.

The polymer particle is preferably at least one selected from a thermally adhesive particle, a thermally reactive polymer particle, a polymer particle having a polymerizable group, a microcapsule including a hydrophobic compound,

and a micro gel (crosslinking polymer particle). Among these, a polymer particle having a polymerizable group and a micro gel are preferred.

Preferred examples of the thermally adhesive particle include a thermoplastic polymer particle described in Research Disclosure No. 33303 of January 1992 and the specifications of JP1997-123387A (JP-H09-123387A), JP1997-131850A (JP-H09-131850A), JP1997-171249A (JP-H09-171249A), JP1997-171250A(JP-H09-171250A), and EP931647B.

Specific examples of polymers that constitute the thermally adhesive particle include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures thereof. Preferred examples thereof include copolymers having polystyrene, styrene, and acrylonitrile and methyl polymethacrylate. The number-average primary particle diameter of the thermally adhesive particles is preferably in a range of 0.01 μm to 2.0 μm.

Examples of the thermally reactive polymer particle include a polymer particle having a thermally reactive group. The polymer particle having a thermally reactive group forms a hydrophobilized region through crosslinking by a thermal reaction and a change in a functional group at this time.

The thermally reactive group in the polymer particle having a thermally reactive group may be a functional group that causes any reactions as long as chemical bonds are formed, but is preferably a polymerizable group. Preferred examples thereof include ethylenically unsaturated groups that cause radical polymerization reactions (for example, acryloyl groups, methacryloyl groups, vinyl groups, allyl groups, and the like), cationic polymerizable groups (for example, vinyl groups, vinyloxy groups, epoxy groups, oxetanyl groups, and the like), isocyanato groups that cause addition reactions or blocked bodies thereof, epoxy groups, vinyloxy groups, functional groups having active hydrogen atoms that are reaction partners thereof (for example, amino groups, hydroxy groups, carboxy groups, and the like), carboxy groups that cause condensation reactions, hydroxy groups or amino groups that are reaction partners, acid anhydrides that cause ring-opening addition reactions, amino groups or hydroxy groups which are reaction partners, and the like.

Examples of the microcapsules include microcapsules including all or part of the constituent components of the image-recording layer as described in JP2001-277740A and JP2001-277742A. The constituent components of the image-recording layer can also be added outside the microcapsules. A preferred aspect of the image-recording layer including the microcapsules is an image-recording layer including hydrophobic constituent components in the microcapsules and including hydrophilic constituent components outside the microcapsules.

Micro gels (crosslinking polymer particles) are capable of containing some of the constituent components of the curable composition in at least one of the inside or surface thereof, and particularly, an aspect of micro capsules that have radical polymerizable groups on the surfaces and thus turn into reactive micro gels is preferred from the viewpoint of image-forming sensitivity or printing resistance.

In order to put the constituent components of the curable composition into microcapsules or micro gels, well-known methods can be used.

The volume average particle diameter of the microcapsules or the micro gels is preferably in a range of 0.01 to 3.0 μm, more preferably in a range of 0.05 to 2.0 μm, and particularly preferably in a range of 0.10 to 1.0 μm. Within this range, favorable resolution and temporal stability can be obtained.

The volume average particle diameter is measured using a dynamic light scattering-type particle size distribution analyzer LB-500 (manufactured by Horiba Ltd.) and a light scattering method.

The content of the polymer particle is preferably 5% to 90% by mass of the total solid content of the curable composition.

<Chain Transfer Agent>

The curable composition according to the embodiment of the present disclosure may also contain a chain transfer agent. The chain transfer agent contributes to the improvement of the printing resistance of a lithographic printing plate in a case in which the curable composition is used for the image-recording layer in the lithographic printing plate precursor.

The chain transfer agent is preferably a thiol compound, from the viewpoint of the boiling point (the difficulty of volatilization), more preferably thiol having 7 or more carbon atoms, and still more preferably a compound having a mercapto group on an aromatic ring (an aromatic thiol compound). The above-described thiol compound is preferably a monofunctional thiol compound.

Specific examples of the chain transfer agent include the following compounds.

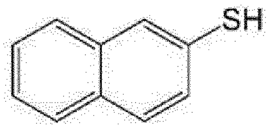

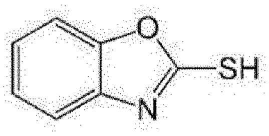 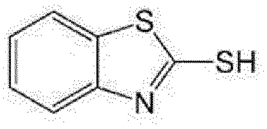 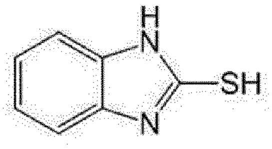

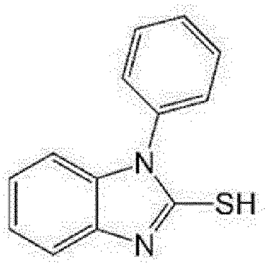 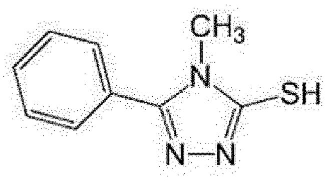 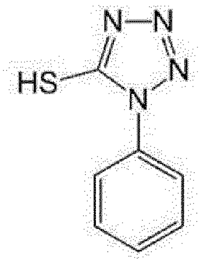

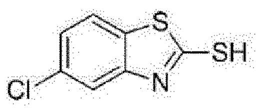 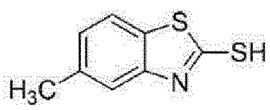 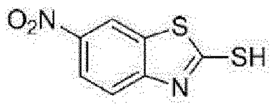 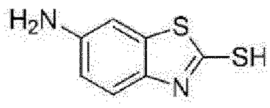

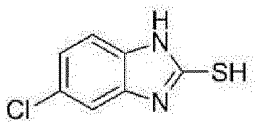 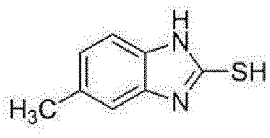 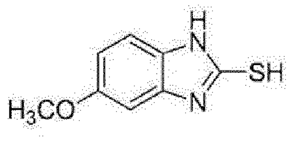 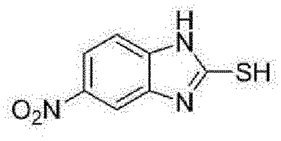

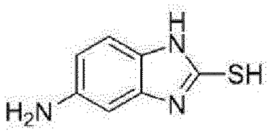 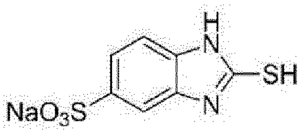 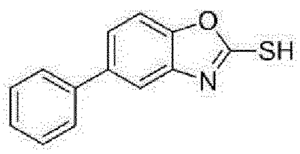

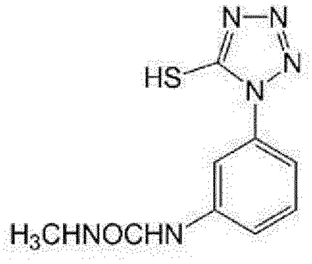 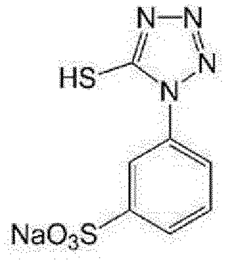

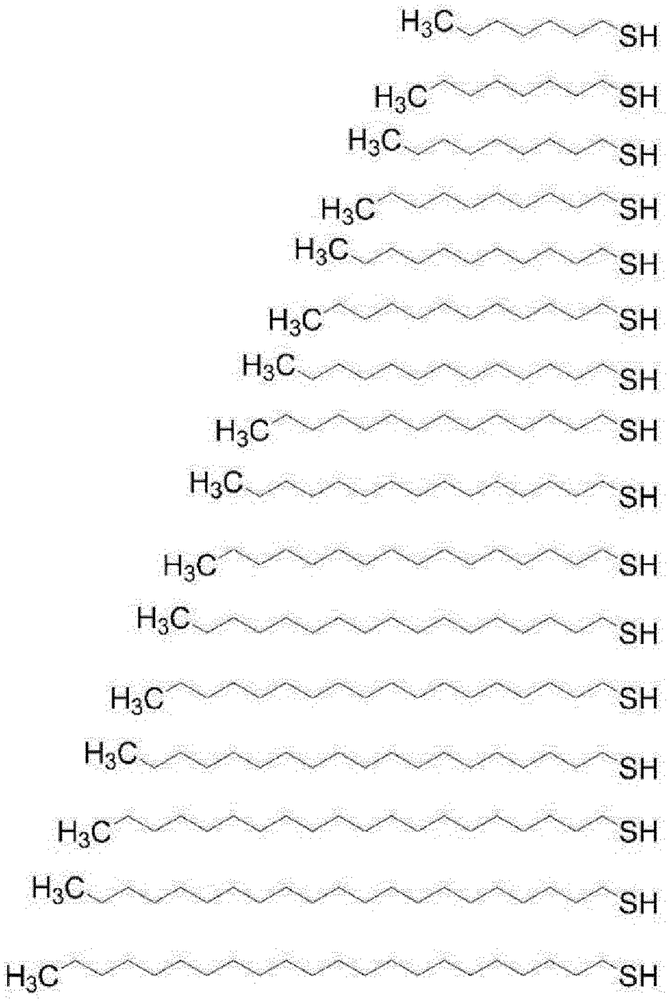
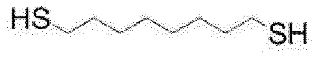
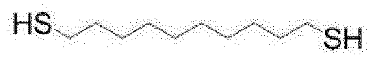
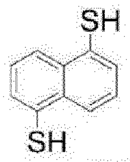
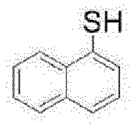
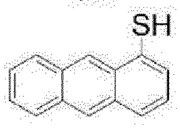
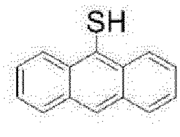
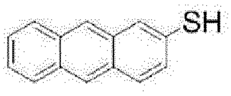
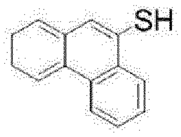
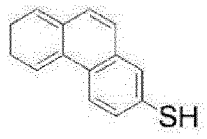
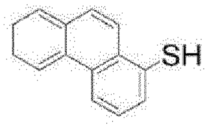
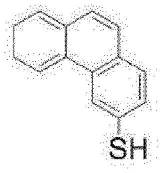
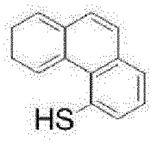

Only one chain transfer agent may be added thereto or two or more chain transfer agents may be jointly used.

The content of the chain transfer agent is preferably 0.01% to 50% by mass, more preferably 0.05% to 40% by mass, and still more preferably 0.1% to 30% by mass of the total solid content of the curable composition.

<Additional Infrared Absorber>

The curable composition according to the embodiment of the present disclosure may also contain an additional infrared absorber other than the specific infrared absorber. In the case of containing an additional infrared absorber, the curable composition according to the embodiment of the present disclosure can be preferably used as an infrared-sensitive curable composition.

In addition, even in the case of being used as a thermosensitive curable composition, the curable composition according to the embodiment of the present disclosure may contain an additional infrared absorber.

The additional infrared absorber is a compound having a function of converting an absorbed infrared ray to heat. In addition, the infrared absorber may have a function of migrating electrons and/or energy to the polymerization initiator described below or the like by being excited by an infrared ray.

The additional infrared absorber preferably has the maximum absorption in a wavelength range of 750 to 1,400 nm. As the additional infrared absorber, a dye or a pigment is preferably used.

As the dye, it is possible to use a commercially available dye and a well-known dye described in publications, for example, "Dye Handbooks" (edited by the Society of Synthetic Organic Chemistry, Japan and published on 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt, and a metal thiolate complex.

Among these dyes, a cyanine colorant, a squarylium colorant, and a pyrylium salt are preferably exemplified. Among these, a cyanine colorant is preferred, and an indolenine cyanine colorant is particularly preferred.

Specific examples of the cyanine colorant include a compound described in Paragraphs 0017 to 0019 of

JP2001-133969A, a compound described in Paragraphs 0016 to 0021 of JP2002-023360A and Paragraphs 0012 to 0037 of JP2002-040638A, preferably, a compound described in Paragraphs 0034 to 0041 of JP2002-278057A and Paragraphs 0080 to 0086 of JP2008-195018A, and, particularly preferably, a compound described in Paragraphs 0035 to 0043 of JP2007-090850A.

In addition, it is also possible to preferably use a compound described in Paragraphs 0008 and 0009 of JP1993-005005A (JP-H05-005005A) and Paragraphs 0022 to 0025 of JP2001-222101A.

As the pigment, a compound described in Paragraphs 0072 to 0076 of JP2008-195018A is preferred.

The additional infrared absorber may be used singly or two or more additional infrared absorbers may be jointly used. In addition, as the additional infrared absorber, a dye and a pigment may be jointly used.

The additional infrared absorber can be added to the curable composition in any amount. The content of the additional infrared absorber is preferably 0.05% to 30% by mass, more preferably 0.1% to 20% by mass, and still more preferably 0.2% to 10% by mass with respect to 100 parts by mass of the total solid content of the curable composition.

[Low-Molecular-Weight Hydrophilic Compound]

In order to improve on-machine developability without degrading printing resistance, the curable composition according to the embodiment of the present disclosure may include a low-molecular-weight hydrophilic compound. Meanwhile, the low-molecular-weight hydrophilic compound is preferably a compound having a molecular weight of smaller than 1,000, more preferably a compound having a molecular weight of smaller than 800, and still more preferably a compound having a molecular weight of smaller than 500.

As the low-molecular-weight hydrophilic compound, examples of water-soluble organic compounds include glycols such as ethylene glycol, diethylene glycol, triethylene glycol, propylene glycol, dipropylene glycol, and tripropylene glycol and ethers or ester derivative thereof, polyols such as glycerin, pentaerythritol, and tris(2-hydroxyethyl) isocyanurate, organic amines such as triethanolamine, diethanolamine, and monoethanolamine and salts thereof, organic sulfonic acids such as alkyl sulfonic acid, toluenesulfonic acid, and benzenesulfonic acid and salts thereof, organic sulfamic acids such as alkyl sulfamate and salts thereof, organic sulfuric acids such as alkyl sulfates and alkyl ether sulfates and salts thereof, organic phosphonic acids such as phenylphosphonic acid and salts thereof, organic carboxylic acids such as tartaric acid, oxalic acid, citric acid, malic acid, lactic acid, gluconic acid, and amino acid and salts thereof, betaines, and the like.

As the low-molecular-weight hydrophilic compound, it is preferable to add at least one selected from the group consisting of polyols, organic sulfates, organics sulfonates, and betaines.

Specific examples of the organic sulfonates include alkyl sulfonates such as sodium n-butyl sulfonate, sodium n-hexyl sulfonate, sodium 2-ethylhexyl sulfonate, sodium cyclohexyl sulfonate, and sodium n-octyl sulfonate; alkyl sulfonates having ethylene oxide chains such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, sodium 5,8,11,14-tetraoxatetracosane-1-sulfonate; aryl sulfonates such as sodium benzene sulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthylsulfonate, sodium 1,5-naphthalene disulfonate, and trisodium 1,3,6-naphthalene trisulfonate; compounds described in Paragraphs 0026 to 0031 of JP2007-276454A and Paragraphs 0020 to 0047 of JP2009-154525A; and the like. The salts may be potassium salts or lithium salts.

Examples of the organic sulfates include sulfates of alkyls, alkenyls, alkynyls, aryls, or heterocyclic monoethers such as polyethylene oxides. The number of ethylene oxide units is preferably in a range of 1 to 4, and the salts are preferably sodium salts, potassium salts, or lithium salts. Specific examples thereof include compounds described in Paragraphs 0034 to 0038 of JP2007-276454A.

The betaines are preferably compounds in which the number of carbon atoms in hydrocarbon substituents into nitrogen atoms is in a range of 1 to 5, and specific examples thereof include trimethyl ammonium acetate, dimethyl propyl ammonium acetate, 3-hydroxy-4-trimethyl ammonio butyrate, 4-(1-pyridinio) butyrate, 1-hydroxyethyl-1-imidazolio acetate, trimethyl ammonium methanesulfonate, dimethyl propyl ammonium methanesulfonate, 3-trimethylammonio-1-propane sulfonate, 3-(1-pyridinio)-1-propane sulfonate, and the like.

Since the low-molecular-weight hydrophilic compound has a small structure in hydrophobic portions and barely has surfactant actions, there are no cases in which dampening water permeates exposed portions (image areas) in the image-recording layer and thus the hydrophobic properties or membrane hardness of the image areas degrade, and it is possible to favorably maintain the ink-receiving properties or printing resistance of the image-recording layer.

The content of the low-molecular-weight hydrophilic compound is preferably in a range of 0.5% to 20% by mass, more preferably in a range of 1% to 15% by mass, and still more preferably in a range of 2% to 10% by mass of the total solid content of the curable composition. Within this range, favorable on-machine developability and printing resistance can be obtained.

The low-molecular-weight hydrophilic compound may be used singly or two or more low-molecular-weight

hydrophilic compound may be used in a mixed form.

(Sensitization Agent)

In order to improve the ink-absorbing property of ink (hereinafter, also simply referred to as the "ink-absorbing property"), the curable composition according to the embodiment of the present disclosure may contain a sensitization agent such as a phosphonium compound, a nitrogen-containing low-molecular-weight compound, or an ammonium group-containing polymer. Particularly, in a case in which an inorganic lamellar compound is added to the protective layer, these compounds function as surface coating agents for the inorganic lamellar compound and are capable of suppressing the ink-absorbing properties from being degraded in the middle of printing due to the inorganic lamellar compound.

Among these, a phosphonium compound, a nitrogen-containing low-molecular-weight compound, and an ammonium group-containing polymer are preferably jointly used as the sensitization agent, and a phosphonium compound, quaternary ammonium salts, and an ammonium group-containing polymer are more preferably jointly used.

Examples of a phosphonium compound include phosphonium compounds described in JP2006-297907A and JP2007-050660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof include imidazolinium salts, benzo imidazolinium salts, pyridinium salts, and quinolinium salts. Among these, quaternary ammonium salts and pyridinium salts are preferred. Specific examples thereof include tetramethylammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, compounds described in Paragraphs 0021 to 0037 of JP2008-284858A and Paragraphs 0030 to 0057 of JP2009-090645A, and the like.

The ammonium group-containing polymer needs to have an ammonium group in the structure, and polymers including 5% by mol to 80% by mol of (meth)acrylate having ammonium groups in side chains as copolymerization components are preferred. Specific examples thereof include polymers described in Paragraphs 0089 to 0105 of JP2009-208458A.

In the ammonium group-containing polymer, the value of the reducing specific viscosity (unit: ml/g) obtained according to the measurement method described in JP2009-208458A is preferably in a range of 5 to 120, more preferably in a range of 10 to 110, and particularly preferably in a range of 15 to 100. In a case in which the reducing specific viscosity is converted to the weight-average molecular weight (Mw), the mass average molar mass is preferably in a range of 10,000 to 150,000, more preferably in a range of 17,000 to 140,000, and particularly preferably in a range of 20,000 to 130,000.

Hereinafter, specific examples of the ammonium group-containing polymer will be described.

(1) 2-(Trimethylammonio)ethyl methacrylate=p-toluenesulfonate/3,6-dioxaheptyl methacrylate copolymer (molar ratio: 10/90, Mw: 45,000)
(2) 2-(Trimethylammonio)ethyl methacrylate=hexafluorophosphate/3,6-dioxaheptyl methacrylate copolymer (molar ratio: 20/80, Mw: 60,000)
(3) 2-(Ethyldimethylammonio)ethyl methacrylate=p-toluenesulfonate/hexyl methacrylate copolymer (molar ratio: 30/70, Mw: 45,000)
(4) 2-(Trimethylammonio)ethyl methacrylate=hexafluorophosphate/2-ethylhexyl methacrylate copolymer (molar ratio: 20/80, Mw: 60,000)
(5) 2-(Trimethylammonio)ethyl methacrylate=methylsulfate/hexyl methacrylate copolymer (molar ratio: 40/60, Mw: 70,000)
(6) 2-(Butyldimethylammonio)ethyl methacrylate=hexafluorophosphate/3,6-dioxaheptyl methacrylate copolymer (molar ratio: 25/75, Mw: 65,000)
(7) 2-(Butyldimethylammonio)ethyl acrylate=haxafluorophosphate/3,6-dioxaheptyl methacrylate copolymer (molar ratio: 20/80, Mw: 65,000)
(8) 2-(Butyldimethylammonio)ethyl methacrylate=13-ethyl-5,8,11-trioxa-1-heptadecanesulfonate/3,6-dioxaheptyl methacrylate copolymer (molar ratio: 20/80, Mw: 75,000) (9) 2-(Butyldimethylammonio)ethyl methacrylate=haxafluorophosphate/3,6-dioxaheptyl methacrylate/2-hydroxy-3-methacryloyloxypropyl methacrylate copolymer (molar ratio: 15/80/5, Mw: 65,000)

The content of the sensitization agent is preferably in a range of 0.01% to 30.0% by mass, more preferably in a range of 0.1% to 15.0% by mass, and still more preferably in a range of 1% to 10% by mass of the total solid content

in the curable composition.

[Solvent]

The curable composition according to the embodiment of the present disclosure may contain a solvent.
In addition, a curable composition film can be formed by dissolving or dispersing the respective components that are added to the curable composition in an appropriate solvent to prepare a coating fluid and applying and drying the coating fluid on a support or the like.
As the solvent, a well-known solvent can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. The solvent can be used singly or two or more solvents can be used in a mixture. The concentration of the solid content in the coating fluid is preferably approximately 1% to 50% by mass.

[Other Components]

Furthermore, the curable composition according to the embodiment of the present disclosure is capable of containing, as other components, a surfactant, a polymerization inhibitor, a higher fatty acid derivative, a plasticizer, an inorganic particle, an inorganic lamellar compound, and the like. Specifically, the curable composition according to the embodiment of the present disclosure is capable of containing individual components described in the description in Paragraphs 0114 to 0159 of JP2008-284817A.

(Second Embodiment)

The second embodiment of the curable composition includes a specific infrared absorber and a thermally adhesive particle. The specific infrared absorber and the thermally adhesive particle are identical to the specific infrared absorber and the thermally adhesive particle in the first embodiment, and preferred aspects thereof are identical thereto.
The content of the specific infrared absorber in the second embodiment is preferably 0.2% by mass to 10% by mass and more preferably 0.05% by mass to 30% by mass of the solid content of the curable composition.
The content of the thermally adhesive particle in the second embodiment is preferably 10% by mass to 60% by mass and more preferably 20% by mass to 50% by mass of the solid content of the curable composition.
The curable composition according to the second embodiment may contain the polymer particle other than the thermally adhesive particle, the binder polymer, the radical production aid, the chain transfer agent, the infrared absorber, the low-molecular-weight hydrophilic compound, the sensitization agent, the solvent, and the other components in the first embodiment.

<Formation of Image-Recording Layer>

The image-recording layer in the lithographic printing plate precursor according to the embodiment of the present disclosure is formed by, for example, as described in Paragraphs 0142 and 0143 of JP2008-195018A, dispersing or dissolving the necessary components described above in a well-known solvent so as to prepare a coating fluid, applying the coating fluid onto a support using a well-known method such as bar coating, and drying the coating fluid. The coating amount (solid content) of the image-recording layer after application and drying varies depending on applications; however is preferably in a range of 0.3 to 3.0 $g/m^2$. Within this range, a favorable sensitivity and favorable membrane characteristics of the image-recording layer can be obtained.

(Lithographic Printing Plate Precursor)

A lithographic printing plate precursor according to the embodiment of the present disclosure has an image-recording layer containing the curable composition according to the embodiment of the present disclosure on a support.
Hereinafter, an on-machine development-type lithographic printing plate precursor in which the characteristics of the curable composition according to the embodiment of the present disclosure are significantly developed will be

described as an example.

<Image-Recording Layer>

For the image-recording layer in the lithographic printing plate precursor, development aptitude and printing aptitude are required. Therefore, the curable composition that is used for the image-recording layer preferably contains the specific infrared absorber and the binder polymer. In the case of an on-machine development-type lithographic printing plate precursor, as the binder polymer, a binder polymer for on-machine development is preferably used.

The curable composition that is used for the image-recording layer is preferably the curable composition of the first embodiment or the second embodiment.

In a case in which the curable composition of the first embodiment is used as the curable composition that is used for the image-recording layer, it is preferable that the curable composition contains the specific infrared absorber, the polymerizable compound, the polymerization initiator, and the binder polymer, and it is more preferable that the curable composition contains the specific infrared absorber, the polymerizable compound, the polymerization initiator, the binder polymer, a radical production aid, and the chain transfer agent.

In a case in which the curable composition of the second aspect is used as the curable composition that is used for the image-recording layer, the curable composition preferably contains the specific infrared absorber, a thermally adhesive particle, and the binder polymer.

That is, the image-recording layer in the lithographic printing plate precursor according to the embodiment of the present disclosure contains the respective components that the curable composition contains.

Regarding the respective constituent components such as the specific infrared absorber, the binder polymer, the polymerizable compound, the polymerization initiator, the radical production aid, and the chain transfer agent which are included in the image-recording layer and the contents thereof, it is possible to refer to the description in the section of the curable composition according to the embodiment of the present disclosure.

[Formation of Image-Recording Layer]

The image-recording layer in the lithographic printing plate precursor according to the embodiment of the present disclosure is formed by, for example, as described in Paragraphs 0142 and 0143 of JP2008-195018A, dispersing or dissolving the curable composition in a well-known solvent to prepare a coating fluid, applying the coating fluid onto a support using a well-known method such as bar coating, and drying the coating fluid. The coating amount (solid content) of the image-recording layer after application and drying varies depending on applications; however, generally, is preferably in a range of 0.3 to 3.0 $g/m^2$. Within this range, a favorable sensitivity and favorable membrane characteristics of the image-recording layer can be obtained.

<Undercoat Layer>

The lithographic printing plate precursor according to the embodiment of the present disclosure preferably has an undercoat layer (in some cases, referred to as the interlayer) between the image-recording layer and the support. The undercoat layer strengthens adhesiveness between the support and the image-recording layer in exposed portions and facilitates peeling the support and the image-recording layer in non-exposed portions, and thus the undercoat layer contributes to improving developability without impairing printing resistance. In addition, in the case of exposure using infrared lasers, the undercoat layer functions as an adiabatic layer and thus has an effect of preventing the sensitivity from being degraded due to the diffusion of heat generated by exposure in the support.

Examples of compounds that can be used for the undercoat layer include polymers having adsorbent groups that can be adsorbed to the surface of the support and hydrophilic groups. In order to improve adhesiveness to the image-recording layer, polymers having adsorbent groups and hydrophilic groups and further having crosslinking groups are preferred. The compounds that can be used for the undercoat layer may be low-molecular-weight compounds or polymers. The compounds that can be used for the undercoat layer may be used in a mixed form of two or more kinds as necessary.

In a case in which the compounds that are used for the undercoat layer are polymers, copolymers of monomers having adsorbent groups, monomers having hydrophilic groups, and monomers having crosslinking groups are preferred.

The adsorbent groups that can be adsorbed to the surface of the support are preferably phenolic hydroxy groups, carboxy groups, $-PO_3H_2$, $-OPO_3H_2$, $-CONHSO_2-$, $-SO_2NHSO_2-$, $-COCH_2COCH_3$. The hydrophilic groups are preferably sulfo groups or salts thereof and salts of carboxy groups. The crosslinking groups are preferably acrylic groups, methacryl groups, acrylamide groups, methacrylamide groups, allyl groups, and the like.

The polymers may have crosslinking groups introduced due to the formation of salts between polar substituents of the polymers and compounds having substituents having opposite charges of the above-described polar substituents

and ethylenically unsaturated bonds and may be further copolymerized with monomers other than the above-described monomers, preferably, hydrophilic monomers.

Specifically, preferred examples thereof include silane coupling agents having ethylenic double bond reactive groups that are capable of addition polymerization described in JP1998-282679A (JP-H10-282679A) and phosphorus compounds having ethylenic double bond reactive groups described in JP1990-304441A (JP-H02-304441A). Low-molecular-weight or high-molecular-weight compounds having crosslinking groups (preferably ethylenically unsaturated bond groups), functional groups that interact with the surface of the support, and hydrophilic groups described in JP2005-238816A, JP2005-125749A, JP2006-239867A, and JP2006-215263A are also preferably used.

More preferred examples thereof include high-molecular-weight polymers having adsorbent groups that can be adsorbed to the surface of the support, hydrophilic groups, and crosslinking groups described in JP2005-125749A and JP2006-188038A.

The content of ethylenically unsaturated bonds in the polymer that is used in the undercoat layer is preferably in a range of 0.1 to 10.0 mmol and more preferably in a range of 0.2 to 5.5 mmol per gram of the polymer.

The weight-average molecular weight (Mw) of the polymer that is used in the undercoat layer is preferably 5,000 or higher and more preferably in a range of 10,000 to 300,000.

In addition to the above-described compounds for the undercoat layer, the undercoat layer may also include a chelating agent, secondary or tertiary amines, a polymerization inhibitor, compounds having amino groups or functional groups having a polymerization-inhibiting function and groups that interact with the surfaces of supports (for example, 1,4-diazabicyclo[2.2.2]octane (DABCO), 2,3,5,6-tetrahydroxy-p-quinone, chloranil, sulfophthalic acid, hydroxyethyl ethylene diamine triacetic acid, dihydroxyethyl ethylenediamine diacetic acid, hydroxyethyl iminodiacetic acid, and the like), and the like in order to prevent contamination over time.

The undercoat layer is formed using well-known coating methods. The coating amount (solid content) of the undercoat layer is preferably in a range of 0.1 to 100 $mg/m^2$ and more preferably in a range of 1 to 30 $mg/m^2$.

<Protective Layer>

The lithographic printing plate precursor according to the embodiment of the present disclosure preferably has a protective layer (in some cases, also referred to as the overcoat layer) on the image-recording layer. The protective layer has a function of suppressing image formation-inhibiting reactions caused by the shielding of oxygen and additionally has a function of preventing the generation of damage in the image-recording layer and abrasion prevention during exposure using high-illuminance lasers.

In addition, the protective layer in the lithographic printing plate precursor according to the embodiment of the present disclosure may also include the curable composition according to the embodiment of the present disclosure, that is, the compound represented by Formula 1.

Protective layers having the above-described characteristics are described in, for example, the specification of US3458311A and JP1980-049729B (JP-S55-049729B). As poor oxygen-transmissible polymers that can be used for the protective layer, it is possible to appropriately select and use any one of water-soluble polymers and water-insoluble polymers, and, if necessary, it is also possible to use two or more polymers in a mixed form. Specific examples thereof include polyvinyl alcohols, modified polyvinyl alcohols, polyvinyl pyrrolidone, water-soluble cellulose derivatives, poly(meth)acrylonitrile, and the like.

As the modified polyvinyl alcohols, acid-modified polyvinyl alcohols having carboxy groups or sulfo groups are preferably used. Specific examples thereof include modified-polyvinyl alcohols described in JP2005-250216A and JP2006-259137A.

The protective layer preferably includes inorganic lamellar compounds in order to enhance oxygen-shielding properties. The inorganic lamellar compounds refer to particles having thin flat plate shapes, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.

The inorganic lamellar compounds that can be preferably used are mica compounds. Examples of mica compounds include mica groups such as natural mica and synthetic mica represented by Formula: $A(B, C)_{2-5}D_4O_{10}(OH, F, O)_2$ [here, A is at least one element selected from the group consisting of K, Na, and Ca, B and C are at least one element selected from the group consisting of Fe (II), Fe (III), Mn, Al, Mg, and V, and D is Si or Al.].

In the mica groups, examples of natural mica include white mica, soda mica, gold mica, black mica, and lepidolite. Examples of synthetic mica include non-swelling mica such as fluorphlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite $(Na, Li)Mg_2Li(Si_4O_{10})F_2$, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the above-described mica compounds, fluorine-based swelling mica is particularly useful. That is, swelling synthetic mica has a laminate structure consisting of unit crystal lattice layers having a thickness in a range of

approximately 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case in which the positive ions between the layers are $Li^+$ and $Na^+$, the ionic radii are small, and thus the bonds between lamellar crystal lattices are weak, and mica is significantly swollen by water. In a case in which shear is applied in this state, mica easily cleavages and forms a stable sol in water. The above-described tendency of swelling synthetic mica is strong, and the swelling synthetic mica is particularly preferably used.

From the viewpoint of diffusion control, regarding the shapes of the mica compounds, the thickness is preferably thin, and the planar size is preferably large as long as the smoothness and active light ray-transmitting properties of coated surfaces are not impaired. Therefore, the aspect ratio is preferably 20 or higher, more preferably 100 or higher, and particularly preferably 200 or higher. The aspect ratio is the ratio of the long diameter to the thickness of a particle and can be measured from projection views obtained from the microphotograph of the particle. As the aspect ratio increases, the obtained effect becomes stronger.

Regarding the particle diameters of the mica compound, the average long diameter thereof is preferably in a range of 0.3 to 20 μm, more preferably in a range of 0.5 to 10 μm, and particularly preferably in a range of 1 to 5 μm. The average thickness of the particles is preferably 0.1 μm or smaller, more preferably 0.05 μm or smaller, and particularly preferably 0.01 μm or smaller. Specifically, for example, in the case of swelling synthetic mica which is a typical compound, a preferred aspect has a thickness in a range of approximately 1 to 50 nm and a surface size (long diameter) in a range of approximately 1 to 20 μm.

The content of the inorganic lamellar compound is preferably in a range of 0% to 60% by mass and more preferably in a range of 3% to 50% by mass of the total solid content of the protective layer. Even in a case in which multiple kinds of inorganic lamellar compounds are jointly used, the total amount of the inorganic lamellar compounds is preferably the above-described content. Within the above-described range, the oxygen-shielding properties improve, and a favorable sensitivity can be obtained. In addition, the degradation of the ink-absorbing properties can be prevented.

The protective layer may include well-known additives such as a plasticizer for imparting flexibility, a surfactant for improving coating properties, and inorganic particles for controlling sliding properties on the surface. In addition, the sensitization agent described in the section of the image-recording layer may be added to the protective layer.

The protective layer is formed using a well-known coating method. The coating amount of the protective layer (solid content) is preferably in a range of 0.01 to 10 $g/m^2$, more preferably in a range of 0.02 to 3 $g/m^2$, and particularly preferably in a range of 0.02 to 1 $g/m^2$.

<Support>

A support in the lithographic printing plate precursor according to the embodiment of the present disclosure can be appropriately selected from well-known supports for a lithographic printing plate precursor and used. The support is preferably an aluminum plate which has been roughened using a well-known method and anode-oxidized.

On the aluminum plate, as necessary, enlargement processes or sealing processes of micropores in anode oxide films described in JP2001-253181A and JP2001-322365A, surface hydrophilization processes using alkali metal silicate as described in the specifications of US2,714,066A, US3,181,461A, US3,280,734A, and US3,902,734A, and surface hydrophilization processes using polyvinyl phosphate or the like as described in the specifications of US3,276,868A, US4,153,461A, and US4,689,272A may be appropriately selected and carried out.

In the support, the center line average roughness is preferably in a range of 0.10 to 1.2 μm.

The support may have, as necessary, a backcoat layer including an organic polymer compound described in JP1993-045885A (JP-H05-045885A) or an alkoxy compound of silicon described in JP1994-035174A (JP-H06-035174A) on the surface opposite to the image-recording layer.

(Method for Producing Lithographic Printing Plate)

A method for producing a lithographic printing plate according to the embodiment of the present disclosure preferably includes: a step of subjecting the lithographic printing plate precursor according to the embodiment of the present disclosure to image-wise exposure (exposure step); and a step of removing a non-exposed portion in the image-recording layer of the lithographic printing plate precursor that has been subjected to image-wise exposure, using at least one selected from the group consisting of printing ink and dampening water on a printer (on-machine development step).

<Exposure step>

Image-wise exposure is preferably carried out using a method in which digital data are scanned and exposed using an infrared laser or the like.

The wavelength of the exposure light source is preferably in a range of 750 nm to 1,400 nm. The light source having a wavelength in a range of 750 nm to 1,400 nm is preferably a solid-state laser or a semiconductor laser that radiates infrared rays. The exposure mechanism may be any one of in-plane drum methods, external surface drum methods, flat head methods, and the like.

The exposure step can be carried out using platesetters or the like and well-known methods. In addition, exposure may be carried out on a printer using a printer comprising an exposure device after the lithographic printing plate precursor is mounted on the printer.

<On-Machine Development Step>

In the on-machine development step, in a case in which printing (on-machine development) is initiated by supplying at least one selected from the group consisting of printing ink and dampening water, preferably, printing ink and dampening water on the printer without carrying out any development processes on the lithographic printing plate precursor that has been subjected to image-wise exposure, non-exposed portions on the lithographic printing plate precursor are removed at the initial stage of printing, and accordingly, the hydrophilic surface of the support is exposed, and non-image areas are formed. As the printing ink and the dampening water, well-known printing ink and dampening water for lithographic printing are used. Any of printing ink and dampening water may be first supplied to the surface of the lithographic printing plate precursor, but it is preferable to first supply printing ink from the viewpoint of preventing contamination by the components of the image-recording layer from which dampening water is removed.

In the above-described manner, the lithographic printing plate precursor is on-machine-developed on an off-set printer and is used as it is for printing a number of pieces of paper.

The method for producing a lithographic printing plate according to the embodiment of the present disclosure may also include other well-known steps in addition to the above-described steps. Examples of other steps include a plate-inspecting step of checking a position, a direction, or the like of a lithographic printing plate precursor before each step, or a checking step of checking a printed image after an on-machine development step.

The lithographic printing plate precursor according to the embodiment of the present disclosure can be used to produce lithographic printing plates by means of a development process in which a developer is used by appropriately selecting the binder polymer and the like which are the constituent components of the image-recording layer. Examples of the development process in which a developer is used include an aspect in which a developer having a high pH of 14 or less which includes an alkaline agent is used (also referred to as alkali development) and an aspect in which a developer having a pH of approximately 2 to 11 which contains at least one compound selected from the group consisting of a surfactant and a water-soluble polymer compound is used (also referred to as simple development). The alkali development and the simple development can be carried out using a well-known method.

[Examples]

Hereinafter, the present disclosure will be described in detail using examples, but the present disclosure is not limited thereto. Meanwhile, for polymer compounds, unless particularly otherwise described, the molecular weight refers to the weight-average molecular weight (Mw) converted to a polystyrene equivalent value by the gel permeation chromatography (GPC) method, and the ratio of a repeating unit refers to the molar percentage. In addition, "parts" and "%" indicate "parts by mass" and "% by mass" unless particularly otherwise described. Since the weight-average molecular weight is a term that is used more commonly, the molecular weight is temporarily changed to the weight-average molecular weight; however, in a case in which it is necessary to prefer the use of mass average and unify terms to "mass-average molecular mass", such a request is available.

Synthesis examples of specific infrared absorbers according to the present disclosure will be described below. Other specific infrared absorbers can also be synthesized in the same manner by appropriately changing a raw material or a reaction intermediate.

(Synthesis Example 1: Synthesis of specific infrared absorber D-12)

A synthesis example of a compound D-12 according to the present invention will be illustrated below. Other compounds can also be synthesized in the same manner by appropriately changing the raw material or the reaction intermediate.

[Synthesis Example 1: Synthesis of Compound D-12]

(Synthesis of Intermediate 1) The synthesis scheme of an intermediate 1 will be illustrated below.

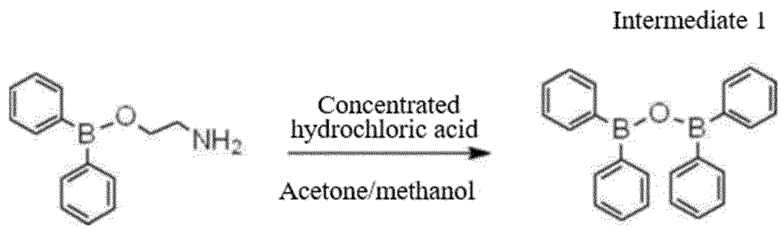


2-Aminoethyldiphenyl borate (manufactured by Tokyo Chemical Industry Co., Ltd.) (15.0 g), acetone (150 ml), and methanol (150 ml) were added to and mixed together in a three-neck flask, furthermore, concentrated hydrochloric acid (8 ml) was added thereto, and the components were stirred at room temperature for one hour. Next, the water bath temperature was set to 30 degrees, and a solvent made up of acetone and methanol was distilled away using an evaporator. Next, ethyl acetate (200 ml) and water (200 ml) were added to the residue and dissolved, then, an ethyl acetate layer was separated, magnesium sulfate was added thereto, and the components were left to stand for one night. After that, filtration was carried out, and a solvent of sufficiently dehydrated ethyl acetate was distilled away using an evaporator, thereby obtaining an intermediate 1 (8.2 g, yield: 76%).

(Synthesis of Intermediates 2 and 3) The synthesis schemes of intermediates 2 and 3 will be illustrated below.

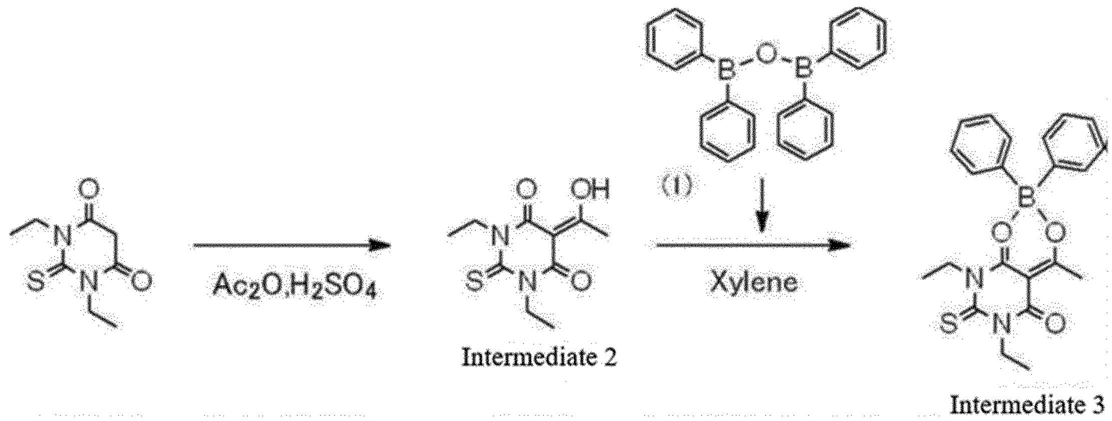


Diethyl thiobarbituric acid (manufactured by Tokyo Chemical Industry Co., Ltd.) (22 g) and acetic anhydride (60 ml) were added to and dissolved in a three-neck flask, concentrated sulfuric acid (1 g) was added thereto, and then the components were stirred at an oil bath temperature of 100°C for one hour.

Next, the acetic anhydride was distilled away, then, ethyl acetate (200 ml) and water (200 ml) were added to the residue and dissolved, then, an ethyl acetate layer was separated, magnesium sulfate was added thereto, and the components were left to stand for one night. After that, a solvent of sufficiently dehydrated ethyl acetate was distilled away using an evaporator, and the precipitated solid substance was made into a slurry using water (90 ml) and methanol (10 ml). The obtained crystal was filtered and dried, thereby obtaining an intermediate 2 (18 g, yield: 82%). Next, the intermediate 2 (2.4 g) and xylene (12 ml) were added to the three-neck flask and dissolved at room temperature. Next, the intermediate 2 (4.2 g) was added thereto, and the components were stirred at room temperature for 24 hours.

Xylene was distilled away from the obtained reaction liquid, and then the residue was separated by column chromatography (hexane/ethyl acetate=95/5), thereby obtaining an intermediate 3 (3.6 g, yield: 86%).

(Synthesis of Intermediate 5)

The synthesis schemes of intermediates 4 and 5 will be illustrated below.

Meanwhile, the intermediate 4 is one example of the specific infrared absorber of the present invention.

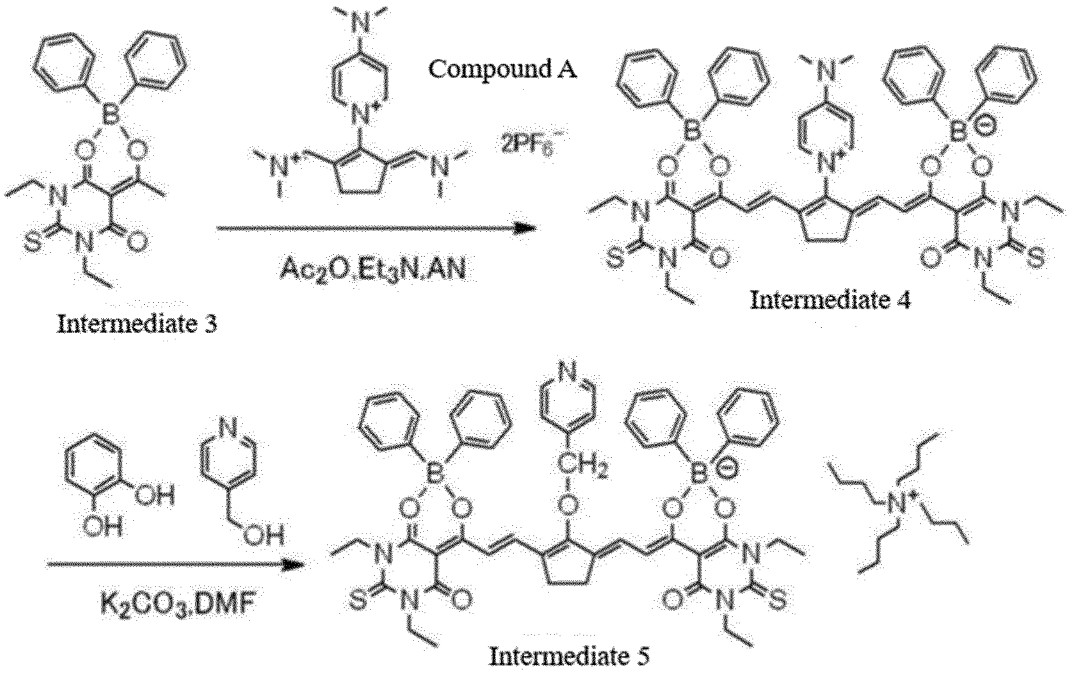


Intermediate 3
Intermediate 4
Intermediate 5

The intermediate 3 (1.74 g), a compound A (which can be prepared by referring to Journal of the American Chemical Society, 2006, vol. 128, #35 p, 11362 to 11363 and changing the counter salt to a PF6 salt) (1.04 g), and acetonitrile (AN) (30 ml) were added to and dissolved in a three-neck flask, furthermore, acetic anhydride (0.86 g) and triethylamine (0.86 g) were added thereto, and the components were stirred at room temperature for 10 minutes.

Next, methanol (30 ml) was added thereto, stirred for one minute, then, filtration and drying were carried out, thereby obtaining an intermediate 4 (1.2 g, yield: 69%). Next, the intermediate 4 (1.02 g), pyridine methanol (manufactured by Tokyo Chemical Industry Co., Ltd.) (0.52 g), and dehydrated dimethyl formamide (32 ml) were added thereto, dissolved, and then cooled to 0°C in an ice bath. Next, potassium carbonate (0.27 g) and catechol (55 mg) were added thereto, and the components were stirred at 0°C for 12 hours. The obtained reaction liquid was injected into water (100 ml), then, tetrabutylammonium bromide (0.8 g) was added thereto, and a target substance was precipitated. The precipitated target substance was filtered and, furthermore, made into a slurry using methanol (30 ml), and the slurry was filtered and dried, thereby obtaining an intermediate 5 (0.82 g, yield: 64%).

(Synthesis of D-12)

The synthesis scheme of a compound D-12 will be illustrated below.

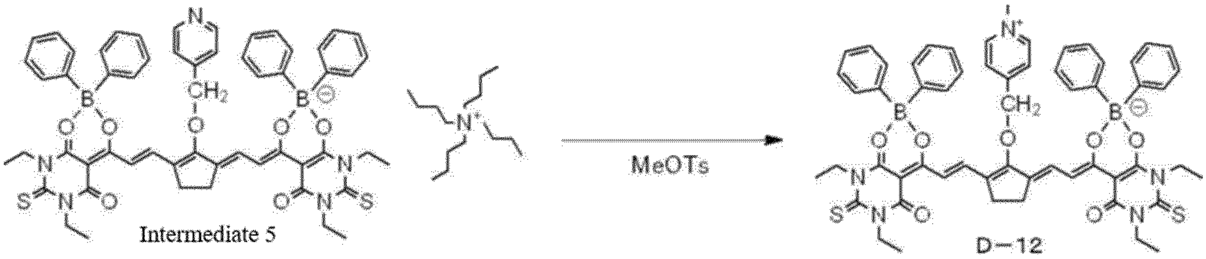


Intermediate 5
D-12

The intermediate 5 (62 mg) and methyl para-toluenesulfonate (2 g) were added to an eggplant-type flask and stirred at 25°C for 24 hours. The obtained reaction liquid was added to isopropanol (20 ml), and the obtained crystal was filtered. Furthermore, the obtained crystal was made into a slurry using methanol (3 ml), thereby obtaining a compound

D-12 (40 mg, yield: 72%). The structure of the obtained compound D-12 was identified by NMR. The identification result is described below.

$^1$H-NMR (400 MHz, deuterated dimethyl sulfoxide) $\delta$=1.16 (t, 6 H), 1.33 (t, 6 H), 2.75 (s, 4 H), 4.05 (s, 3 H), 4.39 (q, 4H), 4.39 (q, 4H), 5.87 (s, 2H), 7.07-7.2 (m, 12H), 7.26-7.34 (m, 10H), 8.12 (s, 2 H), 8.19 (d, 2 H), 8.69 (d, 2 H)

<Production of Support>

In order to remove rolling oil on the surface of a 0.3 mm-thick aluminum plate (material JIS A 1050), a defatting process was carried out thereon using an aqueous solution of 10% by mass of sodium aluminate at 50°C for 30 seconds, and then, the surface of the aluminum plate was grained using three implanted nylon brushes having hair diameters of 0.3 mm and a suspension of pumice having a median diameter of 25 $\mu$m and water (specific gravity: 1.1 g/cm$^3$) and well washed with water. The aluminum plate was etched by being immersed in an aqueous solution of 25% by mass of sodium hydroxide at 45°C for nine seconds, was washed with water, then, was further immersed in an aqueous solution of 20% by mass of nitric acid at 60°C for 20 seconds, and was washed with water. The etched amount of the grained surface was approximately 3 g/m$^2$.

Next, an electrochemical roughening process was continuously carried out thereon using an alternating-current voltage of 60 Hz. An electrolytic solution was an aqueous solution of 1% by mass of nitric acid (including 0.5% by mass of aluminum ions), and the liquid temperature was 50°C. The electrochemical roughening process was carried out thereon using an alternating current source waveform in which the time TP taken for the current value to reach the peak from zero was 0.8 msec, a duty ratio of 1:1, a trapezoidal square-wave alternating current, and a carbon electrode as an opposite electrode. As an auxiliary anode, ferrite was used. The current density was 30 A/dm$^2$ in terms of the peak value of the current, and 5% of the current coming from the power supply was divided into the auxiliary positive electrode. Regarding the quantity of electricity during nitric acid electrolysis, the quantity of electricity was 175 C/dm$^2$ in a case in which the aluminum plate served as the positive electrode. After that, the plate was washed with water by means of spraying.

Subsequently, an electrochemical roughening process was carried out thereon using the same method as nitric acid electrolysis in an aqueous solution of 0.5% by mass of hydrochloric acid (including 0.5% by mass of aluminum ions) and an electrolytic solution having a liquid temperature of 50°C under a condition of the quantity of electricity of 50 C/dm$^2$ in a case in which the aluminum plate served as the positive electrode, and then, the plate was washed with water by means of spraying.

Next, 2.5 g/m$^2$ of a direct current anode oxide film was formed on the aluminum plate at a current density of 15 A/dm$^2$ using an aqueous solution of 15% by mass of sulfuric acid (including 0.5% by mass of aluminum ions) as an electrolytic solution, and then water washing and drying were carried out thereon, thereby producing a support A. The average pore diameter of the surface layer of the anode oxide film (surface average pore diameter) was 10 nm.

The pore diameter of the surface layer of the anode oxide film was measured using a method in which the surface was observed an ultrahigh resolution SEM (S-900 manufactured by Hitachi, Ltd.) at a relatively low acceleration voltage of 12 V at a magnification of 150,000 times without carrying out a deposition process or the like for imparting conductive properties, 50 pores were randomly extracted, and the average value was obtained. The standard deviation was $\pm$10% or less.

After that, in order to ensure the hydrophilicity of a non-image area, a silicate process was carried out on the support A using an aqueous solution of 2.5% by mass of No. 3 sodium silicate at 60°C for ten seconds, and then the support was washed with water, thereby producing a support B. The attached amount of Si was 10 mg/m$^2$. The center line average roughness (Ra) of the support B was measured using a needle having a diameter of 2 $\mu$m and was found to be 0.51 $\mu$m.

A support C was produced in the same manner as in the method for producing the support A except for the fact that, in the production of the support A, the electrolytic solution in the formation of the direct current anode oxide film was changed to an aqueous solution of 22% by mass of phosphoric acid. The average pore diameter of the surface layer of the anode oxide film (surface average pore diameter) was measured using the same method as described above and found out to be 25 nm.

After that, a silicate process was carried out on the support C using an aqueous solution of 2.5% by mass of No. 3 silicate soda at 60°C for 10 seconds in order to ensure the hydrophilicity of a non-image area and then washed with water, thereby producing a support D. The amount of Si attached was 10 mg/m$^2$. The center line average roughness (Ra) of the support D was measured using a needle having a diameter of 2 $\mu$m and found out to be 0.52 $\mu$m.

(Examples 1 to 9 and Comparative Examples 1 to 3)

<Production of Lithographic Printing Plate Precursor A>

[Formation of Undercoat Layer]

A coating fluid for an undercoat layer (1) having the following composition was applied onto the support so that the dried coating amount reached 20 mg/m$^2$, thereby forming an undercoat layer.

< Coating Fluid for Undercoat Layer (1)>

- Polymer (P-1) [the following structure]: 0.18 parts
- Hydroxyethyl iminodiacetic acid: 0.10 parts
- Water: 61.4 parts

(P-1)

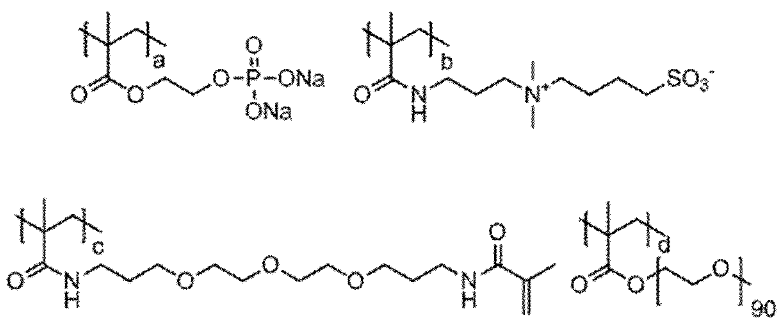

a / b / c / d = 14.2 / 71.8 / 9.0 / 5.0 (wt%)
a / b / c / d = 19.0 / 72.8 / 7.8 / 0.4 (mol%)
Weight-average molecular weight = 200,000

A method for synthesizing the polymer P-1 will be described below.

[Synthesis of Monomer M-1]

ANCAMINE 1922A (diethylene glycol di(aminopropyl) ether, manufactured by Air Products) (200 parts), distilled water (435 parts), and methanol (410 parts) were added to a 3 L three-neck flask and cooled to 5°C. Next, benzoic acid (222.5 parts) and 4-hydroxy-2,2,6,6-tetramethylpiperidine-1-oxyl (4-OH-TEMPO) (0.025 parts) were added thereto, and a methacrylic anhydride (280 parts) was added dropwise thereto so that the inner temperature of the reaction liquid reached 10°C or lower. The reaction liquid was stirred at 5°C for six hours and, subsequently, stirred at 25°C for 12 hours, and then phosphoric acid (70 parts) was added thereto so as to adjust the pH to 3.3. The reaction liquid was moved to a stainless steel beaker, ethyl acetate (3,320 parts), methyl-tert butyl ether (MTBE) (1,120 parts), and distilled water (650 parts) were added thereto, and the components were strongly stirred and then left to stand. The upper layer (organic layer) was disposed of, then, ethyl acetate (1,610 parts) was added thereto, the components were strongly stirred and then left to stand, and the upper layer was disposed of. Furthermore, ethyl acetate (1,350 parts) was added thereto, the components were strongly stirred and then left to stand, and the upper layer was disposed of. Next, MTBE (1,190 parts) was added thereto, the components were strongly stirred and then left to stand, and the upper layer was disposed of. 4-OH-TEMPO (0.063 parts) was added to the obtained aqueous solution, thereby obtaining an aqueous solution of a monomer M-1 (12,000 parts, 20.1% by mass in terms of the solid content).

[Purification of Monomer M-2]

LIGHT ESTER P-1M (2-methacryloyloxyethyl acid phosphate, manufactured by Kyoeisha Chemical Co., Ltd.) (420 parts), diethylene glycol dibutyl ether (1,050 parts), and distilled water (1,050 parts) were added to a separating funnel, strongly stirred, and then left to stand. The upper layer was disposed of, diethylene glycol dibutyl ether (1,050 parts) was added thereto, and the components were strongly stirred and then left to stand. The upper layer was disposed of, thereby obtaining an aqueous solution of a monomer M-2 (13,000 parts, 10.5% by mass in terms of the solid content).

(Synthesis of Polymer P-1)

Distilled water (600.6 parts), the aqueous solution of the monomer M-1 (33.1 parts), and a monomer M-3 described below (46.1 parts) were added to a three-neck flask and heated to 55°C in a nitrogen atmosphere. Next, a dropwise addition liquid 1 described below was added dropwise thereto for two hours, the components were stirred for 30 minutes, then, VA-046B (manufactured by Wako Pure Chemical Corporation) (3.9 parts) was added thereto, and the components were heated to 80°C and stirred for 1.5 hours. The reaction liquid was returned to room temperature (25°C, which shall apply below), and then an aqueous solution of 30% by mass of sodium hydroxide (175 parts) was added thereto, thereby adjusting the pH to 8.3. Next, 4-OH-TEMPO (0.152 parts) was added thereto, and the components were heated to 53°C. A methacrylic anhydride (66.0 parts) was added thereto, and the components were stirred at 53°C for three hours. The components were returned to room temperature, then, the reaction liquid was moved to a stainless steel beaker, MTBE (1,800 parts) was added thereto, the components were strongly stirred and then left to stand, and the upper layer was disposed of. A washing operation using MTBE (1,800 parts) was further repeated twice in the same manner, and then distilled water (1,700 parts) and 4-OH-TEMPO (0.212 parts) were added to the obtained water layer, thereby obtaining a polymer P-1 (41,000 parts, 11.0% in terms of the solid content) as a homogeneous solution. The weight-average molecular weight (Mw) converted to a polyethylene glycol equivalent value by the gel permeation chromatography (GPC) method was 200,000.

Dropwise addition liquid 1

- The aqueous solution of the monomer M-1: 132.4 g
- The aqueous solution of the monomer M-2: 376.9 g
- Monomer M-3 [the following structure]: 184.3 g
- BREMMER PME 4000 (manufactured by NOF Corporation): 15.3 g
- VA-046B (manufactured by Wako Pure Chemical Corporation): 3.9 g
- Distilled water: 717.4 g

BREMMER PME 4000: Methoxy polyethylene glycol methacrylate (the number of the oxyethylene unit repeated: 90)
VA-046B: 2,2'-Azobis[2-(2-imidazolin-2-yl)propane] disulfate dihydrate

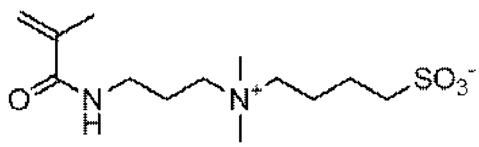

Monomer M-3

<Formation of Image-Recording Layer>

A coating fluid for an image-recording layer (1) having the following composition was applied onto the undercoat layer by means of bar coating and was dried in an oven at 100°C for 60 seconds, thereby forming an image-recording layer having a dried coating amount of 1.0 g/$m^2$.

The coating fluid for the image-recording layer (1) was prepared by mixing and stirring the following photosensitive liquid (1) and a micro gel liquid immediately before the coating.

<Photosensitive Liquid (1)>

- Binder polymer (1) [the following structure]: 0.240 parts
- Polymerization initiator (1) [the following structure]: 0.245 parts
- Specific infrared absorber or compound for comparison shown in Table 1: 0.046 parts
- Polymerizable compound: 0.192 parts, tris(acryloyloxyethyl)isocyanurate (NK ester A-9300, manufactured by Shin-Nakamura Chemical Co., Ltd.)
- Low-molecular-weight hydrophilic compound: 0.062 parts, tris(2-hydroxyethyl)isocyanurate
- Low-molecular-weight hydrophilic compound (1) [the following structure]: 0.050 parts
- Sensitization agent: 0.055 parts, phosphonium compound (1) [the following structure]
- Sensitization agent: 0.018 parts, benzyl-dimethyl-octylammonium·$PF_6$ salt
- Sensitization agent: 0.035 parts, ammonium group-containing polymer (1) [the following structure, reducing specific viscosity of 44 ml/g]
- Fluorine-based surfactant (1) [the following structure]: 0.008 parts
- 2-Butanone: 1.091 parts
- 1-Methoxy-2-propanol: 8.609 parts

<Micro Gel Liquid>

- Micro gel (1): 2.640 parts
- Distilled water: 2.425 parts

The structures of the binder polymer (1), the polymerization initiator (1), TPB, the low-molecular-weight hydrophilic compound (1), the phosphonium compound (1), the ammonium group-containing polymer (1), and the fluorine-based surfactant (1) which were used for the photosensitive liquid (1) will be illustrated below. Meanwhile, Me represents a methyl group, and numerical values on the lower right side of parentheses of individual constitutional units of the following polymer represent molar ratios.

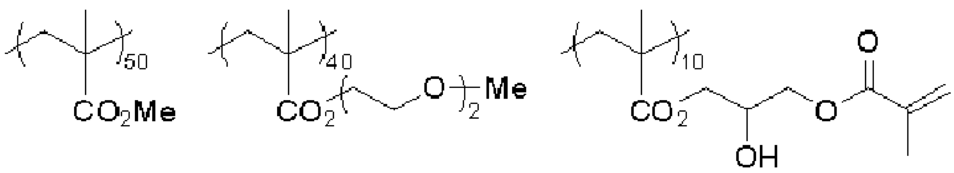

(Mw 70, 000)

Binder polymer (1)

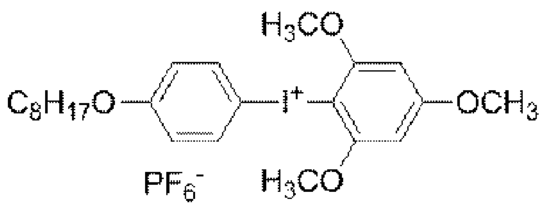

Polymerization initiator (1)

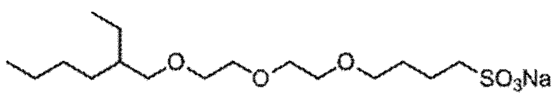

Low-molecular-weight hydrophilic comound (1)

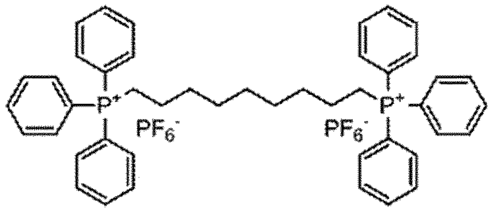

Phosphonium compound (1)

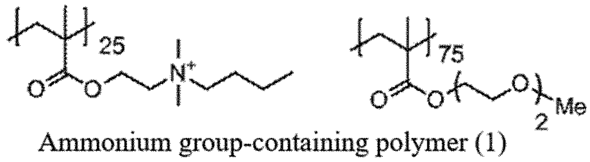

Ammonium group-containing polymer (1)

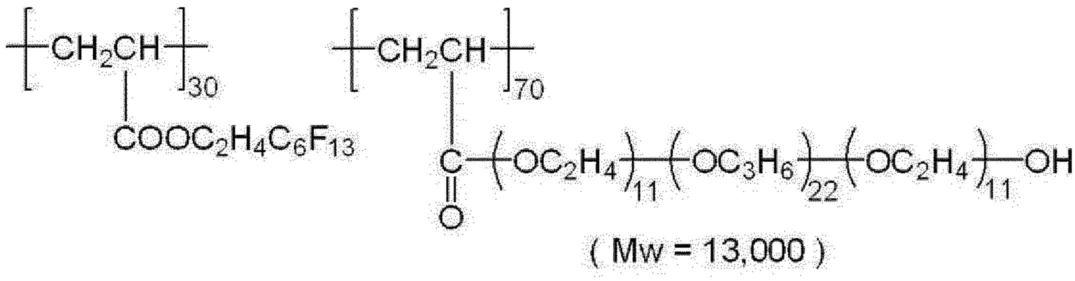

( Mw = 13,000 )

Fluorine-based surfactant (1)

A method for preparing a micro gel (1) used for the micro gel liquid will be described below.

<Preparation of Polyhydric Isocyanate Compound (1)>

Bismuth tris(2-ethylhexanoate) (NEOSTAN U-600, manufactured by Nitto Kasei Co., Ltd.) (43 mg) was added to an ethyl acetate (25.31 g) suspended solution of isophorone diisocyanate (17.78 g, 80 mmol) and the following polyhydric phenol compound (1) (7.35 g, 20 mmol), and the components were stirred. The reaction temperature was set to 50°C in a case in which the generation of heat settled, and the components were stirred for three hours, thereby obtaining an ethyl acetate solution of a polyhydric isocyanate compound (1) (50% by mass).

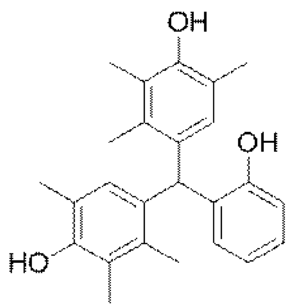

Polyhydric phenol compound (1)

<Preparation of Micro Gel (1)>

Oil-phase components described below and a water-phase component described below were mixed together and emulsified at 12,000 rpm for 10 minutes using a homogenizer. The obtained emulsion was stirred at 45°C for four hours, an aqueous solution of 10% by mass of 1,8-diazabicyclo[5.4.0]undec-7-ene-octanoic acid salt (U-CAT SA102, manufactured by San-Apro Ltd.) (5.20 g) was added thereto, and the components were stirred at room temperature for

30 minutes and left to stand at 45°C for 24 hours. Adjustment was made using distilled water so that the concentration of the solid content reached 20% by mass, thereby obtaining a water dispersion liquid of a micro gel (1). The volume average particle diameter was measured using the above-described method and a light scattering method and found out to be 0.28 μm.

(Oil-Phase Components)

(Component 1) Ethyl acetate: 12.0 g
(Component 2) An adduct obtained by adding trimethylolpropane (6 mol) and xylene diisocyanate (18 mol) and adding methyl single terminal polyoxy ethylene (1 mol, the number of the oxyethylene unit repeated: 90) thereto (a solution of 50% by mass of ethyl acetate, manufactured by Mitsui Chemicals Inc.): 3.76 g
(Component 3) Polyhydric isocyanate compound (1) (as a solution of 50% by mass of ethyl acetate): 15.0 g
(Component 4) An ethyl acetate solution of 65% by mass of dipentaerythritol pentaacrylate (SR-399, Sartomer Japan Inc.): 11.54 g
(Component 5) An ethyl acetate solution of 10% of a sulfonate-type surfactant (BIONINE A-41-C, manufactured by Takemoto Oil & Fat Co., Ltd.): 4.42 g

(Water-Phase Component)

Distilled water: 46.87 g

<Formation of Protective Layer>

A coating fluid for a protective layer having the following composition was applied onto the image-recording layer by means of bar coating and dried in an oven at 120°C for 60 seconds, thereby forming a protective layer having a dried coating amount of 0.15 $g/m^2$ and thus producing each of lithographic printing plate precursors A for Examples 1 to 9 and Comparative Examples 1 to 3. Specific infrared absorbers or compounds for comparison in the coating fluid for an image-recording layer (1) which were used to produce the respective lithographic printing plate precursors are summarized in Table 1.

<Coating Fluid for Protective Layer>

- Inorganic lamellar compound dispersion liquid (1) [described below]: 1.5 parts
- Aqueous solution of 6% by mass of polyvinyl alcohol (CKS50 manufactured by The Nippon Synthetic Chemical Industry Co., Ltd., sulfonic acid-modified, degree of saponification of 99% by mol or higher, degree of polymerization of 300): 0.55 parts
- Aqueous solution of 6% by mass of polyvinyl alcohol (PVA-405 manufactured by Kuraray Co., Ltd., degree of saponification of 81.5% by mol, degree of polymerization of 500): 0.03 parts
- Aqueous solution of 1% by mass of a surfactant (polyoxyethylene lauryl ether, EMALEX 710, manufactured by Nihon Emulsion Co., Ltd.): 0.86 parts
- Ion exchange water: 6.0 parts

A method for preparing the inorganic lamellar compound dispersion liquid (1) used for the coating fluid for a protective layer will be described below.

<Preparation of Inorganic Lamellar Compound Dispersion Liquid (1)>

Synthetic mica (SOMASIF ME-100 manufactured by Co-op Chemical Co., Ltd.) (6.4 g) was added to ion exchange water (193.6 g) and was dispersed using a homogenizer until the average particle diameter (the laser scattering method) reached 3 μm. The aspect ratio of the obtained dispersed particle was 100 or higher.

<Evaluation of Lithographic Printing Plate Precursors>

For the respective lithographic printing plate precursors described above, the color developability, the on-machine developability, the white light stability, the printing resistance, and the tone reproducibility were evaluated using the following evaluation methods. The evaluation results are shown in Table 1.

[Color Developability]

The obtained lithographic printing plate precursors were exposed using a TRENDSETTER 3244VX manufactured by Creo Co., Ltd. which was equipped with a water cooling-type 40 W infrared semiconductor laser under conditions of an output of 11.7 W, an external surface drum rotation speed of 250 rpm, and a resolution of 2,400 dpi (dot per inch, 1 inch=25.4 mm). The exposure was carried out in an environment of 25°C and 50%RH.

The color development of the lithographic printing plate precursor was measured immediately after exposure and after two hours of storage in a dark plate (25°C) after the exposure. The color development was measured using a spectrophotometer CM2600d and operation software CM-S100W manufactured by Konica Minolta, Inc. by means of a specular component excluded (SCE) method. The color developability were evaluated using the difference $\Delta L$ between the L* value of an exposed portion and the L* value of a non-exposed portion using L* values (brightness) in the L*a*b* color system. The numerical values of $\Delta L$ are shown in Table 1. A larger value of $\Delta L$ indicates superior color developability and also indicates a superior plate inspection property by the color developing of the lithographic printing plate. In addition, a larger value of $\Delta L$ after two hours from exposure (the numerical values shown in the column "color developability (after two hours)" in the table) indicates superior color developability after aging.

[On-Machine Developability]

The lithographic printing plate precursors were exposed using a LUXEL PLATESETTER T-6000III manufactured by Fujifilm Corporation which was equipped with an infrared semiconductor laser under conditions of an external surface drum rotation speed of 1,000 rpm, a laser output of 70%, and a resolution of 2,400 dpi. Exposed images were provided with solid images and 50% halftone dot charts of 20 μm dot FM screens.

Without carrying out a development process on the exposed plate precursors, the lithographic printing plate precursors were attached to the plate trunk of a printer LITHRONE 26 manufactured by Komori Corporation. Dampening water and ink were supplied using dampening water of ECOLITY-2 (manufactured by Fujifilm Corporation)/tap water=2/98 (capacity ratio) and Values-G(N) BLACK INK (manufactured by DIC Graphics Corporation) and using the standard automatic printing start method of LITHRONE 26, and then printing was carried out on 100 pieces of TOKUBISHI art paper (76.5 kg) (manufactured by Mitsubishi Paper Mills limited) at a printing rate of 10,000 pieces per hour.

The on-machine development of non-exposed portions in the image-recording layer was completed on the printer, and the number of pieces of printing paper required until ink was not transferred to the non-image areas was measured and evaluated as the on-machine developability. A smaller number of pieces of printing paper indicates superior on-machine developability.

[White Light Stability]

In an environment of room temperature (25°C) and a humidity of 50%, an OSRAM FLR40SW fluorescent light manufactured by Mitsubishi electric Corporation was used as a light source, and the lithographic printing plate precursor was set at a location of an illuminance of 1,000 lx in a pocket illuminance meter ANA-F9 manufactured by Tokyo Photoelectric Co., Ltd. and irradiated with white light for two hours. After that, image-wise exposure and on-machine development were carried out in the same manner as in the evaluation of the on-machine developability, the number of pieces of printing paper was measured and evaluated as the white light stability. A smaller number of pieces of printing paper indicates superior white light stability.

[Printing Resistance]

After the on-machine developability were evaluated, printing was further continued. As the number of printed pieces increased, the image-recording layer gradually wore, and thus the ink concentration on printed matters decreased. The number of pieces of printed paper until the value of the halftone dot area ratio of FM screen 50% halftone dots on printed matters measured using a gretag density meter decreased to be 5% lower than the measurement value obtained in a case in which printing was carried out on a $100^{th}$ piece of paper was measured. The printing resistance was evaluated using relative printing resistance for which the number of pieces of printed paper of 50,000 was considered as 100. A larger numerical value indicates superior printing resistance.

$$\text{Relative printing resistance} = (\text{the number of pieces of printed paper of the subject lithographic printing plate precursor})/50{,}000 \times 100$$

[Tone Reproducibility]

The halftone dot area ratio of 50% halftone dots was measured using a gretag density meter, the dot gain amount (%) of the 50% halftone dots was obtained from the difference between the actual measurement value of the halftone dot area ratio and the original image halftone % (=50%), and the tone reproducibility was evaluated using this numerical value. The numerical value closer to zero indicates superior tone reproducibility. The numerical value of 5% or less is a practically permissible level, and the numerical value of 6% or more lacks practicality.

[Table 1]

| | Lithographic printing plate precursor | Specific infrared-absorbing colorant or compound for comparison | Color develop ability (immediately after exposure) | Color developability (after two hours) | On-machine stability (number of sheets) | White light stability (number of sheets) | Printing resistance | Tone reproducibility (%) |
|---|---|---|---|---|---|---|---|---|
| Example 1 | A | D-1 | 5.1 | 4.6 | 20 | 23 | 78 | 4 |
| Example 2 | A | D-2 | 5.3 | 4.9 | 15 | 18 | 75 | 3 |
| Example 3 | A | D-3 | 5.5 | 5.0 | 27 | 20 | 80 | 3 |
| Example 4 | A | D-4 | 5.3 | 5.0 | 28 | 22 | 76 | 3 |
| Example 5 | A | D-5 | 5.1 | 4.7 | 26 | 25 | 72 | 4 |
| Example 6 | A | D-6 | 5.0 | 4.4 | 21 | 20 | 74 | 4 |
| Example 7 | A | D-7 | 4.5 | 4.0 | 25 | 25 | 68 | 4 |
| Example 8 | A | D-8 | 4.8 | 4.2 | 27 | 23 | 70 | 4 |
| Example 9 | A | D-9 | 4.9 | 4.6 | 26 | 24 | 71 | 4 |
| Comparative example 1 | A | H-1 | 4.0 | 3.0 | 35 | 30 | 65 | 5 |
| Comparative example 2 | A | H-2 | 3.5 | 3.0 | 30 | 35 | 60 | 5 |
| Comparative example 3 | A | H-3 | 3.0 | 2.5 | 36 | 32 | 58 | 6 |

Compounds H-1 to H-3 used in Comparative Examples 1 to 3 are compounds having structures represented by Formulae H-1 to H-3.

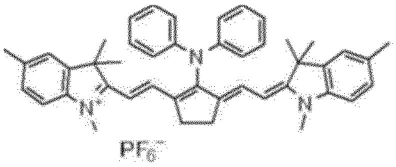

Formula H-1

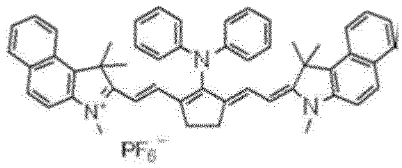

Formula H-2

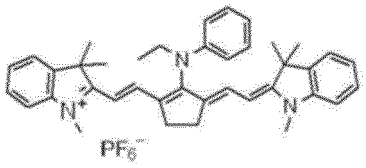

Formula H-3

The compound H-1 to H-3 were synthesized using a well-known method.

(Examples 10 to 27 and Comparative Examples 4 to 6)

<Production of Lithographic Printing Plate Precursor B>

Lithographic printing plate precursors B for Examples 10 to 27 and Comparative Examples 4 to 6 were respectively produced in the same manner as in the production of the lithographic printing plate precursor A except for the fact that, in the production of the lithographic printing plate precursor A, an image-recording layer coating fluid (2) described below was used instead of the image-recording layer coating fluid (1). The image-recording layer coating fluid (2) was prepared by mixing and stirring a photosensitive liquid (2) described below and a micro gel liquid immediately before being applied. Supports and specific infrared absorbers or compounds for comparison in the image-recording layer coating fluid (2) which were used to produce the respective lithographic printing plate precursors are summarized in Table 2.

<Photosensitive Liquid (2)>

- Binder polymer (1) [described above]: 0.240 parts
- Specific infrared absorber or compound for comparison shown in Table 2: 0.038 parts
- Borate compound: 0.010 parts
  TPB [described above]
- Polymerizable compound: 0.192 parts, tris(acryloyloxyethyl)isocyanurate, (NK ester A-9300, manufactured by Shin-Nakamura Chemical Co., Ltd.)
- Low-molecular-weight hydrophilic compound: 0.062 parts, tris(2-hydroxyethyl)isocyanurate
- Low-molecular-weight hydrophilic compound (1) [described above]: 0.050 parts
- Sensitization agent: 0.055 parts, phosphonium compound (1) [described above]
- Sensitization agent: 0.018 parts
  Benzyl-dimethyl-octylammonium·$PF_6$ salt
- Sensitization agent: 0.035 parts, ammonium group-containing polymer (1) [described above]
- Fluorine-based surfactant (1) [described above]: 0.008 parts
- 2-Butanone: 1.091 parts
- 1-Methoxy-2-propanol: 8.609 parts

<Micro Gel Liquid>

- Micro gel (1) [described above]: 2.640 parts
- Distilled water: 2.425 parts

<Evaluation of Lithographic Printing Plate Precursors>

For the respective lithographic printing plate precursors B, the color developability, the on-machine developability, the white light stability, the printing resistance, and the tone reproducibility were evaluated in the same manner as in the case of using the lithographic printing plate precursor A. The evaluation results are shown in Table 2.

[Table 2]

| | Lithographic printing plate precursor | Specific infrared-absorbing colorant or compound for comparison | Color developability (immediately after exposure) | Color developability (after two hours) | On-machine stability (number of sheets) | White light stability (number of sheets) | Printing resistance | Tone reproducibility (%) |
|---|---|---|---|---|---|---|---|---|
| Example 10 | B | D-12 | 6.2 | 4.6 | 20 | 23 | 78 | 4 |
| Example 11 | B | D-13 | 6.8 | 6.8 | 15 | 18 | 75 | 3 |
| Example 12 | B | D-14 | 6.5 | 6.2 | 18 | 15 | 75 | 4 |
| Example 13 | B | D-15 | 6.0 | 5.8 | 19 | 12 | 72 | 4 |
| Example 14 | B | D-16 | 5.8 | 5.9 | 14 | 17 | 74 | 4 |
| Example 15 | B | D-16 | 6.0 | 5.6 | 15 | 20 | 70 | 3 |
| Example 16 | B | D-18 | 5.6 | 5.5 | 20 | 22 | 71 | 3 |
| Example 17 | B | D-20 | 6.1 | 5.7 | 20 | 25 | 72 | 4 |
| Example 18 | B | D-22 | 6.0 | 5.2 | 22 | 22 | 78 | 4 |
| Example 19 | B | D-24 | 5.9 | 5.6 | 23 | 23 | 74 | 4 |
| Example 20 | B | D-28 | 5.7 | 5.6 | 24 | 26 | 73 | 5 |
| Example 21 | B | D-30 | 5.9 | 5.3 | 26 | 27 | 72 | 5 |
| Example 22 | B | D-31 | 5.6 | 5.4 | 23 | 25 | 70 | 4 |
| Example 23 | B | D-33 | 6.2 | 5.6 | 20 | 24 | 71 | 4 |
| Example 24 | B | D-35 | 5.3 | 5.3 | 17 | 24 | 75 | 4 |
| Example 25 | B | D-36 | 5.4 | 5.4 | 19 | 25 | 76 | 3 |
| Example 26 | B | D-40 | 5.5 | 5.4 | 21 | 21 | 74 | 4 |
| Example 27 | B | D-44 | 5.6 | 5.2 | 19 | 17 | 69 | 4 |
| Comparative example 4 | B | H-1 | 4.2 | 3.2 | 35 | 31 | 66 | 5 |
| Comparative example 5 | B | H-2 | 3.8 | 2.6 | 29 | 33 | 65 | 6 |
| Comparative example 6 | B | H-3 | 3.3 | 2.6 | 32 | 30 | 56 | 5 |

<Production of Lithographic Printing Plate Precursor C>

Lithographic printing plate precursors C for Examples 28 to 36 and Comparative Examples 7 to 9 were respectively produced by applying an image-recording layer coating fluid (3) having the following composition by means of bar coating instead of the image-recording layer coating fluid (1) and drying the coating fluid in an oven at 70°C for 60 seconds, thereby forming an image-recording layer having a dried coating amount of 0.6 g/$m^2$ in the production of the lithographic printing plate precursor A. The protective layer was not formed. That is, the lithographic printing plate precursor C was a lithographic printing plate precursor having no protective layer. Supports and specific infrared absorbers or compounds for comparison in the image-recording layer coating fluid (3) which were used to produce the respective lithographic printing plate precursors are summarized in Table 3.

<Image-Recording Layer Coating Fluid (3)>

- Specific infrared absorber or compound for comparison shown in Table 3: 0.046 parts
- Polymerization initiator (1) [described above]: 0.245 parts
- Borate compound: 0.010 parts
  TPB [described above]
- Polymer particle water dispersion liquid (1) (22% by mass) [described below]: 10.0 parts
- Polymerizable compound: 1.50 parts
  SR-399 (manufactured by Sartomer Japan Inc.)
- Mercapt-3-triazole: 0.2 parts
- Byk 336 (manufactured by BYK Additives & Instruments): 0.4 parts
- Klucel M (manufactured by Hercules Incorporated): 4.8 parts
- ELVACITE 4026 (manufactured by Ineos Acrylics): 2.5 parts
- n-Propanol: 55.0 parts
- 2-Butanone: 17.0 parts

The compounds which were used for the image-recording layer coating fluid (3) and are expressed using trade names are as described below.

- SR-399: Dipentaerythritol pentaacrylate
- Byk 336: Modified dimethyl polysiloxane copolymer (a solution of 25% by mass of xylene and methoxypropyl acetate)
- Klucel M: Hydroxypropyl cellulose (2% by mass aqueous solution)
- ELVACITE 4026: Highly branched polymethyl methacrylate (a solution of 10% by mass of 2-butanone)

A method for preparing the polymer particle water dispersion liquid (1) used for the image-recording layer coating fluid (3) will be described below.

<Preparation of Polymer Particle Water Dispersion Liquid (1)>

A stirrer, a thermometer, a dropping funnel, a nitrogen introduction pipe, and a reflux cooler were provided to a four-neck flask, nitrogen gas was introduced thereinto, polyethylene glycol methyl ether methacrylate (PEGMA, the average repeating unit number of ethylene glycol: 50) (10 g), distilled water (200 g), and n-propanol (200 g) were added thereto while carrying out deoxidation by introducing nitrogen gas, and the components were heated until the inner temperature reached 70°C. Next, a mixture obtained by mixing styrene (St) (10 g), acrylonitrile (AN) (80 g), and 2,2'-azobisisobutyronitrile (0.8 g) in advance was added dropwise thereto for one hour. A reaction continued for five hours after the end of the dropwise addition, then, 2,2'-azobisisobutyronitrile (0.4 g) was added thereto, and the inner temperature was increased up to 80°C. Subsequently, 2,2'-azobisisobutyronitrile (0.5 g) was added thereto for six hours. At a stage of continuing the reaction for a total of 20 hours, 98% or more of polymerization had progressed, and a polymer particle water dispersion liquid (1) including PEGMA/St/AN in a mass ratio of 10/10/80 was prepared. The particle size distribution of the polymer particles had the maximum value at a particle diameter of 150 nm.

The particle size distribution was obtained by capturing an electron micrograph of the polymer particles, measuring the particle diameters of a total of 5,000 particles on the photograph, dividing the range of the obtained particle diameter measurement values from zero to the maximum value into 50 sections using a logarithmic scale, and plotting the appearance frequency of the respective particle diameters. Meanwhile, for a non-spherical particle, the particle diameter value of a spherical particle having the same particle area as the particle area on the photograph was considered

as the particle diameter.

<Evaluation of Lithographic Printing Plate Precursors>

For the respective lithographic printing plate precursors C, the color developability, the on-machine developability, the white light stability, the printing resistance, and the tone reproducibility were evaluated in the same manner as in the case of using the lithographic printing plate precursor A. The evaluation results are shown in Table 3.

[Table 3]

| | Lithographic printing plate precursor | Specific infrared-absorbing colorant or compound for comparison | Color developability (immediately after exposure) | Color developability (after two hours) | On-machine stability (number of sheets) | White light stability (number of sheets) | Printing resistance | Tone reproducibility (%) |
|---|---|---|---|---|---|---|---|---|
| Example 28 | C | D-1 | 5.0 | 4.2 | 20 | 23 | 77 | 4 |
| Example 29 | C | D-2 | 5.1 | 4.2 | 21 | 20 | 77 | 4 |
| Example 30 | C | D-3 | 4.9 | 4.7 | 22 | 26 | 76 | 4 |
| Example 31 | C | D-4 | 4.8 | 4.6 | 26 | 22 | 72 | 3 |
| Example 32 | C | D-13 | 5.0 | 4.9 | 20 | 22 | 71 | 4 |
| Example 33 | C | D-24 | 5.2 | 5.0 | 19 | 24 | 70 | 4 |
| Example 34 | C | D-33 | 5.1 | 5.0 | 22 | 26 | 75 | 3 |
| Example 35 | C | D-34 | 5.0 | 4.6 | 12 | 20 | 70 | 4 |
| Example 36 | C | D-43 | 4.7 | 4.2 | 23 | 21 | 69 | 4 |
| Comparative example 7 | C | H-1 | 3.5 | 2.5 | 36 | 30 | 66 | 4 |
| Comparative example 8 | C | H-2 | 3.6 | 3.2 | 31 | 36 | 60 | 4 |
| Comparative example 9 | C | H-3 | 3.2 | 2.8 | 32 | 30 | 59 | 5 |

<Production of Lithographic Printing Plate Precursor D>

Lithographic printing plate precursors D for Examples 37 to 45 and Comparative Examples 10 to 12 were respectively produced by applying an image-recording layer coating fluid (4) having a composition that became as described below after coating by means of bar coating instead of the image-recording layer coating fluid (1) and drying the coating aqueous solution in an oven at 50°C for 60 seconds, thereby forming an image-recording layer having a dried coating amount of 0.93 g/m$^2$ in the production of the lithographic printing plate precursor A. The protective layer was not formed. That is, the lithographic printing plate precursor D was a lithographic printing plate precursor having no protective layer. Supports and specific infrared absorbers or compounds for comparison in the image-recording layer coating fluid (4) which were used to produce the respective lithographic printing plate precursors are summarized in Table 4.

<Image-Recording Layer Coating Fluid (4)>

- Specific infrared absorber or compound for comparison shown in Table 4: 0.038 g/m$^2$
- Borate compound: 0.01 g/m$^2$
  TPB [described above]
- Polymer particle water dispersion liquid (2): 0.693 g/m$^2$
- Glascol E15: 0.09 g/m$^2$
  (manufactured by Allied Colloids Manufacturing GMBH)
- ERKOL WX48/20 (manufactured by ERKOL): 0.09 g/m$^2$
- Zonyl FSO100 (manufactured by DuPont): 0.0075 g/m$^2$

The compounds which were used for the image-recording layer coating fluid (4) and are expressed using trade names and the polymer particle water dispersion liquid (2) are as described below.

- Glascol E15: Polyacrylic acid
- ERKOL WX48/20: Polyvinyl alcohol/polyvinyl acetate copolymer
- Zonyl FSO100: Surfactant
- Polymer particle water dispersion liquid (2): A styrene/acrylonitrile copolymer stabilized with an anionic wetting agent (the molar ratio: 50/50, the average particle diameter: 61 nm, and the solid content: approximately 20%)

<Evaluation of Lithographic Printing Plate Precursors>

For the respective lithographic printing plate precursors D, the color developability, the on-machine developability, the white light stability, the printing resistance, and the tone reproducibility were evaluated in the same manner as in the case of using the lithographic printing plate precursor A. The evaluation results are shown in Table 4.

[Table 4]

| | Lithographic printing plate precursor | Specific infrared-absorbing colorant or compound for comparison | Color developability (immediately after exposure) | Color developability (after two hours) | On-machine stability (number of sheets) | White light stability (number of sheets) | Printing resistance | Tone reproducibility (%) |
|---|---|---|---|---|---|---|---|---|
| Example 37 | D | D-1 | 5.2 | 5.0 | 19 | 22 | 78 | 4 |
| Example 38 | D | D-2 | 5.2 | 5.1 | 20 | 21 | 74 | 4 |
| Example 39 | D | D-3 | 5.3 | 5.0 | 20 | 23 | 75 | 4 |
| Example 40 | D | D-4 | 5.1 | 4.6 | 22 | 26 | 73 | 4 |
| Example 41 | D | D-13 | 5.0 | 4.7 | 26 | 26 | 71 | 4 |
| Example 42 | D | D-24 | 5.6 | 5.3 | 21 | 28 | 71 | 4 |
| Example 43 | D | D-38 | 6.2 | 5.8 | 12 | 26 | 80 | 3 |
| Example 44 | D | D-39 | 6.0 | 6.0 | 14 | 21 | 81 | 3 |
| Example 45 | D | D-43 | 5.6 | 5.0 | 24 | 22 | 78 | 4 |
| Comparative example 10 | D | H-1 | 4.0 | 3.0 | 35 | 30 | 65 | 5 |
| Comparative example 11 | D | H-2 | 3.5 | 3.0 | 30 | 35 | 60 | 5 |
| Comparative example 12 | D | H-3 | 3.0 | 2.5 | 36 | 32 | 58 | 6 |

From the results shown for the lithographic printing plate precursors A to C, it is clear that the lithographic printing plate precursor having an image-recording layer containing the infrared absorber according to the present disclosure has superior color developability and the maintenance of the color developability to the lithographic printing plate precursors of the comparative examples containing the compound for comparison. Furthermore, it is found that the lithographic printing plate precursor having an image-recording layer containing the specific infrared absorber according to the present disclosure has favorable printing resistance and is favorable in terms of the on-machine developability, the white light stability, and the tone reproducibility.

In addition, from the results of the lithographic printing plate precursors D, it is also clear that the lithographic printing plate precursor having the specific infrared absorber according to the embodiment of the present disclosure has superior color developability and printing resistance to the lithographic printing plate precursors of the comparative examples containing the compound for comparison. The reason for the performance of the specific infrared absorber according to the present disclosure being excellent in spite of the above-described thermal fusion system (a system in which the curable composition according to the second embodiment is used for the image-recording layer) is not clear, but is assumed that the specific infrared absorber has a superior photothermal conversion efficiency and exhibits a higher performance compared with a cyanine-based infrared absorber of the related art.

(Examples 2-1 to 2-7 and 2-10 to 2-18 and Comparative Examples 2-1 and 2-2)

<Formation of infrared-sensitive curable composition film>

Infrared-sensitive curable compositions having a composition A or a composition B described below were respectively prepared, applied onto the aluminum support B by means of bar coating so that the dried coating amount reached 1.0 g/m$^2$, and dried in an oven at 120°C for 40 seconds to form infrared-sensitive curable composition films, thereby respectively producing infrared-sensitive color developing materials for Examples 2-1 to 2-7 and 2-10 to 2-18 and Comparative Examples 2-1 and 2-2. The compositions of the infrared-sensitive curable compositions used to produce the respective infrared-sensitive color developing materials and the specific infrared absorbers or the compounds for comparison in the infrared-sensitive curable compositions are summarized in Table 5 and Table 6.

<Composition A of Infrared-sensitive Curable Composition>

- Polymethyl methacrylate (Mw: 12,000): 0.69 parts by mass
- Specific infrared absorber or compound for comparison shown in Table 5: 0.046 parts by mass
- Tetraphenyl borate·sodium salt: 0.010 parts by mass
- 2-Butanone: 11.3 parts by mass

<Composition B of Infrared-sensitive Curable Composition>

- Polymethyl methacrylate (Mw: 12,000): 0.53 parts by mass
- Polymerization initiator (1) [the following structure]: 0.16 parts by mass
- Specific infrared absorber or compound for comparison shown in Table 6: 0.046 parts by mass
- 2-Butanone: 11.3 parts by mass

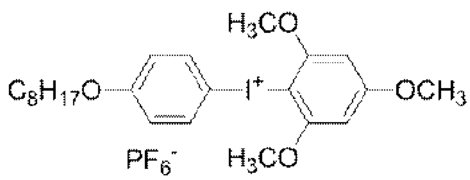

Polymerization initiator (1)

Evaluation of Color Developability of Infrared-sensitive Color Developing Materials

The infrared-sensitive color developing materials were exposed in a Trendsetter 3244VX equipped with a water

cooling-type 40 W infrared semiconductor laser manufactured by Creo Co., Ltd. under conditions of an output of 11.7 W, an external surface drum rotation speed of 250 rpm, a resolution of 2,400 dpi (dot per inch, 1 inch=25.4 mm). The materials were exposed in an environment of 25°C and 50%RH.

Color development of the infrared-sensitive color developing materials was measured immediately after the exposure and after two hours of storage in a dark place (25°C) after the exposure. The color development was measured using a spectrophotometer CM2600d and operation software CM-S100W manufactured by Konica Minolta, Inc. by means of a specular component excluded (SCE) method. The color developability was evaluated using the difference ΔL between the L* value of an exposed portion and the L* value of a non-exposed portion using L* values (brightness) in the L*a*b* color system. A larger value of ΔL indicates superior color developability.

The evaluation results are summarized in Tables 5 and 6.

[Table 5]

| | Infrared-sensitive curable composition | Specific infrared absorber or compound for comparison | Color developability (immediately after exposure) | Color developability (after two hours) |
|---|---|---|---|---|
| Example 2-1 | A | D-12 | 11.4 | 11.0 |
| Example 2-2 | A | D-16 | 10.9 | 10.1 |
| Example 2-3 | A | D-17 | 10.5 | 10.1 |
| Example 2-4 | A | D-20 | 10.4 | 10.1 |
| Example 2-5 | A | D-23 | 11.0 | 11.0 |
| Example 2-6 | A | D-30 | 10.1 | 9.9 |
| Example 2-7 | A | D-45 | 9.8 | 9.6 |
| Comparative example 2-1 | A | H-1 | 5.5 | 3.9 |

[Table 6]

| | Infrared-sensitive curable composition | Specific infrared absorber or compound for comparison | Color developability (immediately after exposure) | Color developability (after two hours) |
|---|---|---|---|---|
| Example 2-10 | B | D-1 | 7.9 | 7.1 |
| Example 2-11 | B | D-3 | 7.5 | 7.0 |
| Example 2-12 | B | D-6 | 8.0 | 7.2 |
| Example 2-13 | B | D-10 | 7.9 | 7.6 |
| Example 2-14 | B | D-11 | 8.1 | 7.9 |
| Example 2-15 | B | D-24 | 7.1 | 6.9 |
| Example 2-16 | B | D-28 | 6.8 | 6.2 |
| Example 2-17 | B | D-35 | 7.3 | 7.3 |

(continued)

| | Infrared-sensitive curable composition | Specific infrared absorber or compound for comparison | Color developability (immediately after exposure) | Color developability (after two hours) |
|---|---|---|---|---|
| Example 2-18 | B | D-46 | 7.6 | 7.8 |
| Comparative example 2-2 | B | H-2 | 5.2 | 3.5 |

From the results shown in Tables 5 and 6, it is found that the infrared-sensitive color developing materials having the infrared-sensitive curable composition film containing the compound according to the present invention are infrared-sensitive color developing materials which have a favorable color developability after exposure to an infrared ray and are also excellent in terms of the maintenance of the color developability even after two hours.

## Claims

1. A curable composition comprising:
an infrared absorber comprising at least one element in Group XIII of the periodic table on a mother nucleus structure and comprising a chain-like polymethine structure.

2. The curable composition according to claim 1, wherein, in the infrared absorber, an anion charge is present on the element in Group XIII in a resonant structure formula.

3. The curable composition according to claim 1 or 2, wherein the element in Group XIII of the periodic table comprises boron or aluminum.

4. The curable composition according to any one of claims 1 to 3, wherein the chain-like polymethine structure comprises a chain-like polymethine structure in which two or more hetero atoms are bonded to carbon atoms at non-meso positions.

5. The curable composition according to claim 4, wherein the infrared absorber comprises two or more boron atoms, and the two or more hetero atoms comprise two or more oxygen atoms or two or more nitrogen atoms.

6. The curable composition according to claim 4, wherein the infrared absorber comprises two or more boron atoms, and the two or more hetero atoms comprises four or more oxygen atoms.

7. The curable composition according to any one of claims 1 to 6, wherein the infrared absorber comprises a group represented by the following Formula I:

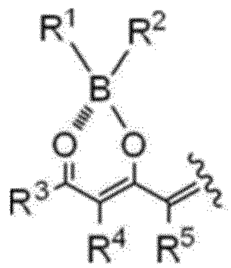

Formula I

wherein, in Formula I, $R^1$ and $R^2$ each independently represent a halogen atom or a monovalent atomic group comprising at least one atom selected from the group consisting of an oxygen atom, a nitrogen atom, and a carbon atom; $R^1$ and $R^2$ may be bonded to each other to form a ring structure; $R^3$, $R^4$, and $R^5$ each independently represent a monovalent atomic group comprising at least one atom selected from the group consisting of a hydrogen atom,

an oxygen atom, a nitrogen atom, and a carbon atom; at least two groups selected from the group consisting of $R^3$, $R^4$, and $R^5$ may be bonded to each other to form a ring structure; and a wavy line moiety represents a bonding site with a different structure.

**8.** The curable composition according to any one of claims 1 to 7, wherein the infrared absorber comprises a compound represented by the following Formula II:

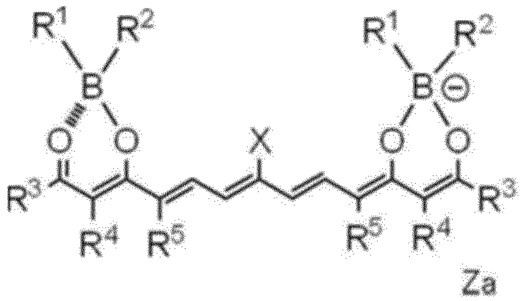

Formula II

wherein, in Formula II, $R^1$ and $R^2$ each independently represent a halogen atom or a monovalent atomic group comprising at least one atom selected from the group consisting of an oxygen atom, a nitrogen atom, and a carbon atom; $R^1$ and $R^2$ may be bonded to each other to form a ring structure; $R^3$, $R^4$, and $R^5$ each independently represent a monovalent atomic group comprising at least one atom selected from the group consisting of a hydrogen atom, an oxygen atom, a nitrogen atom, and a carbon atom; at least two groups selected from the group consisting of $R^3$, $R^4$, and $R^5$ may be bonded to each other to form a ring structure; a linear polymethine chain may have a ring structure therein; X represents a halogen atom or a monovalent atomic group comprising at least one atom selected from the group consisting of an oxygen atom, a sulfur atom, a nitrogen atom, and a carbon atom; and Za represents a counter ion for neutralizing a charge.

**9.** The curable composition according to any one of claims 1 to 8, wherein the infrared absorber comprises a compound represented by the following Formula III:

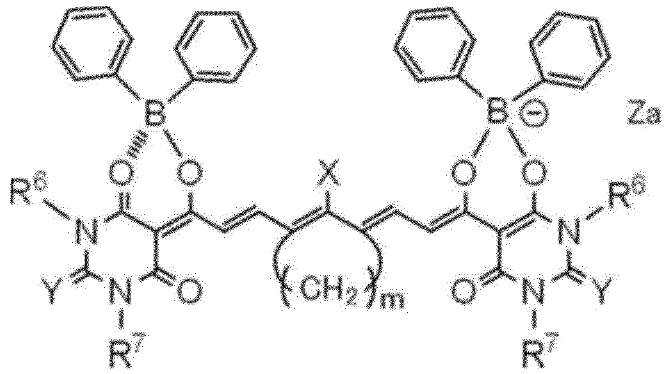

Formula III

wherein, in Formula III, $R^6$ and $R^7$ each independently represent a hydrogen atom, an alkyl group, or an aryl group; X represents a halogen atom or a monovalent atomic group comprising at least one atom selected from the group consisting of an oxygen atom, a sulfur atom, a nitrogen atom, and a carbon atom; each Y independently represents an oxygen atom, a sulfur atom, or a divalent atomic group comprising at least one atom selected from the group consisting of a nitrogen atom and a carbon atom, wherein in a case in which Y represents a divalent atomic group comprising at least one atom selected from the group consisting of a nitrogen atom and a carbon atom, the atomic group may be bonded to at least one group selected from the group consisting of $R^6$ and $R^7$ to form a ring structure; m represents an integer of 2 to 10; and Za represents a counter ion for neutralizing a charge.

**10.** The curable composition according to any one of claims 1 to 9, further comprising:

a polymerizable compound; and
a polymerization initiator.

**11.** The curable composition according to claim 10, wherein the polymerization initiator comprises an onium salt compound.

**12.** The curable composition according to any one of claims 1 to 11, further comprising:
a thermally adhesive particle.

**13.** The curable composition according to any one of claims 1 to 12, further comprising:
a binder polymer.

**14.** A lithographic printing plate precursor comprising:

a support; and
an image-recording layer comprising the curable composition according to any one of claims 1 to 13 on the support.

**15.** The lithographic printing plate precursor according to claim 14, further comprising:
a protective layer on the image-recording layer.

**16.** A method for producing a lithographic printing plate, the method comprising:

a step of subjecting the lithographic printing plate precursor according to claim 14 or 15 to image-wise exposure; and
a step of removing a non-exposed portion of the image-recording layer on a printer using at least one selected from the group consisting of printing ink and dampening water.

## INTERNATIONAL SEARCH REPORT

International application No.
PCT/JP2017/030201

A. CLASSIFICATION OF SUBJECT MATTER
*B41N1/00*(2006.01)i, *C08F2/44*(2006.01)i, *C08F4/00*(2006.01)i, *C08K5/00*(2006.01)i

According to International Patent Classification (IPC) or to both national classification and IPC

B. FIELDS SEARCHED

Minimum documentation searched (classification system followed by classification symbols)
B41N1/00, C08F2/44, C08F4/00, C08K5/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | JP 2013-199089 A (Fujifilm Corp.), 03 October 2013 (03.10.2013), entire text (Family: none) | 1-16 |
| A | JP 2008-277268 A (TDK Corp.), 13 November 2008 (13.11.2008), entire text & US 2008/0236663 A1 entire text & EP 1981047 A2 & CN 101276849 A | 1-16 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 September 2017 (25.09.17) | 10 October 2017 (10.10.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No. PCT/JP2017/030201

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-517009 A (Dow Global Technologies Inc.), 20 May 2003 (20.05.2003), entire text & US 2002/0025381 A1 entire text & WO 2001/044311 A1 | 1-16 |
| A | JP 2012-503687 A (Basell Polyolefine GmbH), 09 February 2012 (09.02.2012), entire text & US 2011/0212283 A1 entire text & WO 2010/034463 A1 & KR 10-2011-0061584 A & CN 102165005 A | 1-16 |
| A | Masahiko YAMAGUCHI et al., Linear Trimerization Reaction of Silylacetylene Promoted by GaCl3, J. Org. Chem., 1998.10.27, 63, p. 8086-8087 | 1-16 |
| P,A | Yuping DONG et al., Reversible multicolor switching via simple reactions of the AIE-characteristic molecules, Dyes and Pigments, 2016.12.28, 139, p. 714-719 | 1-16 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2008544053 A
- JP 2008544322 A
- JP 2013199089 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S48041708 B
- JP 51037193 A
- JP S51037193 A
- JP 2032293 B
- JP H02032293 B
- JP 2016765 B
- JP H02016765 B
- JP 2003344997 A
- JP 2006065210 A
- JP 58049860 B
- JP S58049860 B
- JP 56017654 B
- JP S56017654 B
- JP 62039417 B
- JP S62039417 B
- JP 62039418 B
- JP S62039418 B
- JP 2000250211 A
- JP 2007094138 A
- US 7153632 B
- JP 8505958 A
- JP H08505958 A
- JP 2007293221 A
- JP 2007293223 A
- JP 2008195018 A
- JP 8108621 A
- JP H08108621 A
- JP 61166544 A
- JP S61166544 A
- JP 2002328465 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2001133969 A
- JP 2002023360 A
- JP 2002040638 A
- JP 2002278057 A
- JP 2007090850 A
- JP 5005005 A
- JP H05005005 A
- JP 2001222101 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A
- JP 55049729 B
- JP S55049729 B
- JP 2005250216 A
- JP 2006259137 A
- JP 2001253181 A
- JP 2001322365 A
- US 2714066 A
- US 3181461 A
- US 3280734 A

- US 3902734 A
- US 3276868 A
- US 4153461 A
- US 4689272 A
- JP 5045885 A
- JP H05045885 A
- JP 6035174 A
- JP H06035174 A

**Non-patent literature cited in the description**

- **HANSCH, C. ; LEO, A. ; TAFT, R. W.** *Chem. Rev.,* 1991, vol. 91, 165-195
- *Research Disclosure No. 33303,* January 1992
- Dye Handbooks. 1970
- *Journal of the American Chemical Society,* 2006, vol. 128 (35), 11362-11363